# EUROPEAN PATENT APPLICATION

(11) **EP 4 456 703 A1**
(43) Date of publication of application: **30.10.2024**
(21) Application number: 22911715.5
(22) Date of filing: 09.12.2022
(51) Int. Cl.: H10K 99/00, H10K 50/00

(54) **NOVEL ORGANIC LIGHT EMITTING DEVICE COMPRISING TWO LIGHT EMITTING LAYERS**

(30) Priority: 20.12.2021 KR 20210182670
(71) Applicant: SFC Co., Ltd., Cheongju-si, Chungcheongbuk-do 28122 (KR)
(72) Inventor: CHO, Jin-Hwi, Cheongju-si Chungcheongbuk-do 28122 (KR); YU, Se-Jin, Cheongju-si Chungcheongbuk-do 28122 (KR); SHIM, So-Young, Cheongju-si Chungcheongbuk-do 28122 (KR); YANG, Yong-Woon, Cheongju-si Chungcheongbuk-do 28122 (KR)
(74) Representative: Epping - Hermann - Fischer
(86) International application number: PCT/KR2022/020033
(87) International publication number: WO 2023/121082

(57) **Abstract**

The present invention relates to a novel organic light emitting device comprising two light emitting layers, and more specifically, to a novel organic 7light emitting device in which at least two light emitting layers are included, wherein by using a compound having a specific structure as a host material in at least one light emitting layer, the organic light emitting device is capable of realizing device characteristics such as high luminous efficiency, long lifespan, and low voltage driving.

## Description

### Technical Field

The present invention relates to a novel organic light emitting device including two light-emitting layers, and more specifically, to a novel organic light emitting device including least two light-emitting layers, wherein a compound having a specific structure is used as a host material in at least one light-emitting layer, whereby the organic light emitting diode is capable of realizing device characteristics such as high luminous efficiency, long lifespan, and low voltage driving.

### Background Art

Organic light-emitting diodes (OLEDs), which are self-emitting devices, enjoy advantages including a wide viewing angle, high contrast, fast response time, high luminance, a low driving voltage, a high response speed, and polychromatic properties.

A typical organic light emitting diode includes a positive electrode (anode) and a negative electrode (cathode), which face each other, with an organic emission layer for light emission disposed therebetween.

In detail, the organic light-emitting diode may have a structure in which a hole transport layer, a light-emitting layer, an electron transport layer, and a cathode are sequentially formed on an anode. Here, the hole transport layer, the light-emitting layer, and the electron transport layer are each an organic thin film composed of an organic compound.

Having such a structure, the organic light-emitting diode operates according to the following principle. When a voltage is applied between the anode and the cathode, a hole injected from the anode moves toward the light-emitting layer through the hole transport layer while an electron injected from the cathode moves toward the light-emitting layer through the electron transport layer. In the light-emitting layer zone, the carriers such as a hole and an electron recombine to produce an exciton. The exciton returns to the ground state from the excited state, emitting light.

Materials used as organic layers in organic light-emitting diodes may be divided according to functions into luminescent materials and charge transport materials, for example, a hole injection material, a hole transport material, an electron transport material, and an electron injection material. An electron blocking layer or a hole blocking layer may be added as necessary.

As for the luminescent materials, there are two main families of OLED: those based on small molecules and those employing polymers. The light-emitting mechanism forms the basis of classification of luminescent materials as fluorescent and phosphorescent materials, which use excitons in singlet and triplet states, respectively.

When a single material is employed as the luminescent material, intermolecular actions cause the maximum luminescence wavelength to shift toward a longer wavelength, resulting in a reduction in color purity and luminous efficiency due to light attenuation. In this regard, a host-dopant system may be used as a luminescent material so as to increase the color purity and the luminous efficiency through energy transfer.

This is based on the principle whereby, when a dopant which is smaller in energy band gap than a host forming a light-emitting layer is added in a small amount to the light-emitting layer, excitons are generated from the light-emitting layer and transported to the dopant, emitting light at high efficiency. Here, light with desired wavelengths can be obtained depending on the kind of the dopant because the wavelength of the host moves to the wavelength range of the dopant.

With respect to related arts for materials for light-emitting layers, reference may be made to Japanese Patent No. 1996-012600 A (January 16, 1996), which discloses the use of a phenyl anthracene derivative as a light-emitting material in OLEDs, and Japanese Patent No. 5608978 (OctobeR₂₂, 2014), which discloses an OLED that contains an anthracene derivative having a dibenzofuran-structured substituent bonded to the end of an anthracene structure in a light-emitting layer.

In spite of the manufacture of various types of compounds for use in light-emitting layers, including the techniques of the cited documents, there is a still continuing need for development of an organic light-emitting diode that has improved efficiency and long lifespan characteristics at low driving voltages.

### Disclosure

### Technical Problem

Therefore, the present disclosure aims primarily to provide a novel organic light-emitting diode (OLED) that contains two light-emitting layers with specific structures of compounds used as host materials within at least one light-emitting layer, whereby the OLED can exhibit excellent diode properties including high emission yield, long lifespan, and low driving voltage.

### Technical Solution

To achieve the technical challenges, the present disclosure provides an organic light-emitting diode sequentially including: a first electrode; and a second electrode facing the first electrode; a first light-emitting layer containing a first host and a first dopant; and a second light-emitting layer containing a second host and a second dopant, both the light-emitting layers interposed between the first electrode and the second electrode,
wherein at least one of the first host and the second host includes at least one of the compounds represented by the following Chemical Formula A: 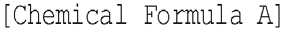 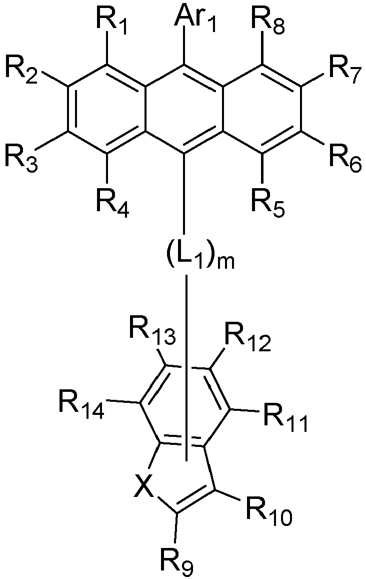
wherein,
   Ar₁ is any one substituent selected from a substituted or unsubstituted aryl of 6 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, and a substituted or unsubstituted aliphatic hydrocarbon ring-fused heteroaryl of 5 to 30 carbon atoms,
   R₁ to R₁₄, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted amine of 0 to 30 carbon atoms, a substituted or unsubstituted silyl of 0 to 30 carbon atoms, a germanium of 0 to 30 carbon atoms, a cyano, a nitro, and a halogen, with one of R₉ to R₁₄ being a single bond to L₁,
   X is an oxygen atom (O) or a sulfur atom (S),
   L₁, which functions as a linker, is a single bond or any one selected from a substituted or unsubstituted arylene of 6 to 20 carbon atoms and a substituted or unsubstituted heteroarylene of 2 to 20 carbon atoms,
   m is an integer of 1 to 3, wherein when m is 2 or higher, the corresponding L₁'s are same or different,
   wherein the term "substituted" in the expression "substituted or unsubstituted" used for compounds of Chemical Formula A means having at least one substituent selected from the group consisting of a deuterium atom, a cyano, a halogen, a hydroxy, a nitro, an alkyl of 1 to 24 carbon atoms, a halogenated alkyl of 1 to 24 carbon atoms, a cycloalkyl of 3 to 30 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, an alkoxy of 1 to 24 carbon atoms, an amine of 1 to 24 carbon atoms, a silyl of 1 to 24 carbon atoms, a germanium of 1 to 24 carbon atoms, an aryloxy of 6 to 24 carbon atoms, and an arylthionyl of 6 to 24 carbon atoms.

### Advantageous Effects

The novel organic light-emitting diode according to the present disclosure can be driven at lower voltages with improved emission yield and longevity, compared to conventional organic light-emitting diodes.

### Description of Drawings

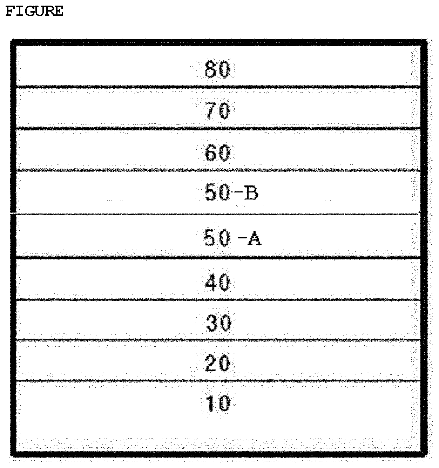

The Figure is a schematic diagram depicting the structure of an organic light-emitting diode according to some embodiments of the present disclosure.

### Mode for Invention

Below, a detailed description will be given of the present disclosure. In each drawing of the present disclosure, sizes or scales of components may be enlarged or reduced from their actual sizes or scales for better illustration, and known components may not be depicted therein to clearly show features of the present disclosure. Therefore, the present disclosure is not limited to the drawings. When describing the principle of the embodiments of the present disclosure in detail, details of well-known functions and features may be omitted to avoid unnecessarily obscuring the presented embodiments.

In the drawing, for convenience of description, sizes of components may be exaggerated for clarity. For example, since sizes and thicknesses of components in drawings are arbitrarily shown for convenience of description, the sizes and thicknesses are not limited thereto. Furthermore, throughout the description, the terms "on" and "over" are used to refer to the relative positioning, and mean not only that one component or layer is directly disposed on another component or layer but also that one component or layer is indirectly disposed on another component or layer with a further component or layer being interposed therebetween. Also, spatially relative terms, such as "below", "beneath", "lower", and "between" may be used herein for ease of description to refer to the relative positioning.

Throughout the specification, when a portion may "include" a certain constituent element, unless explicitly described to the contrary, it may not be construed to exclude another constituent element but may be construed to further include other constituent elements. Further, throughout the specification, the word "on" means positioning on or below the object portion, but does not essentially mean positioning on the lower side of the object portion based on a gravity direction.

An organic light-emitting diode according to the present disclosure sequentially include: a first electrode; and a second electrode facing the first electrode; a first light-emitting layer containing a first host and a first dopant; and a second light-emitting layer containing a second host and a second dopant, both the light-emitting layers interposed between the first electrode and the second electrode, wherein at least one of the first host and the second host includes at least one of the compounds represented by the following Chemical Formula A: 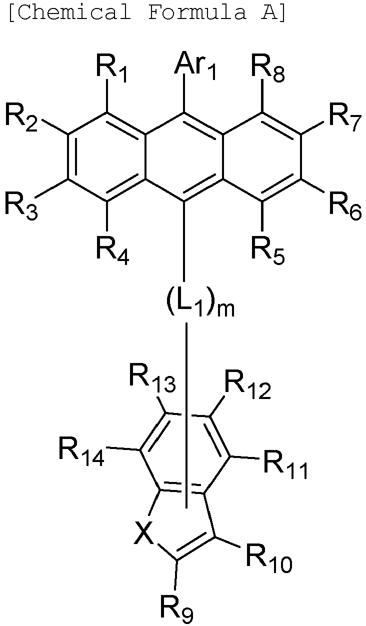 wherein,
Ar₁ is any one substituent selected from a substituted or unsubstituted aryl of 6 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, and a substituted or unsubstituted aliphatic hydrocarbon ring-fused heteroaryl of 5 to 30 carbon atoms,
R₁ to R₁₄, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted amine of 0 to 30 carbon atoms, a substituted or unsubstituted silyl of 0 to 30 carbon atoms, a germanium of 0 to 30 carbon atoms, a cyano, a nitro, and a halogen, with one of R₉ to R₁₄ being a single bond to L₁,
X is an oxygen atom (O) or a sulfur atom (S),
L₁, which functions as a linker, is a single bond or any one selected from a substituted or unsubstituted arylene of 6 to 20 carbon atoms and a substituted or unsubstituted heteroarylene of 2 to 20 carbon atoms,
m is an integer of 1 to 3, wherein when m is 2 or higher, the corresponding L₁'s are same or different,
wherein the term "substituted" in the expression "substituted or unsubstituted" used for compounds of Chemical Formula A means having at least one substituent selected from the group consisting of a deuterium atom, a cyano, a halogen, a hydroxy, a nitro, an alkyl of 1 to 24 carbon atoms, a halogenated alkyl of 1 to 24 carbon atoms, a cycloalkyl of 3 to 30 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, an alkoxy of 1 to 24 carbon atoms, an amine of 1 to 24 carbon atoms, a silyl of 1 to 24 carbon atoms, a germanium of 1 to 24 carbon atoms, an aryloxy of 6 to 24 carbon atoms, and an arylthionyl of 6 to 24 carbon atoms.

The expression indicating the number of carbon atoms, such as "a substituted or unsubstituted alkyl of 1 to 30 carbon atoms", "a substituted or unsubstituted aryl of 5 to 50 carbon atoms", etc. means the total number of carbon atoms of, for example, the alkyl or aryl radical or moiety alone, exclusive of the number of carbon atoms of substituents attached thereto. For instance, a phenyl group with a butyl at the para position falls within the scope of an aryl of 6 carbon atoms, even though it is substituted with a butyl radical of 4 carbon atoms.

As used herein, the term "aryl" means an organic radical, derived from an aromatic hydrocarbon by removing one hydrogen atom. Further, the aromatic system may include a fused ring that is formed by adjacent substituents on the aryl radical.

Concrete examples of the aryl include phenyl, o-biphenyl, m-biphenyl, p-biphenyl, o-terphenyl, m-terphenyl, p-terphenyl, naphthyl, anthryl, phenanthryl, pyrenyl, indenyl, fluorenyl, tetrahydronaphthyl, perylenyl, chrysenyl, naphthacenyl, and fluoranthenyl at least one hydrogen atom of which may be substituted by a deuterium atom, a halogen atom, a hydroxy, a nitro, a cyano, a silyl, an amino (-NH₂, -NH (R), -N(R') (R") wherein R' and R" are each independently an alkyl of 1 to 10 carbon atoms, in this case, called "alkylamino"), an amidino, a hydrazine, a hydrazone, a carboxyl, a sulfonic acid, a phosphoric acid, an alkyl of 1 to 24 carbon atoms, a halogenated alkyl of 1 to 24 carbon atoms, an alkenyl of 1 to 24 carbon atoms, an alkynyl of 1 to 24 carbon atoms, a heteroalkyl of 1 to 24 carbon atoms, an aryl of 6 to 24 carbon atoms, an arylalkyl of 6 to 24 carbon atoms, a heteroaryl of 2 to 24 carbon atoms, or a heteroarylalkyl of 2 to 24 carbon atoms.

The substituent heteroaryl used in the compound of the present disclosure refers to a heteroaromatic radical of 2 to 24 carbon atoms bearing one to three heteroatoms selected from among N, O, P, Si, S, Ge, Se, and Te in each ring of the aryl, wherein the rings may be fused. One or more hydrogen atoms on the heteroaryl may be substituted by the same substituents as on the aryl.

In addition, the term "heteroaromatic ring", as used herein, refers to an aromatic hydrocarbon ring bearing at least one heteroatom as an aromatic ring member. In the heteroaromatic ring, one to three carbon atoms of the aromatic hydrocarbon may be substituted by at least one selected particularly from N, O, P, Si, S, Ge, Se, and Te.

As used herein, the term "alkyl" refers to an alkane missing one hydrogen atom and includes linear or branched structures. Examples of the alkyl substituent useful in the present disclosure include methyl, ethyl, propyl, isopropyl, isobutyl, sec-butyl, tert-butyl, pentyl, isoamyl, and hexyl. At least one hydrogen atom of the alkyl may be substituted by the same substituent as in the aryl.

The term "cyclo" as used in substituents of the present disclosure, such as cycloalkyl, cycloalkoxy, etc., refers to a structure responsible for a mono- or polycyclic ring of saturated hydrocarbons. Concrete examples of cycloalkyl radicals include cyclopropyl, cyclobutyl, cyclopentyl, cyclohexyl, methylcyclopentyl, methylcyclohexyl, ethylcyclopentyl, ethylcyclohexyl, adamantyl, dicyclopentadienyl, decahydronaphthyl, norbornyl, bornyl, and isobornyl. One or more hydrogen atoms on the cycloalkyl may be substituted by the same substituent as in the aryl.

The term "alkoxy" as used in the compounds of the present disclosure refers to an alkyl or cycloalkyl singularly bonded to oxygen. Concrete examples of the alkoxy include methoxy, ethoxy, propoxy, isobutoxy, sec-butoxy, pentoxy, iso-amyloxy, hexyloxy, cyclobutyloxy, cyclopentyloxy, adamantyloxy, dicyclopentyloxy, bornyloxy, and isobornyloxy. One or more hydrogen atoms on the alkoxy may be substituted by the same substituents as on the aryl.

Concrete examples of the arylalkyl used in the compounds of the present disclosure include phenylmethyl (benzyl), phenylethyl, phenylpropyl, naphthylmethyl, and naphthylethyl. One or more hydrogen atoms on the arylalkyl may be substituted by the same substituents as on the aryl.

As used herein, the term "alkenyl" refers to an unsaturated hydrocarbon group that contains a carbon-carbon double bond between two carbon atoms and the term "alkynyl" refers to an unsaturated hydrocarbon group that contains a carbon-carbon triple bond between two carbon atoms.

As used herein, the term "alkylene" refers to an organic aliphatic radical regarded as derived from a linear or branched saturated hydrocarbon alkane by removal of two hydrogen atoms from different carbon atoms. Concrete examples of the alkylene include methylene, ethylene, propylene, isopropylene, isobutylene, sec-butylene, tert-butylene, pentylene, isoamylene, hexylene, and so on. One or more hydrogen atoms on the alkylene may be substituted by the same substituents as on the aryl.

Furthermore, the term "amine", as used herein, is indented to encompass -NH₂, alkylamine, arylamine, alkylarylamine, arylheteroarylamine, heteroarylamine, etc. Here, arylamine refers to an amine resulting from substitution of aryl for one or two hydrogen atoms of -NH₂; alkylamine refers to an amine resulting from substitution of alkyl for one or two hydrogen atoms of -NH₂; alkylarylamine refers to an amine resulting from substitution of alkyl and aryl for the two hydrogen atoms of - NH₂, respectively; arylheteroarylamine refers to an amine resulting from substitution of aryl and heteroaryl for the two hydrogen atoms of -NH₂; and heteroarylamine refers to an amine resulting from substitution of heteroaryl for one or two hydrogen atoms of -NH₂. Examples of the arylamine include a substituted or unsubstituted monoarylamine and a substituted or unsubstituted diarylamine, and the same application may be made to alkylamine and heteroarylamine.

Here, the aryl in each of arylamine, heteroarylamine, and arylheteroarylamine may be monocyclic aryl or polycyclic aryl. The heteroaryl in each of arylamine, heteroarylamine, and arylheteroarylamine may be monocyclic heteroaryl or polycyclic heteroaryl.

The term "silyl" used in the compounds of the present disclosure is intended to encompass -SiH₃, alkylsilyl, arylsilyl, arylsilyl, alkylarylsilyl, arylheteroarylsilyl, heteroarylsilyl, and the like. Here, arylsilyl refers to a silyl resulting from substitution of aryl for one, two, or three hydrogen atoms of -SiH₃; alkylsilyl refers to a silyl resulting from substitution of alkyl for one, two, or three hydrogen atoms of -SiH₃; alkylarylsilyl refers to a silyl resulting from substitution of alkyl for one or two hydrogen atoms of -SiH₃ and aryl for one or two hydrogen atoms of -SiH₃; arylheteroarylsilyl refers to a silyl resulting from substitution of aryl for one or two hydrogen atoms of -SiH₃ and heteroaryl for one or two hydrogen atoms of -SiH₃;
heteroarylsilyl refers to a silyl resulting from substitution of heteroaryl for one, two, or three hydrogen atoms of -SiH₃. Examples of the arylsilyl include a substituted or unsubstituted monoarylsilyl, a substituted or unsubstituted diarylsilyl, and a substituted or unsubstituted triarylsilyl, and the same application may be made to alkylsilyl and heteroarylsilyl.

Here, the aryl in each of arylsilyl, heteroarylsilyl, and arylheteroarylsilyl may be monocyclic aryl or polycyclic aryl. The heateroaryl in each of arylsilyl, heteroarylsilyl, and arylheteroarylsilyl may be monocyclic heteroaryl and polycyclic heteroaryl.

Concrete examples of the silyl radicals used in the compounds of the present disclosure include trimethylsilyl, triethylsilyl, triphenylsilyl, trimethoxysilyl, dimethoxyphenylsilyl, diphenylmethylsilyl, diphenylvinlysilyl, methylcyclobutylsilyl, dimethyl furylsilyl, and the like. One or more hydrogen atoms on the silyl may be substituted by the same substituents as on the aryl.

As used herein, the term "germanium" (or germyl or germane) is intended to encompass -GeH₃, an alkyl germanium, an aryl germanium, a heteroaryl germanium, an alkylaryl germanium, an alkylheteroaryl germanium, an arylheteroaryl germanium, and the like. They can be accounted for by the definitions for silyl radicals, with the exception that the silicone atom (Si) in the silyl radical is substituted by a germanium atom (Ge).

Concrete examples of the germanium radical include trimethylgermane, triethylgermane, triphenylgermane, trimethoxygermane, dimethoxyphenylgermane, diphenylmethylgermane, diphenylvinylgermane, methylcyclobutylgermane, and dimethylfurylgermane. One or more hydrogen atoms on the germanium radical may be substituted by the same substituents as on the aryl.

In a preferable embodiment, the substituent counted for by the term "substituted" in the expression "substituted or unsubstituted" used for compounds of Chemical Formula A may be at least one selected from the group consisting of a deuterium atom, a cyano, a halogen, a hydroxy, a nitro, an alkyl of 1 to 12 carbon atoms, a halogenated alkyl of 1 to 12 carbon atoms, an alkenyl of 2 to 12 carbon atoms, an alkynyl of 2 to 12 carbon atoms, a cycloalkyl of 3 to 12 carbon atoms, a heteroalkyl of 1 to 12 carbon atoms, an aryl of 6 to 18 carbon atoms, an arylalkyl of 7 to 20 carbon atoms, an alkylaryl of 7 to 20 carbon atoms, a heteroaryl of 2 to 18 carbon atoms, a heteroarylalkyl of 3 to 18 carbon atoms, an alkylheteroaryl of 3 to 18 carbon atoms, an aromatic hydrocarbon ring-fused cycloalkyl of 9 to 20 carbon atoms, a heteroaromatic ring-fused cycloalkyl of 7 to 20 carbon atoms, an aromatic hydrocarbon ring-fused heterocycloalkyl of 9 to 20 carbon atoms, an aliphatic hydrocarbon ring-fused aryl of 9 to 20 carbon atoms, an aliphatic hydrocarbon ring-fused heteroaryl of 7 to 20 carbon atoms, an alkoxy of 1 to 12 carbon atoms, an amine of 1 to 18 carbon atoms, a silyl of 1 to 18 carbon atoms, a germanium of 1 to 18, an aryloxy of 6 to 18 carbon atoms, and an arylthionyl of 6 to 18 carbon atoms 6.

The anthracene compound, represented by Chemical Formula A, is structurally characterized by the anthracene ring moiety possessing the Ar₁ substituent, selected from a substituted or unsubstituted aryl of 6 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, and a substituted or unsubstituted aliphatic hydrocarbon ring-fused heteroaryl of 5 to 30 carbon atoms, on the carbon atom at position 9 thereof, and the linker L₁, selected from a single bond, a substituted or unsubstituted arylene of 6 to 20 carbon atoms, and a substituted or unsubstituted heteroarylene of 2 to 20 carbon atoms, on the carbon atom at position 10 thereof, wherein the linker L₁ has a substituent represented by the following Structural Formula A or B, with any one of R₉ to R₁₄ being a single bond to the linker L₁:

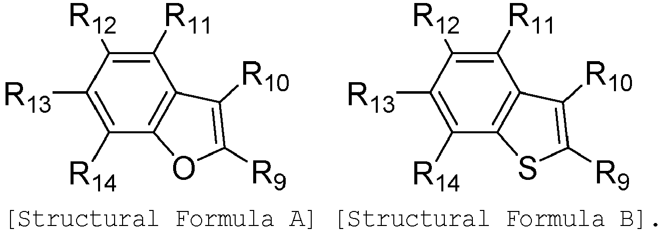

That is, any one of the substituents R₉ to R₁₄ in Structural Formulas A and B is a single bond to the linker L₁.

In an embodiment of the present disclosure, the compound represented by Chemical Formula A may be any one anthracene derivative represented by the following Chemical Formulas A-1 to A-6: 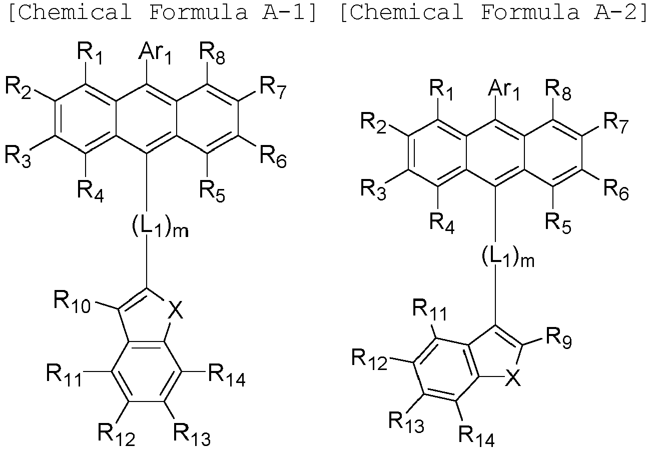 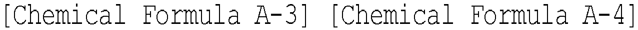 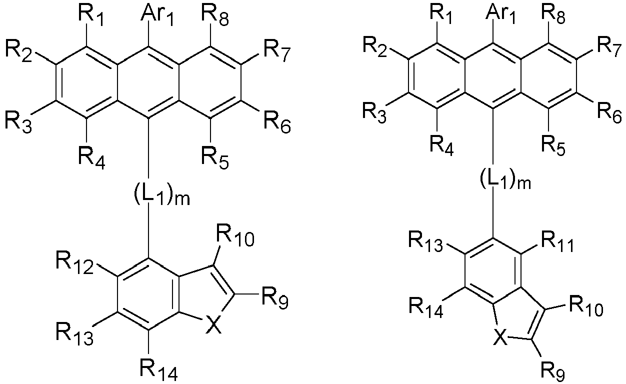 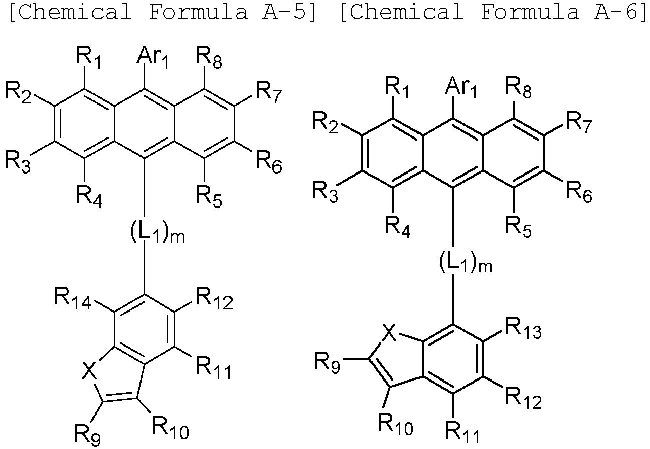 wherein,
Ar₁, R₁ to R₁₄, L₁, X, and m are each as defined in Chemical Formula A above, and more particularly, Ar₁ in Chemical Formulas A-1 to A-6 is a substituted or unsubstituted aryl of 6 to 18 carbon atoms or a substituted or unsubstituted heteroaryl of 2 to 18 carbon atoms,
R₁ to R₁₄, which are same or different, are each independently any one selected from a hydrogen atom, a deuterium atom, a substituted or unsubstituted alkyl of 1 to 15 carbon atoms, a substituted or unsubstituted cycloalkyl of 3 to 15 carbon atoms, a substituted or unsubstituted aryl of 6 to 18 carbon atoms, a substituted or unsubstituted heteroaryl of 2 to 18 carbon atoms, an amine of 1 to 18 carbon atoms, a silyl of 1 to 18 carbon atoms, a germanium of 1 to 18 carbon atoms, a cyano, a nitro, and a halogen,
X is an oxygen atom(O) or a sulfur atom(S),
L₁, which functions as a linker, is a single bond or any one selected from a substituted or unsubstituted arylene of 6 to 20 carbon atoms and a substituted or unsubstituted heteroarylene of 2 to 20 carbon atoms,
m is an integer of 1 or 2, wherein when m is 2, the corresponding L₁'s are same or different, wherein the term "substituted" in the expression "substituted or unsubstituted" is as defined above.

In an embodiment, the compound represented by Chemical Formula A may include at least one deuterium atom. In this regard, the deuterium atom may substitute for at least one hydrogen atom attached to at least one selected from the anthracene moiety including R₁ to R₈, the substituent Ar₁ moiety, the linker L₁ moiety, and the heteroring moiety including R₉ to R14 .

According to an embodiment, at least one of R₁₁ to R₁₄ in the anthracene derivatives represented by Chemical Formulas A-1 and A-2 may be a substituted or unsubstituted aryl of 6 to 20 carbon atoms, a substituted or unsubstituted cycloalkyl of 3 to 20 carbon atoms, and a substituted or unsubstituted heteroaryl of 3 to 20 carbon atoms, wherein at least one of R₁₁ to R₁₄ in the anthracene derivative represented by Chemical Formulas A-1 and A-2 may be a deuterated or undeuterated aryl of 6 to 20 carbon atoms.

In an embodiment, the linkers L₁ in Chemical Formula A may each be a single bond or a substituted or unsubstituted arylene of 6 to 18 carbon atoms and more preferably a single bond or any one selected from the following Structural Formulas 1 to 5:

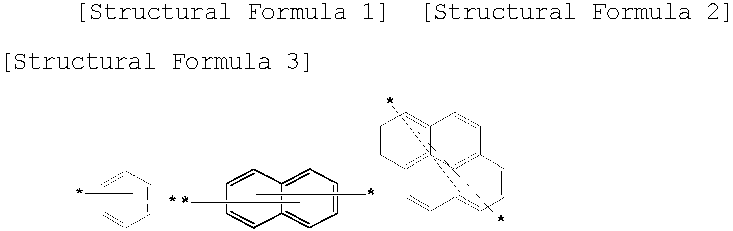

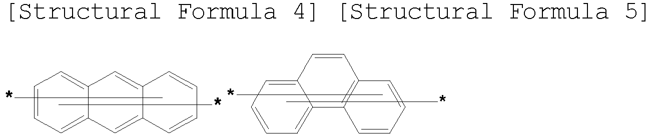

In the linkers, each of the unsubstituted carbon atoms of the aromatic ring moiety is bound with a hydrogen atom or a deuterium atom.

According to an embodiment, Ar₁ in Chemical Formula A may be a substituted or unsubstituted aryl of 6 to 18 carbon atoms. Preferably, Ar₁ in Chemical Formula A may be an aryl of 6 to 18 carbon atoms with or without a substituent selected from a deuterium atom, a phenyl, and a naphthyl.

In addition, when Ar₁ is a substituted or unsubstituted aryl of 6 to 18 carbon atoms that may be any one selected from a substituted or unsubstituted phenyl, a substituted or unsubstituted naphthyl, a substituted or unsubstituted biphenyl, a substituted or unsubstituted anthracenyl, a substituted or unsubstituted phenanthrenyl, and a substituted or unsubstituted fluorenyl.

In an embodiment, R₁ to R₈ in Chemical Formula A, which are same or different, may each be a hydrogen atom or a deuterium atom. In this regard, the anthracene compound with a deuterium atom for at least one of R₁ to R₉ in Chemical Formula A allows for an improved longevity effect, compared to that with a hydrogen atom for the same substituent.

In an embodiment, when including at least one deuterium atom, the anthracene compound represented by Chemical Formula A may have a degree of deuteration of 10% or higher, preferably a degree of deuteration 20% or higher, more preferably a degree of deuteration of 30% or higher, more preferably a degree of deuteration of 40% or higher, more preferably a degree of deuteration of 50% or higher, more preferably a degree of deuteration of 60% or higher, more preferably a degree of deuteration of 70% or higher, and more preferably a degree of deuteration of 80 or higher.

In the anthracene derivative represented by Chemical Formula A according to an embodiment, the substituent R₉ or R₁₀ may be a single bond to the linker L₁.

According to an embodiment, the substituent R₉ in the anthracene derivative represented by Chemical Formula A may be a substituted or unsubstituted aryl of 6 to 18 carbon atoms or a substituted or unsubstituted heteroaryl of 2 to 18 carbon atoms. Preferably, the substituent R₉ may be any one selected from a substituted or unsubstituted phenyl, a substituted or unsubstituted naphthylyl, a substituted or unsubstituted biphenyl, a substituted or unsubstituted anthracenyl, a substituted or unsubstituted phenanthrenyl, a substituted or unsubstituted fluorenyl, a substituted or unsubstituted benzofuran, a substituted or unsubstituted benzothiophene, a substituted or unsubstituted dibenzofuran, and a substituted or unsubstituted dibenzothiophene.

According to an embodiment, the substituent R₁₀ in the anthracene derivative represented by Chemical Formula A is a hydrogen atom or a deuterium atom and, in this context, the substituent R₉ may be a substituted or unsubstituted aryl of 6 to 18 carbon atoms or a substituted or unsubstituted heteroaryl of 2 to 18 carbon atoms. More preferably, when the substituent R₁₀ is a hydrogen atom or a deuterium atom, the substituent R₉ may be any one selected from a substituted or unsubstituted phenyl, a substituted or unsubstituted naphthylyl, a substituted or unsubstituted biphenyl 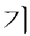 , a substituted or unsubstituted anthracenyl, a substituted or unsubstituted phenanthrenyl, a substituted or unsubstituted fluorenyl, a substituted or unsubstituted benzofuran, a substituted or unsubstituted benzothiophene, a substituted or unsubstituted dibenzofuran, and a substituted or unsubstituted dibenzothiophene.

Concrete examples of the anthracene derivative represented by Chemical Formula A include the following [Compound A-1] to [Compound A-218], but are not limited thereto:

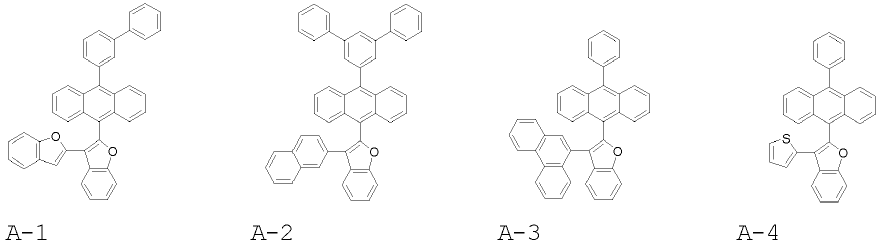

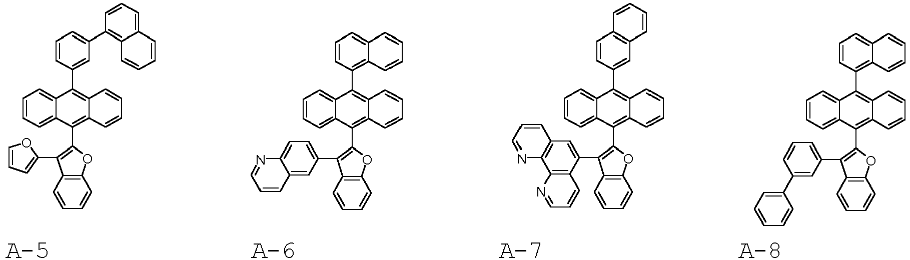

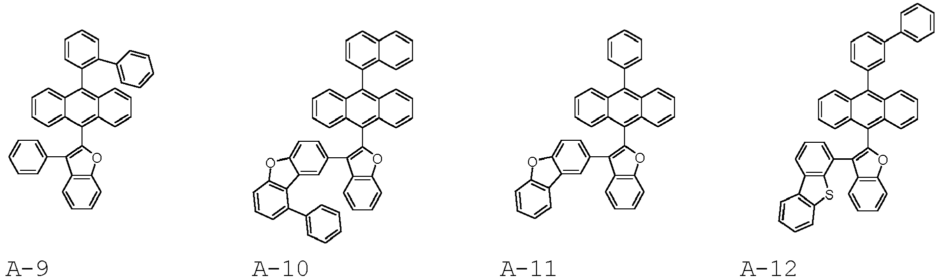

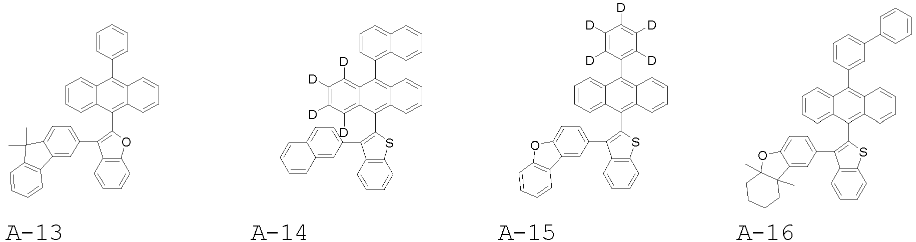

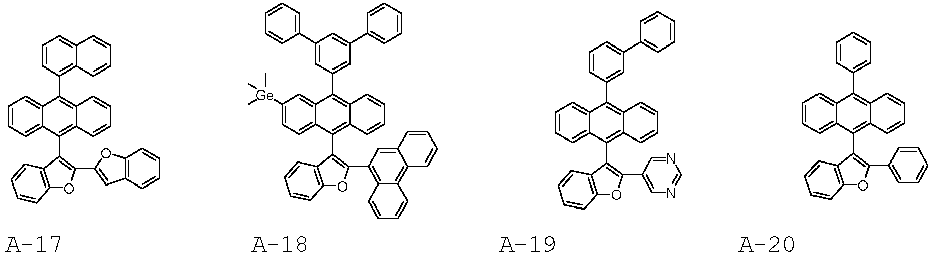

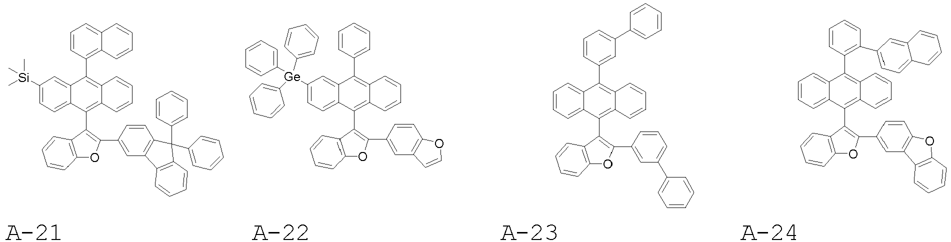

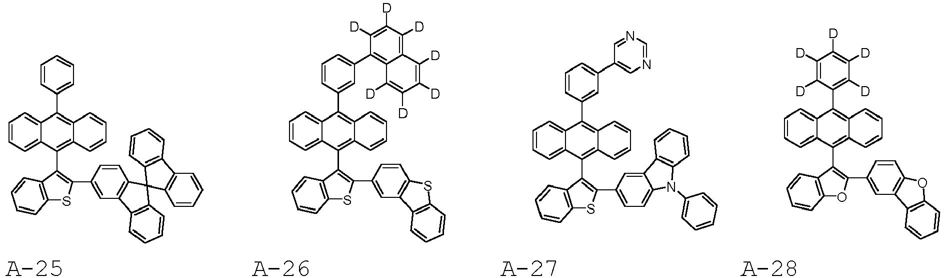

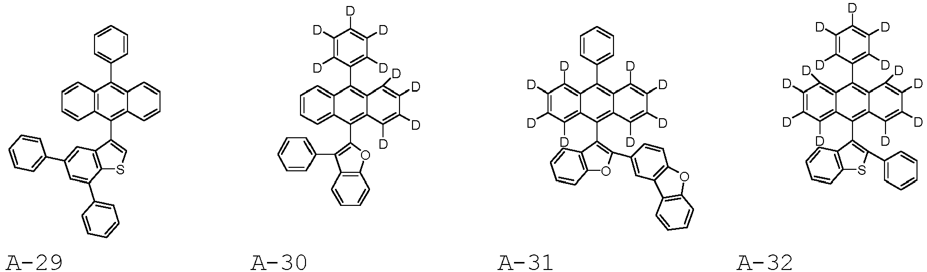

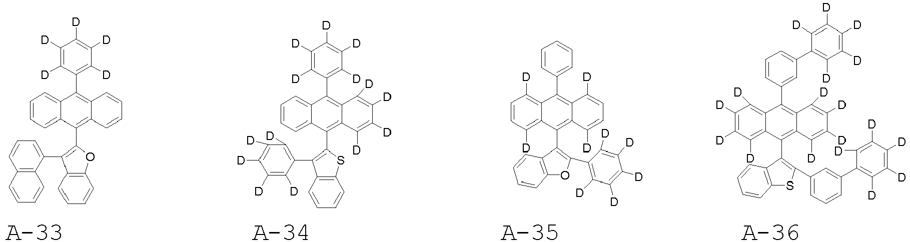

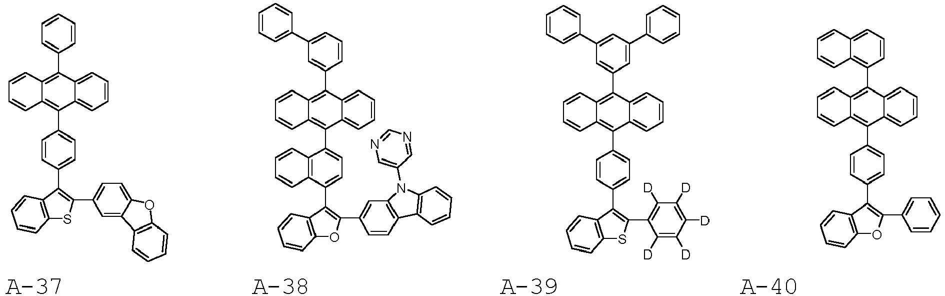

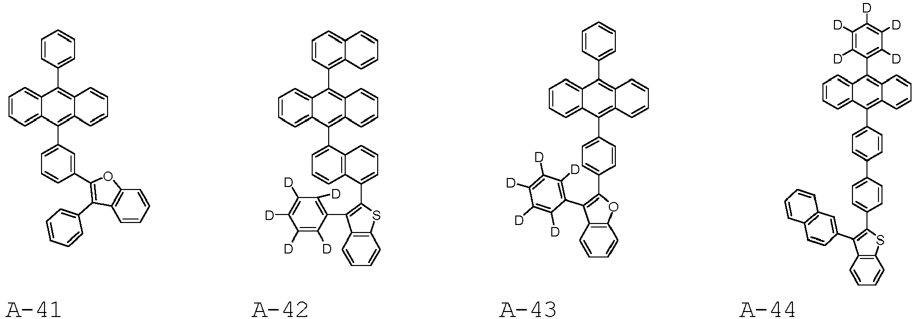

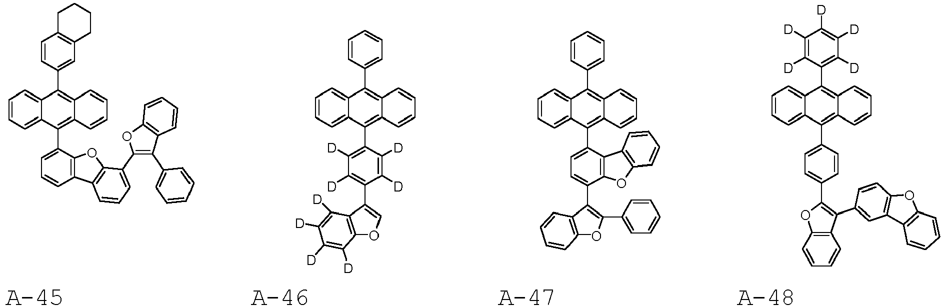

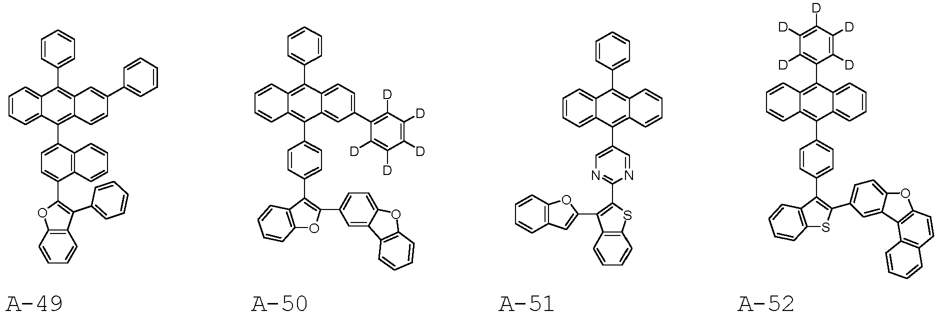

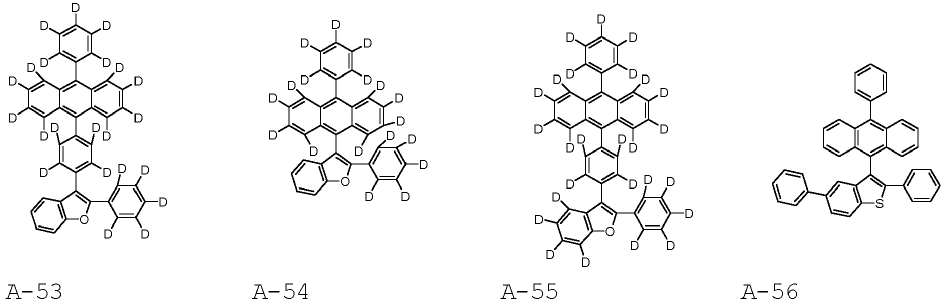

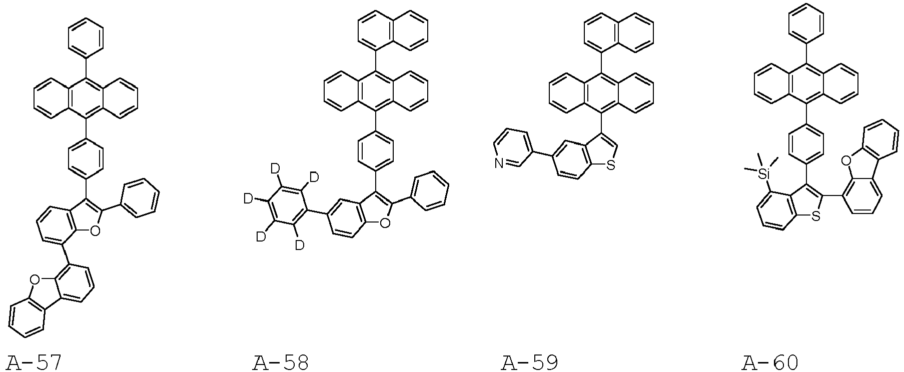

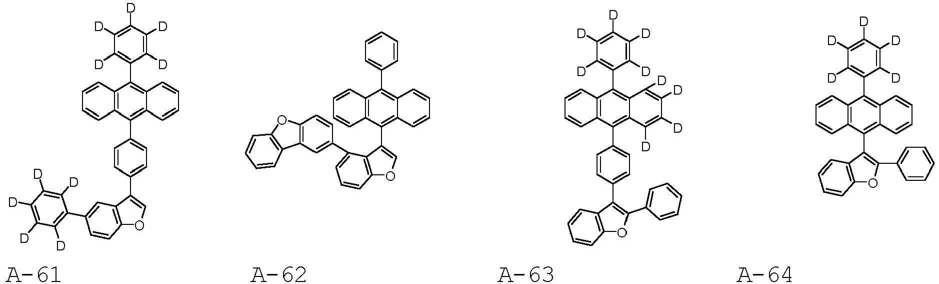

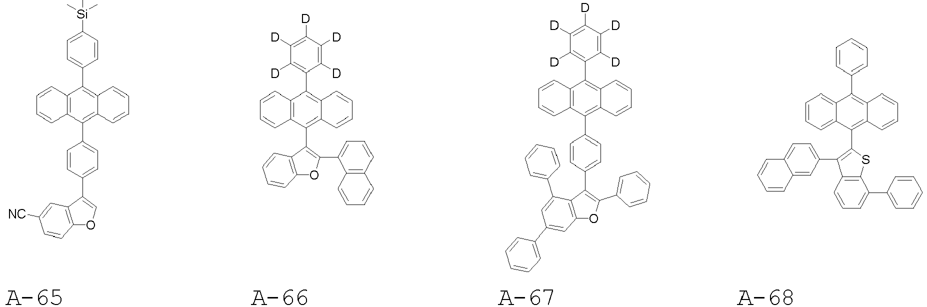

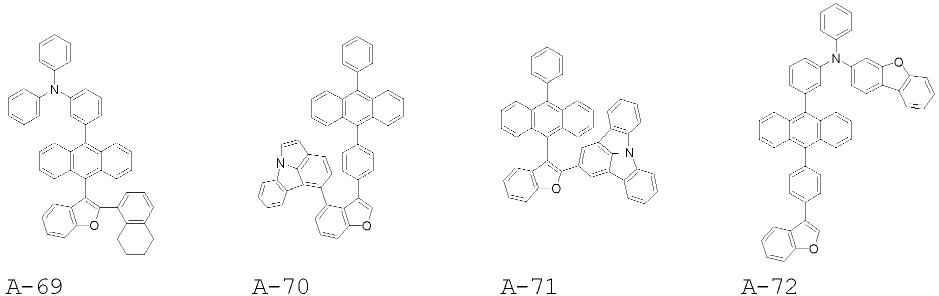

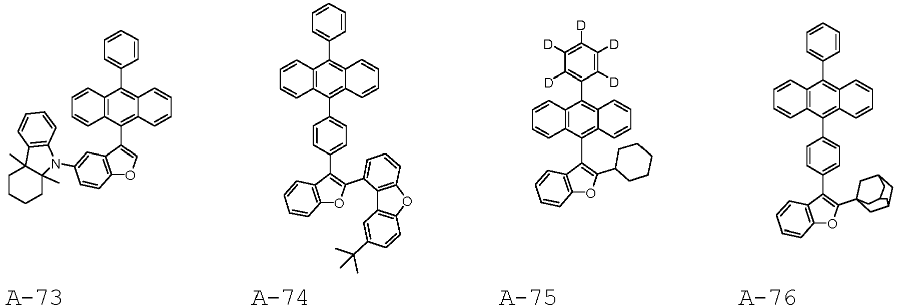

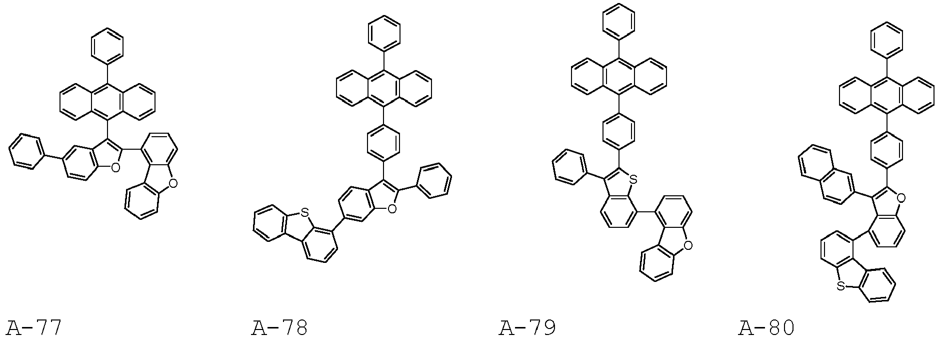

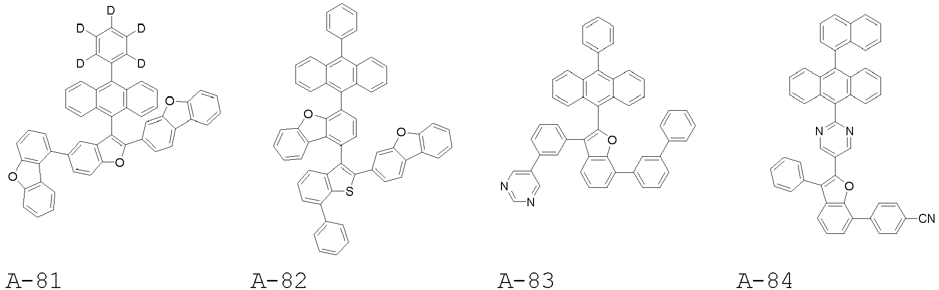

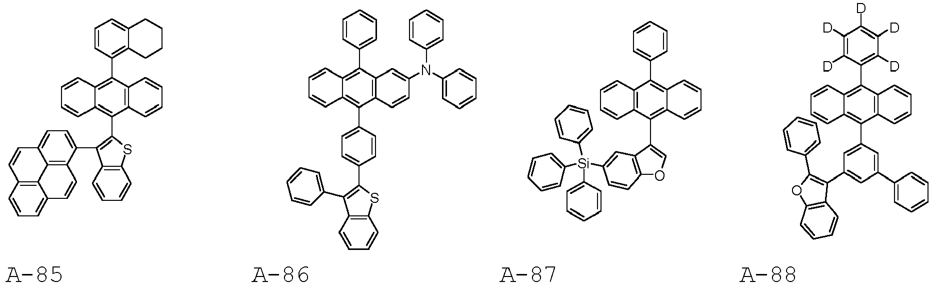

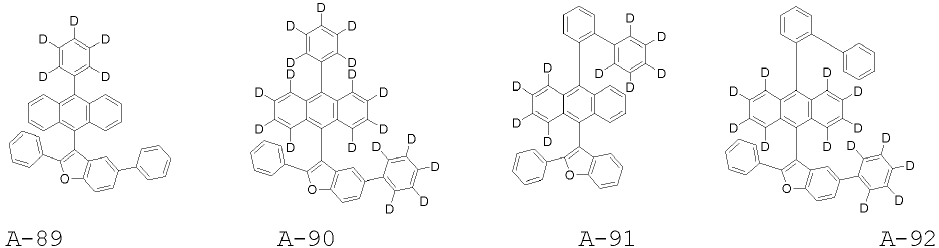

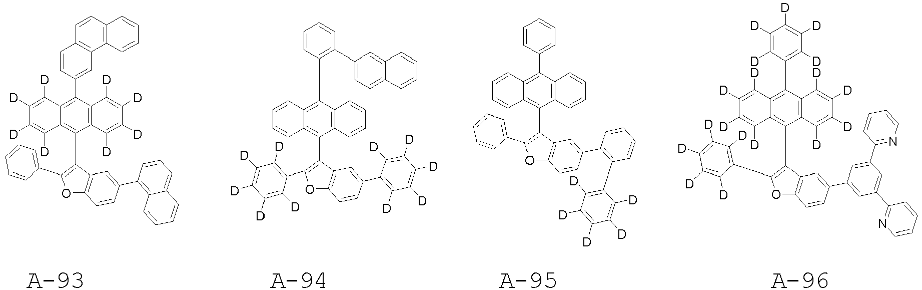

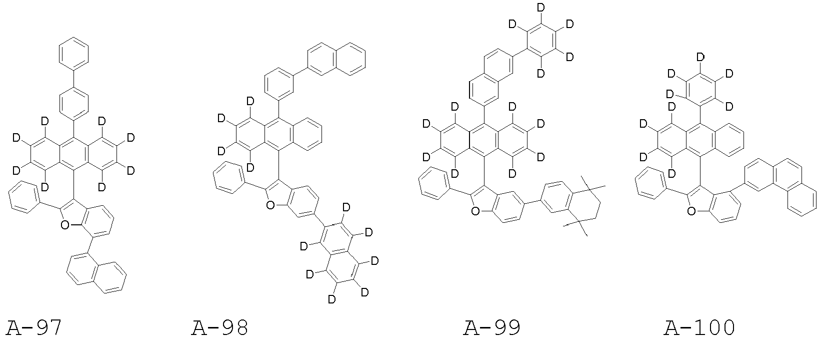

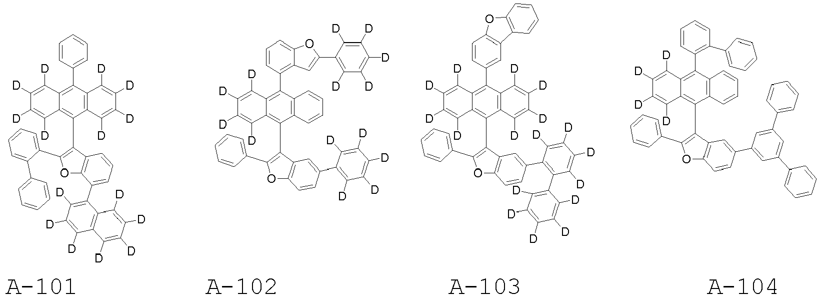

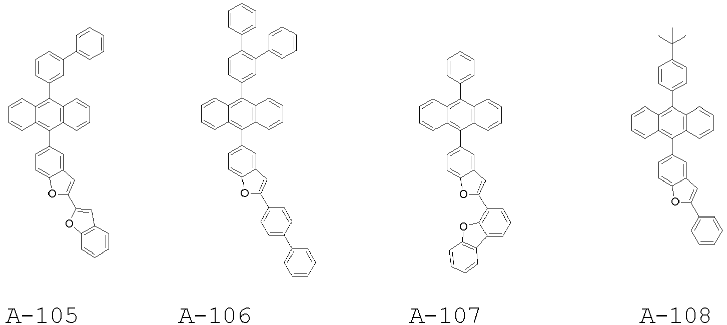

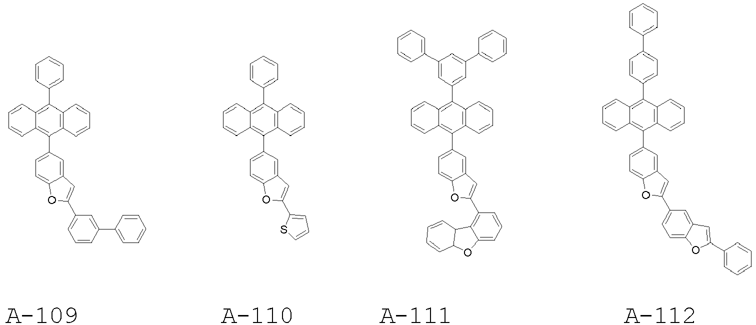

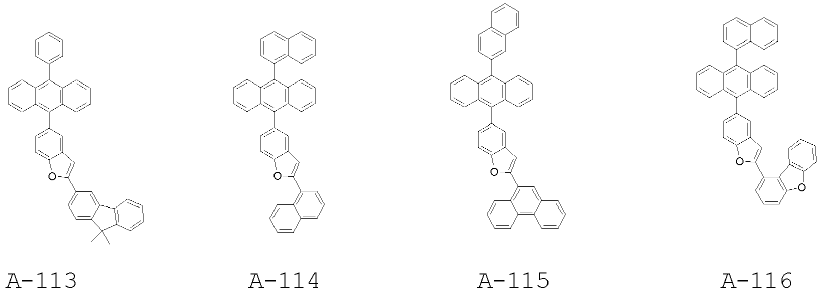

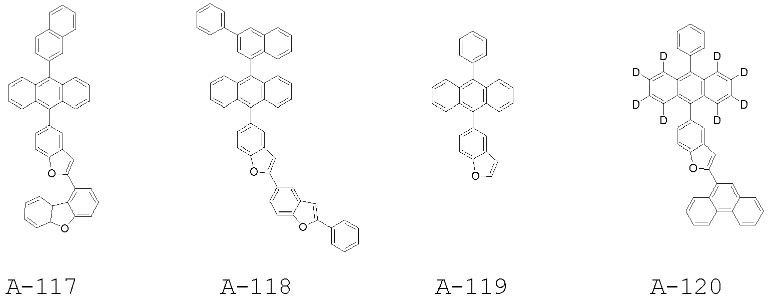

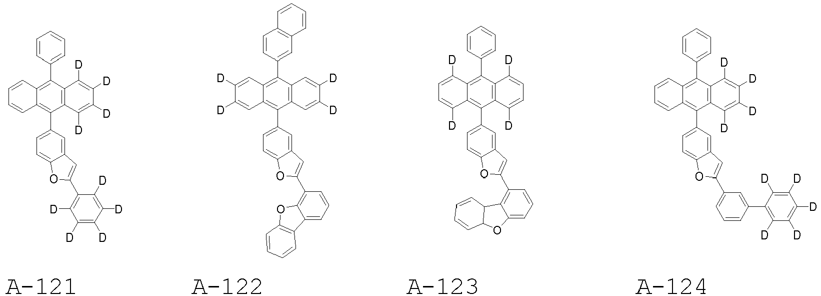

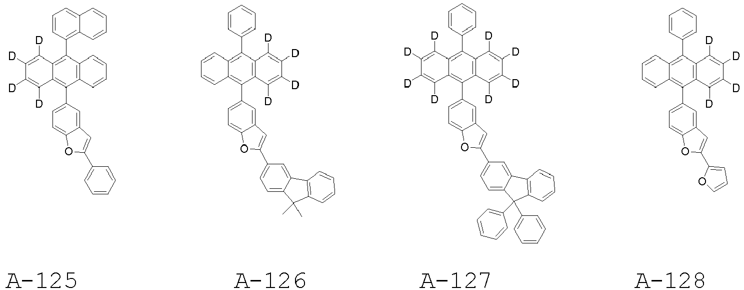

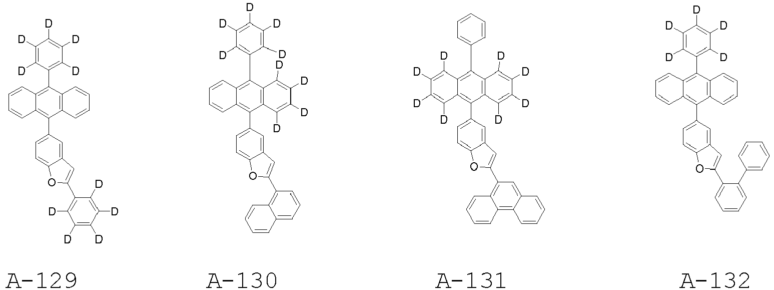

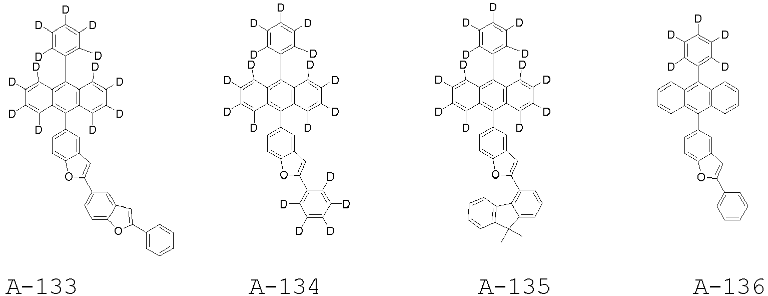

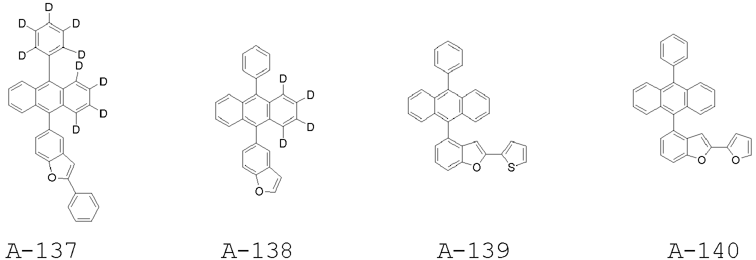

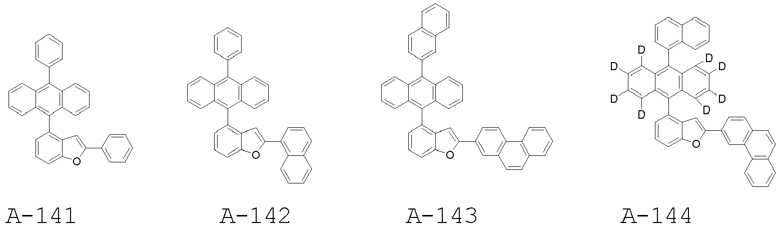

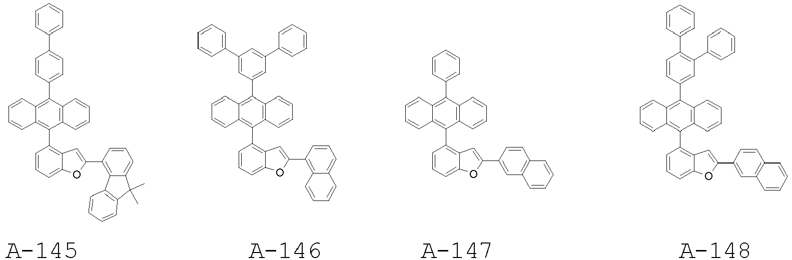

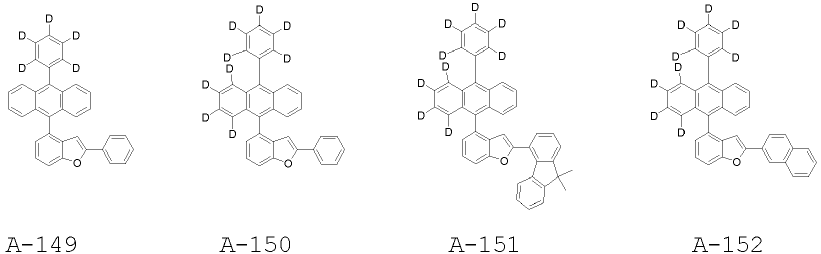

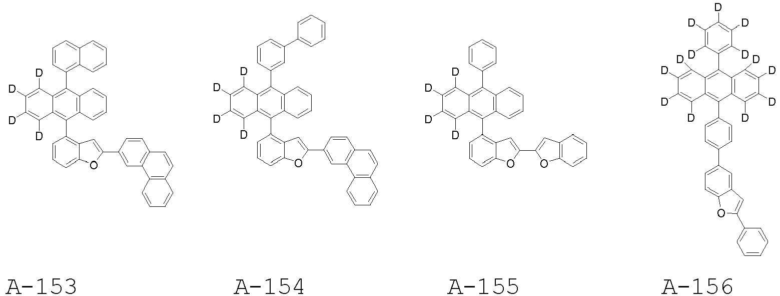

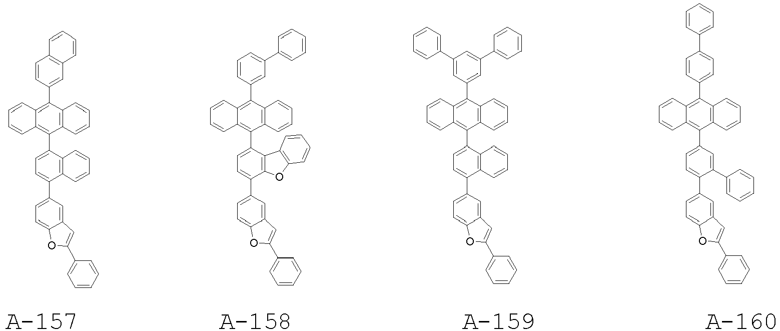

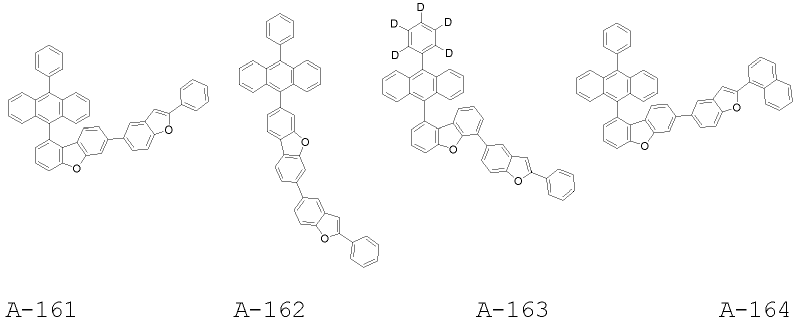

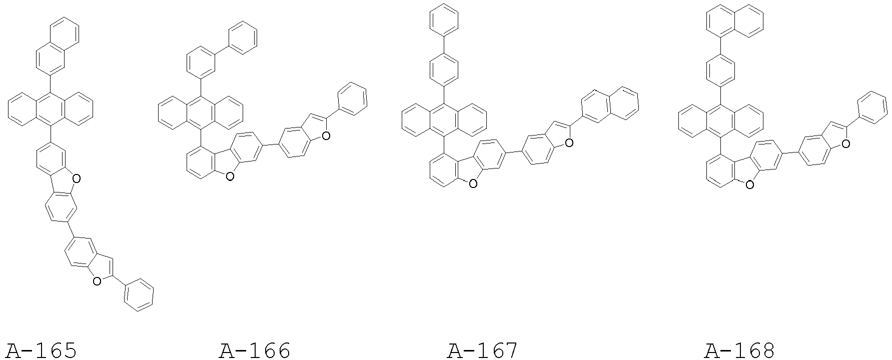

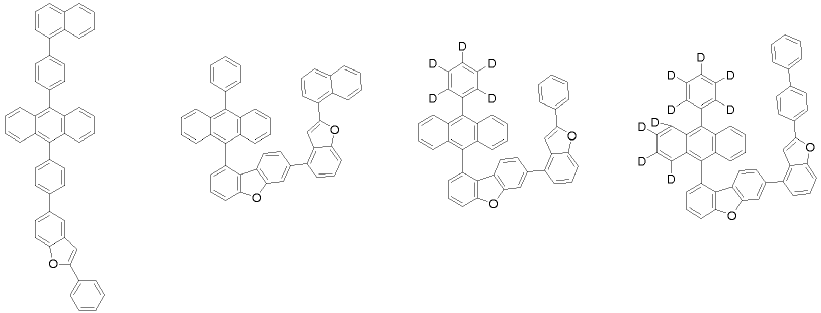

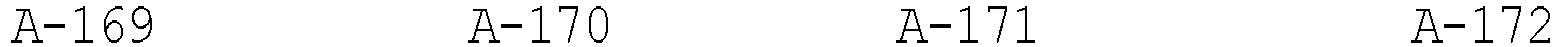

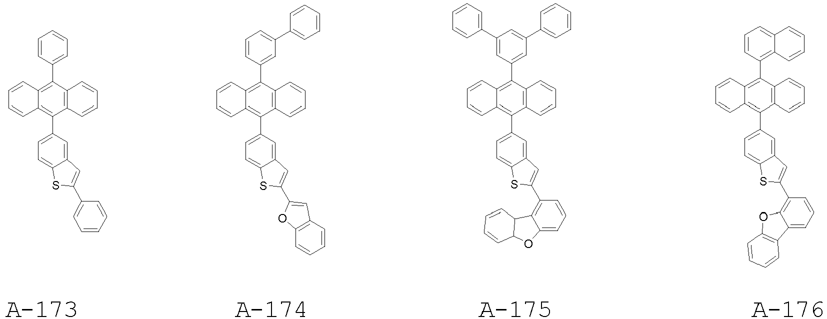

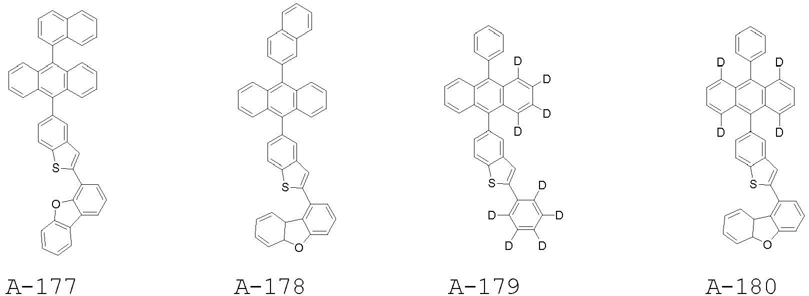

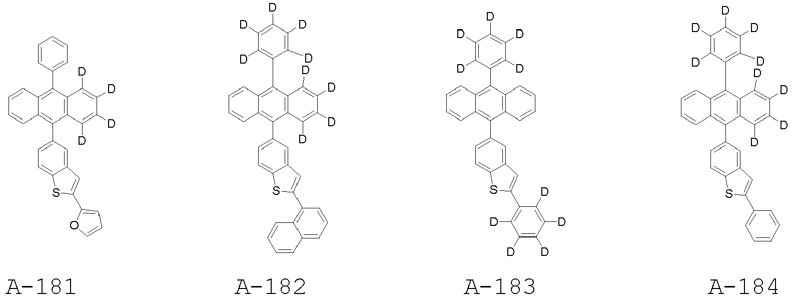

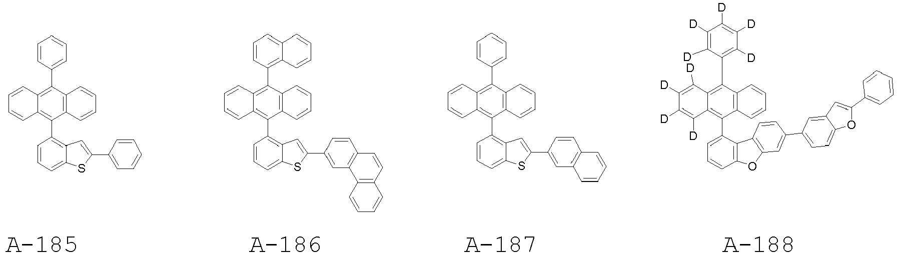

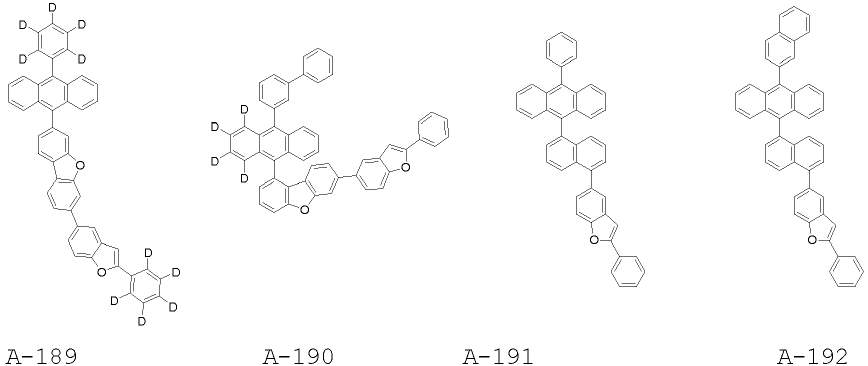

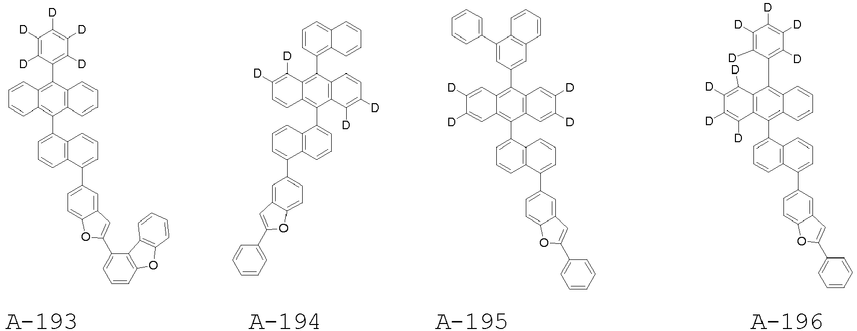

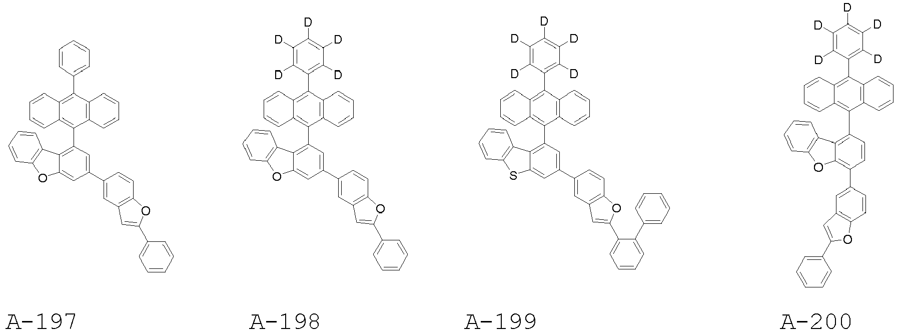

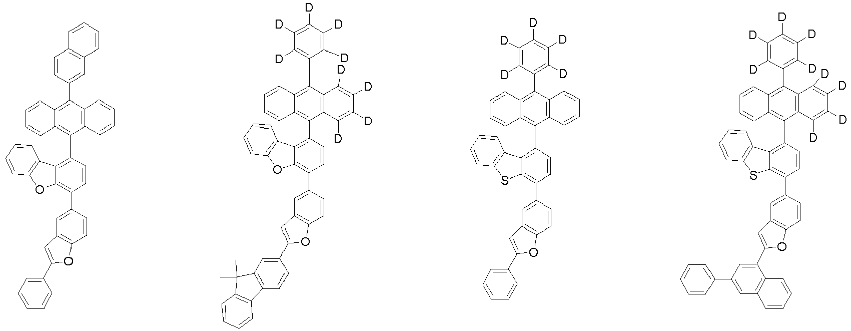

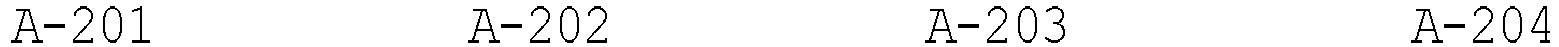

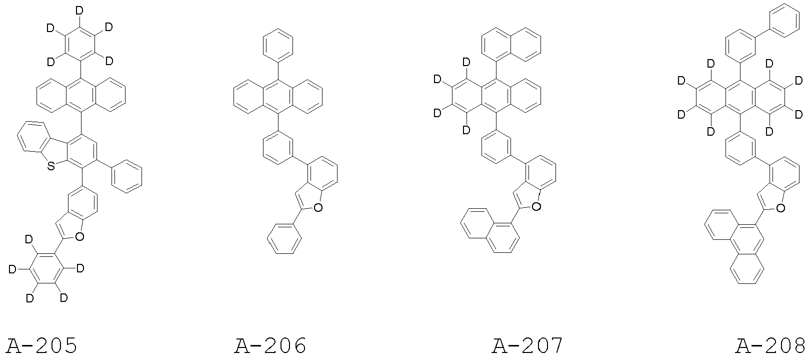

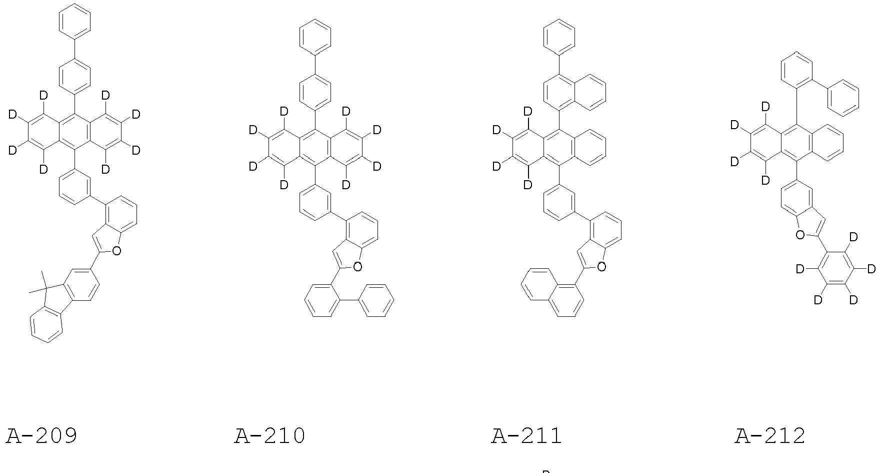

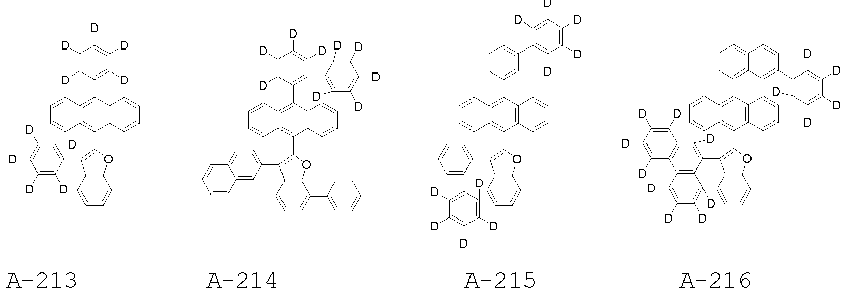

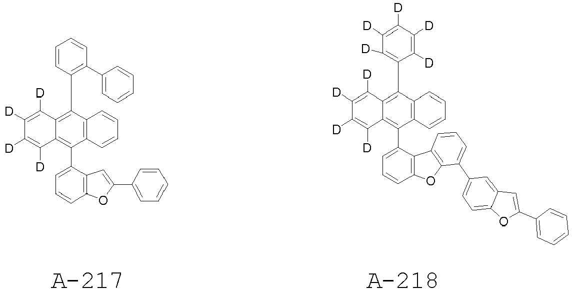

As used herein, the expression "(light-emitting layer) including at least one organic compound" is construed to mean that the organic layer may include one organic compound falling within the scope of the present disclosure or two or more different compounds falling within the scope of the present disclosure.

In an embodiment, the organic light-emitting diode according to an embodiment may include at least one of a hole transport layer and a hole injection layer between the first electrode and the first light-emitting layer, and at least one of an electron transport layer and an electron injection layer between the second light-emitting layer and the second electrode.

Dopant compounds useful in the light-emitting layers where the anthracene derivatives represented by Chemical Formula A are employed as hosts will be elucidated in detail.

In a preferable embodiment of the present disclosure, the organic light-emitting diode may include a compound represented by any one of the following Chemical Formulas D-1 to D-3 as at least one of a first dopant in the first light-emitting layer and a second dopant in the second light-emitting layer. 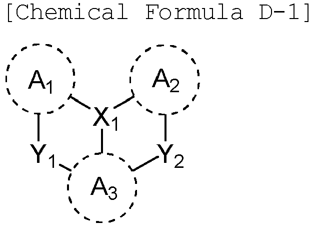 wherein,
X₁ is any one selected from B, P=O, and P=S,
Y₁ and Y₂, which are same or different, are each independently any one selected from NR₂₁, CR₂₂R₂₃, O, S, Se, and SiR₂₄R₂₅,
A₁ to A₃, which are same or different, are each independently any one selected from a substituted or unsubstituted aromatic hydrocarbon ring of 6 to 50 carbon atoms, a substituted or unsubstituted aliphatic hydrocarbon ring of 5 to 50 carbon atoms, a substituted or unsubstituted fused ring of 7 to 50 carbon atoms in which an aromatic hydrocarbon ring is fused with an aliphatic hydrocarbon ring, a substituted or unsubstituted heteroaromatic ring of 2 to 50 carbon atoms, a substituted or unsubstituted fused ring of 6 to 40 carbon atoms in which a heteroaromatic ring is fused with an aliphatic hydrocarbon ring,
R₂₁ to R₂₅, which are same or different, are each independently any one selected from a hydrogen atom, a deuterium atom, a substituted or unsubstituted alkyl of 1 to 30 carbon atoms, a substituted or unsubstituted alkenyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted heterocyclic alkyl of 3 to 30 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a nitro, a cyano, and a halogen,
at least one of R₂₁ to R₂₅ may be connected to at least one of A₁ to A₃ ring moieties to additionally form a mono- or polycyclic aliphatic or aromatic ring or an aliphatic and aromatic fused ring,
adjacent substituents in A₁ to A₃ ring moieties may be connected to each other to form a mono- or polycyclic aliphatic or aromatic ring or an aliphatic and aromatic fused ring, and
a linkage may be made between R₂₂ and R₂₃ or between R₂₄ and R₂₅ to form a mono- or polycyclic aliphatic or aromatic ring or an aliphatic and aromatic fused ring; 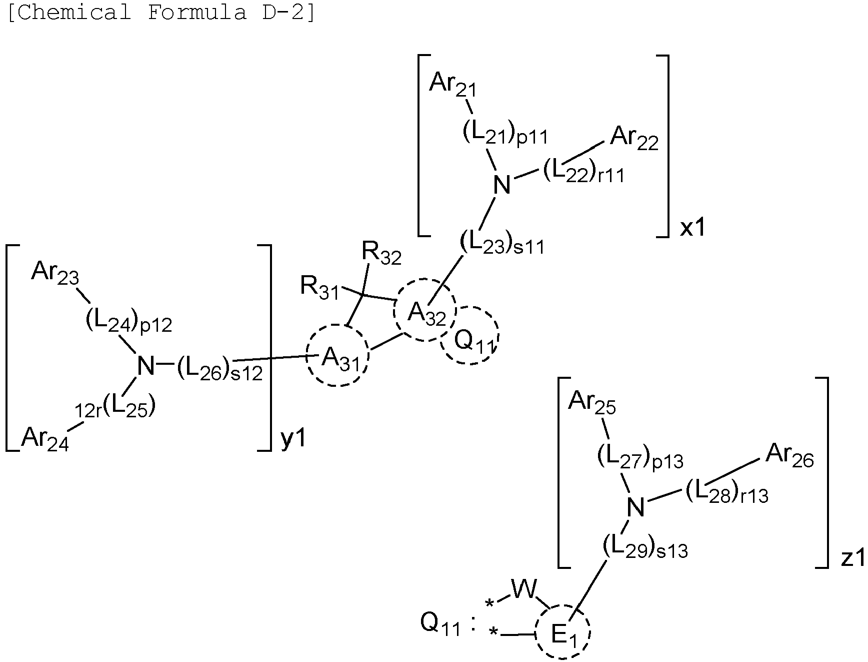 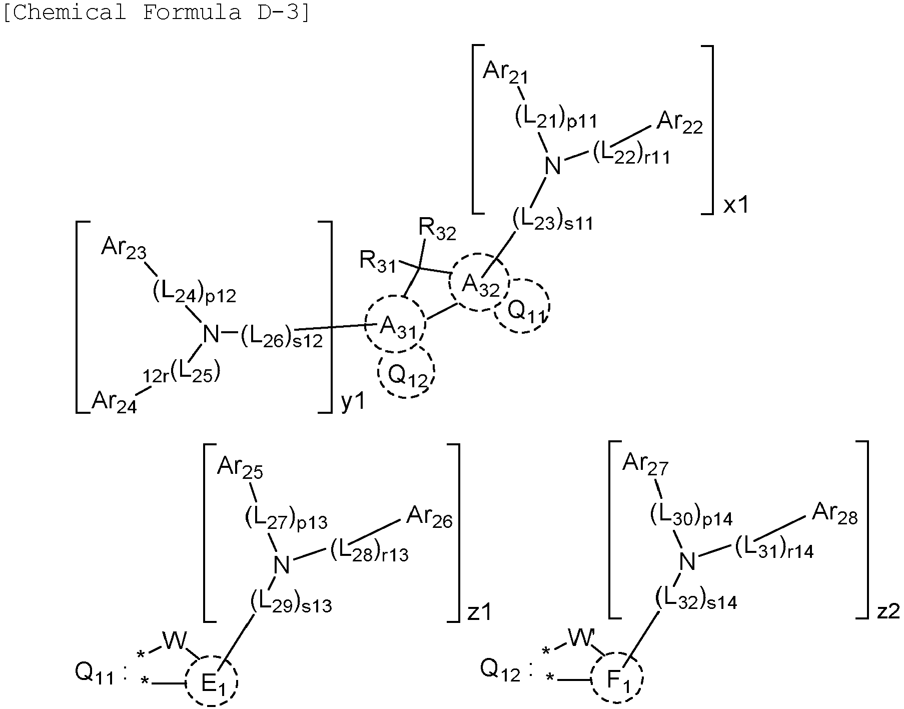
wherein,
   A₃₁, A₃₂, E₁, and F₁, which are same or different, are each independently any one selected from a substituted or unsubstituted aromatic hydrocarbon ring of 6 to 50 carbon atoms, a substituted or unsubstituted aliphatic hydrocarbon ring of 5 to 50 carbon atoms, a substituted or unsubstituted fused ring of 7 to 50 carbon atoms in which an aromatic hydrocarbon ring is fused with an aliphatic hydrocarbon ring, a substituted or unsubstituted heteroaromatic ring of 2 to 50 carbon atoms, a substituted or unsubstituted fused ring of 6 to 40 carbon atoms in which a heteroaromatic ring is fused with an aliphatic hydrocarbon ring;
   two adjacent carbon atoms of the aromatic ring A₃₁ and two adjacent carbon atoms of the aromatic ring A₃₂ form a 5-membered fused ring together with a carbon atom to which substituents R₃₁ and R₃₂ are bonded;
   linkers L₂₁ to L₃₂, which are same or different, are each independently selected from among a single bond, a substituted or unsubstituted alkylene of 1 to 60 carbon atoms, a substituted or unsubstituted alkenylene of 2 to 60 carbon atoms, a substituted or unsubstituted alkynylene of 2 to 60 carbon atoms, a substituted or unsubstituted cycloalkylene of 3 to 60 carbon atoms, a substituted or unsubstituted heterocycloalkylene of 2 to 60 carbon atoms, a substituted or unsubstituted arylene of 6 to 60 carbon atoms, and a substituted or unsubstituted heteroarylene of 2 to 60 carbon atoms
   W and W', which are same or different, are each independently any one selected from N-R₃₃, CR₃₄R₃₅, SiR₃₆R₃₇, GeR₃₈R₃₉, O, S, and Se;
   R₃₁ to R₃₉ and Ar₂₁ to Ar₂₈, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 5 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a cyano, a nitro, and a halogen,
      wherein R₃₁ and R₃₂ together may form a mono- or polycyclic aliphatic or aromatic ring that may be a heterocyclic ring bearing a heteroatom selected from among N, O, P, Si, S, Ge, Se, and Te as a ring member;
   p₁₁ to p₁₄, r₁₁ to r₁₄, and s₁₁ to s₁₄ are each independently an integer of 1 to 3, wherein when any of them is 2 or greater, the corresponding linkers L₂₁ to L₃₂ are same or different,
   x₁ is 1, and y₁, z₁, and z₂, which are same or different, are each independently an integer of 0 to 1; and
   Ar₂₁ may form a ring with Ar₂₂, Ar₂₃ may form a ring with Ar₂₄, Ar₂₅ may form a ring with Ar₂₆, and Ar₂₇ may form a ring with Ar₂₈;
   two adjacent carbon atoms of the A₃₂ ring moiety of Chemical Formula D-1 may occupy respective positions * of Structural Formula Q₁₁ to form a fused ring, and
   two adjacent carbon atoms of the A₃₁ ring moiety of Chemical Formula D-2 may occupy respective positions * of Structural Formula Q₁₂ to form a fused ring, and two adjacent carbon atoms of the A₃₂ ring moiety of Chemical Formula D-2 may occupy respective positions * of Structural Formula Q₁₁ to form a fused ring,
   wherein the term "substituted" in the expression "substituted or unsubstituted" used for Chemical Formulas D-1 to D-3 is as defined in Chemical Formula A.

The polycyclic compound represented by Chemical Formula D-1 may be a compound represented by any one of the following Chemical Formulas D-4 to D-11: 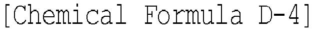 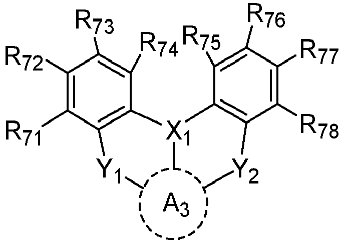 wherein,
R₇₁ to R₇₈, which are same or different, are each independently at least one selected from a hydrogen atom, a deuterium atom, a substituted or unsubstituted alkyl of 1 to 30 carbon atoms, a substituted or unsubstituted alkenyl of 2 to 30 carbon atoms, a substituted or unsubstituted aryl of 5 to 50 carbon atoms, a substituted or unsubstituted cycloalkyl of 3 to 30 carbon atoms, a substituted or unsubstituted heterocyclic alkyl of 3 to 30 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a nitro, a cyano, and a halogen, and may further form a mono- or polycyclic aliphatic or aromatic ring with an adjacent radical thereto,
X₁, Y₁, Y₂, and A₃ are each as defined in Chemical Formula D-1, above; 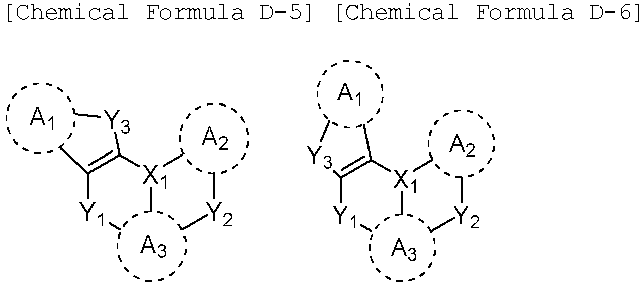
wherein,
   Y₁ to Y₃, which are same or different, are each independently any one selected from NR₂₁, CR₂₂R₂₃, O, S, Se, and SiR₂₄R₂₃,
   X₂, A₁ to A₃, and R₂₁ to R₂₅ are each as defined in Chemical Formula D-1; 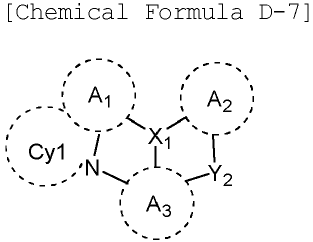
   wherein,
      X₁, Y₂, and A₁ to A₃ are each as defined in Chemical Formula D-1,
      Cy1 accounts for a fused ring bearing, as ring members, the nitrogen atom (N) and two adjacent aromatic carbon atoms contributed by A₁ ring, one of which is bonded to the nitrogen atom (N),
      the ring accounted for by Cy1 being composed of a substituted or unsubstituted alkylene of 2 to 5 carbon atoms, the nitrogen (N) atom, the aromatic carbon atom of A₁ to which the nitrogen (N) atom is bonded, and the aromatic carbon atom of A₁ to which Cy1 is to bond; 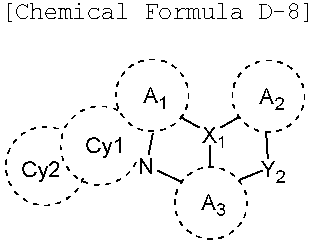
      wherein,
         X₁, Y₂, A₁ to A₃ are each as defined in Chemical Formula D-1 above,
         Cy1 accounts for a fused ring bearing, as ring members, the nitrogen atom (N) and two adjacent aromatic carbon atoms of A₁ ring one of which is bonded to the nitrogen atom (N),
         the ring accounted for by Cy1 being composed of a substituted or unsubstituted alkylene of 2 to 5 carbon atoms, the nitrogen (N) atom, the aromatic carbon atom of A₁ to which the nitrogen (N) atom is bonded, and the aromatic carbon atom of A₁ to which Cy1 is to bond;
         Cy2 accounts for a saturated hydrocarbon ring added to Cy1 and is composed of a substituted or unsubstituted alkylene of 2 to 5 carbon atoms except for the carbon atoms contributed by Cy1; 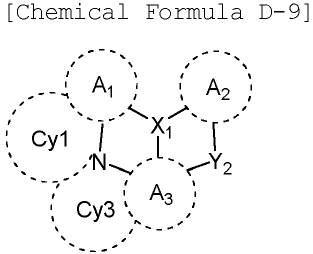
         wherein,
            X₁, Y₂, and A₃ to A₃ are each as defined in Chemical Formula D-1 above,
            Cy1 accounts for a fused ring bearing, as ring members, the nitrogen atom (N) and two aromatic carbon atoms contributed by A₁ ring, one of which is bonded to the nitrogen atom (N),
            the ring accounted for by Cy1 being composed of a substituted or unsubstituted alkylene of 2 to 5 carbon atoms, the nitrogen (N) atom, the aromatic carbon atom of A₁ to which the nitrogen (N) atom is bonded, and the aromatic carbon atom of A₁ to which Cy1 is to bond,
            Cy3 accounts for a fused ring bearing, as ring members, the nitrogen atom, the carbon atom of Cy1 bonded to the nitrogen atom, and two adjacent aromatic carbon atoms of A₃ ring one of which is bonded to the nitrogen atom,
            the ring accounted for by Cy3 being composed of a substituted or unsubstituted alkylene of 1 to 4 carbon atoms, the nitrogen atom (N), the aromatic carbon atom of A₃ bonded to the nitrogen atom, the carbon atom of Cy1 bonded to the nitrogen atom (N), and the aromatic carbon atom of A₃ to which Cy3 is to bond; 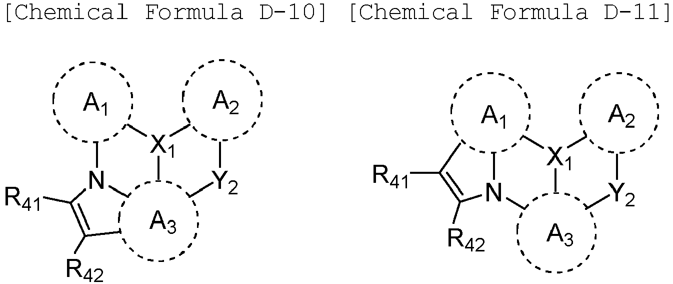
            wherein,
               R₄₁ and R₄₂, which are same or different, are each independently any one selected from a hydrogen atom, a deuterium atom, a substituted or unsubstituted alkyl of 1 to 30 carbon atoms, a substituted or unsubstituted alkenyl of 2 to 30 carbon atoms, a substituted or unsubstituted aryl of 5 to 50 carbon atoms, a substituted or unsubstituted cycloalkyl of 3 to 30 carbon atoms, a substituted or unsubstituted heterocyclic alkyl of 3 to 30 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a nitro, a cyano, and a halogen,
               R₄₁ and R₄₂ may be connected to each other to additionally form a mono- or polycyclic aliphatic or aromatic ring or an aliphatic and aromatic fused ring,
               X₁, Y₂, and A₁ to A₃ are each as defined in Chemical Formula D-1 above,
               wherein the term "substituted" in the expression "substituted or unsubstituted" used for compounds of Chemical Formulas D-4 to D-11 is as defined in the compounds of Chemical Formula A above.

Among the dopant compounds according to the present disclosure, the boron compound represented by any one of Chemical Formulas D-1 and D-4 to D-11 may have, on the aromatic hydrocarbon rings or heteroaromatic rings of A₁ to A₃, a substituent selected from a deuterium atom, an alkyl of 1 to 24 carbon atoms, an aryl of 6 to 24 carbon atoms, an amine of 1 to 24 carbon atoms, a silyl of 1 to 24 carbon atoms, and a germanium of 1 to 24 carbon atoms, wherein the two radicals (alkyl, aryl, heteroaryl, etc.) other than hydrogen atoms in the amine of 1 to 24 carbon atoms may be linked to each other, and particularly a substituent selected from an alkyl of 1 to 12 carbon atoms, an aryl of 6 to 18 carbon atoms, an amine of 1 to 12 carbon atoms, a silyl of 1 to 12 carbon atoms, and a germanium of 1 to 12 carbon atom, wherein the two radicals (alkyl, aryl, heteroaryl, etc.) other than hydrogen atoms in the amine of 1 to 24 carbon atoms may be linked to each other.

Concrete examples of the dopant compounds of Chemical Formula D-4 used in the light-emitting layer include, but are not limited to, the following compounds:

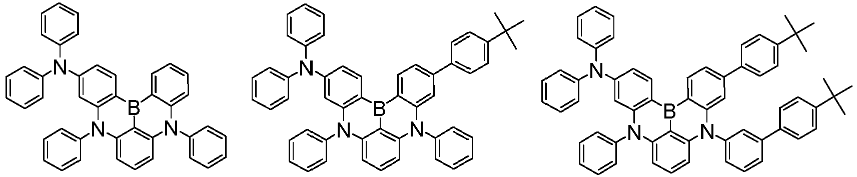

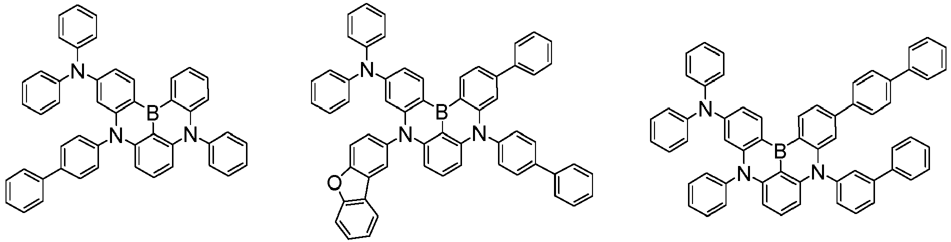

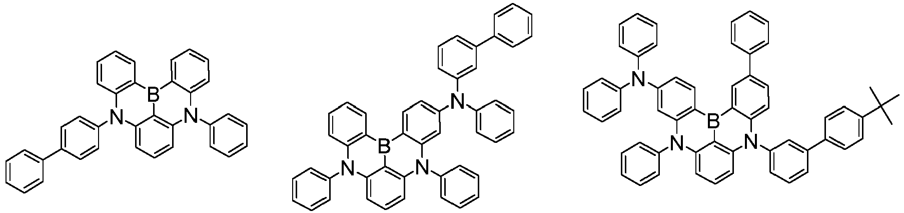

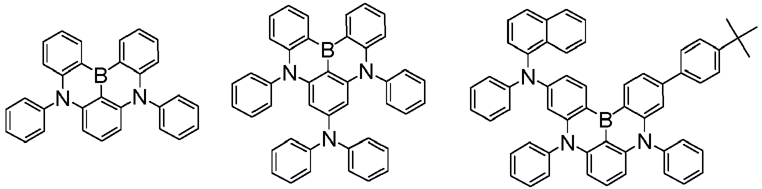

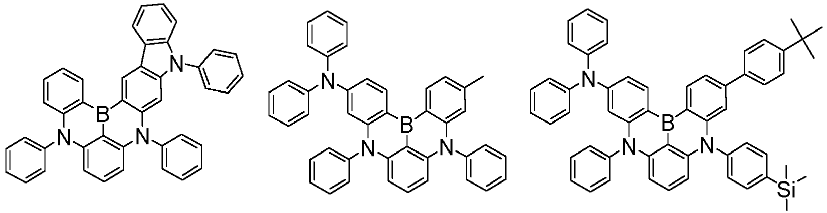

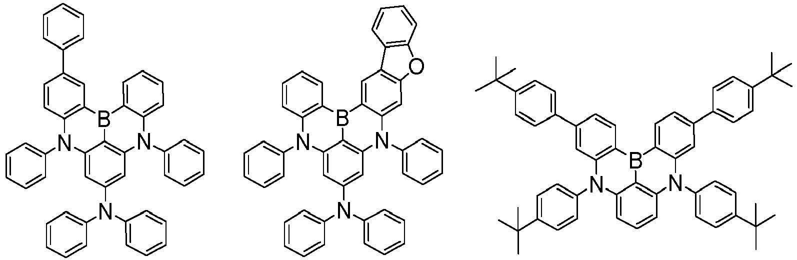

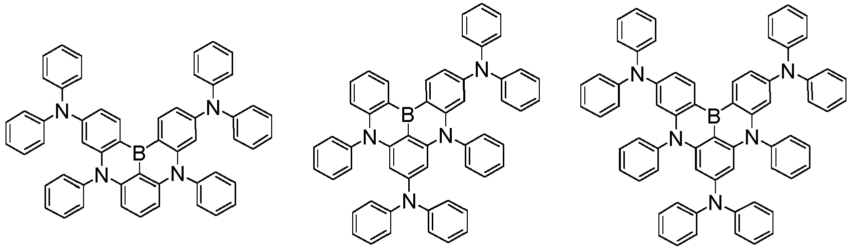

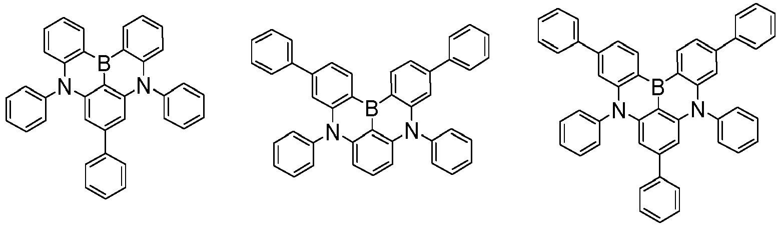

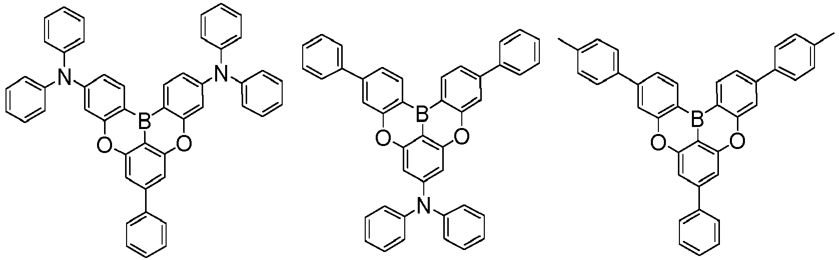

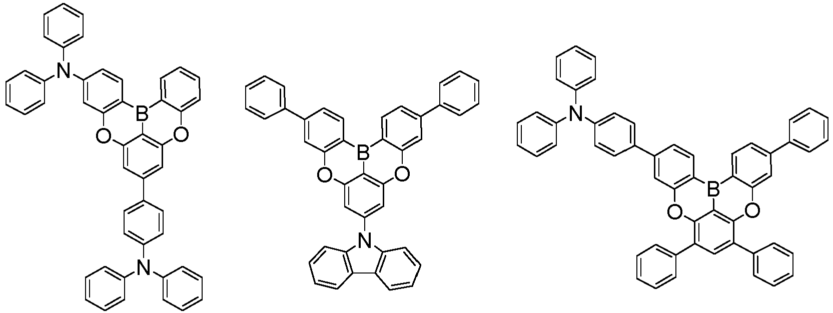

In addition, according to an embodiment of the present disclosure, the compound represented by Chemical Formula D-5 or D-6 may be any one selected from the group consisting of the following compounds, but with no limitations thereto:

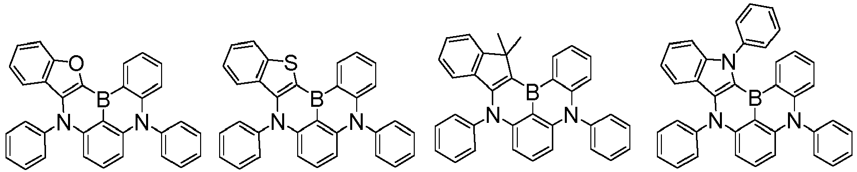

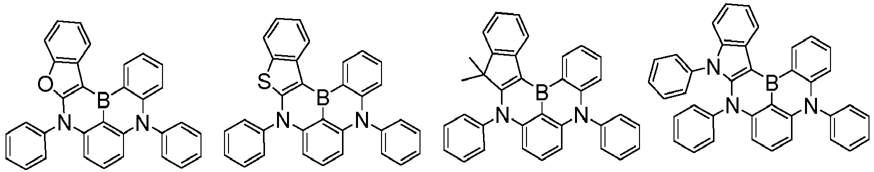

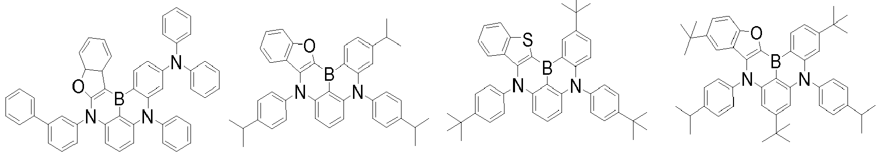

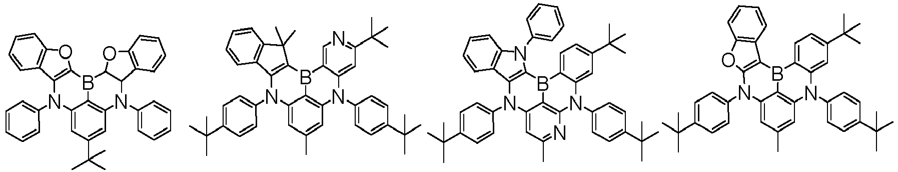

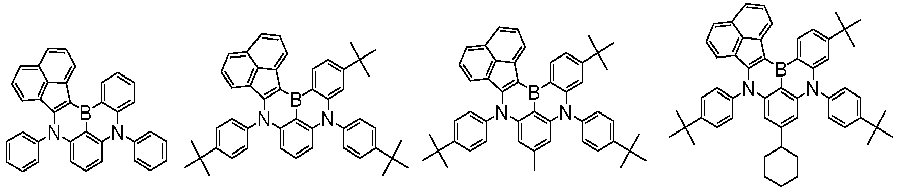

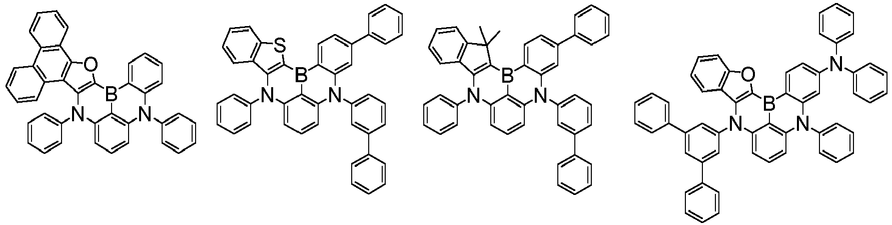

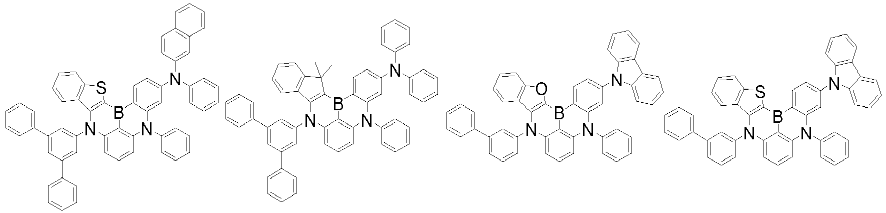

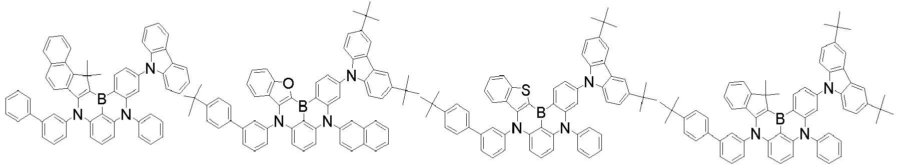

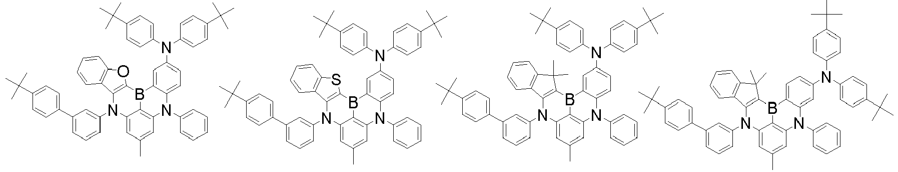

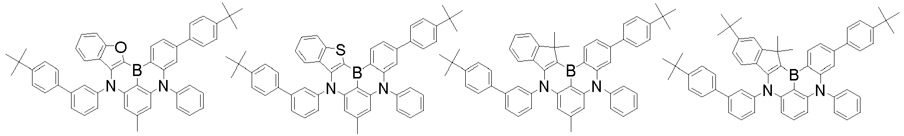

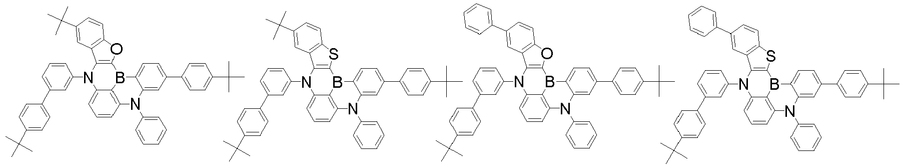

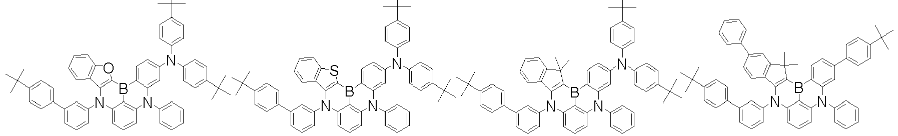

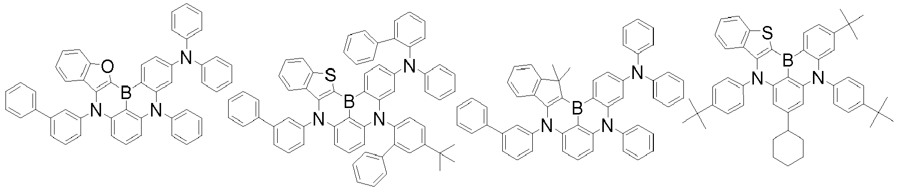

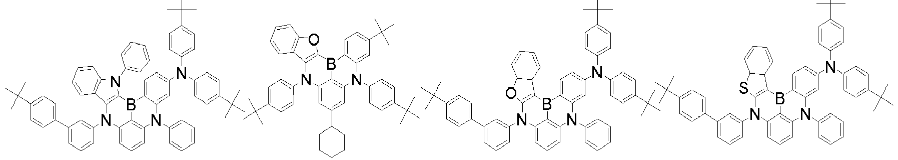

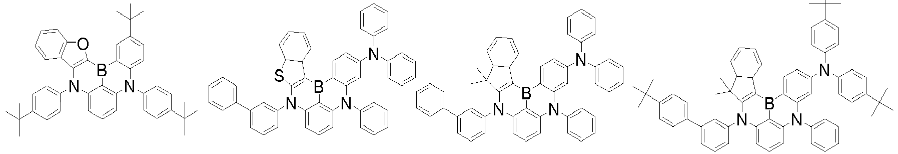

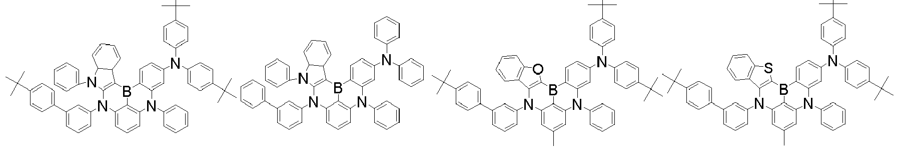

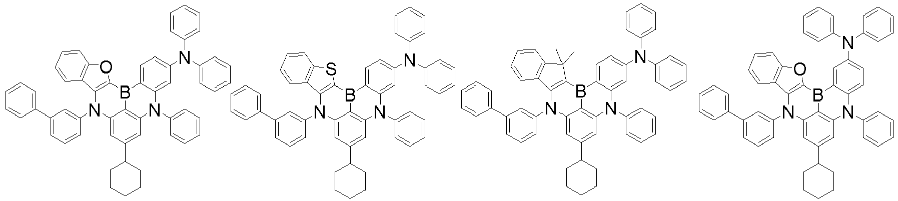

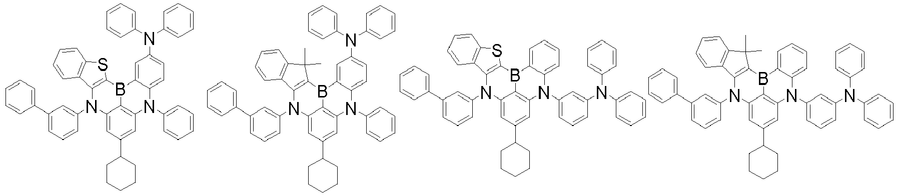

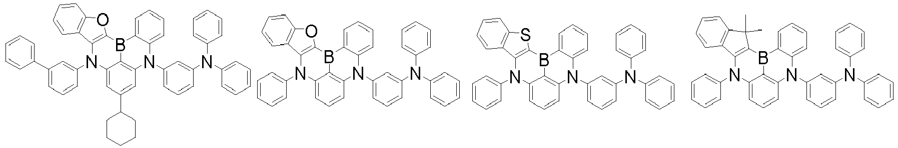

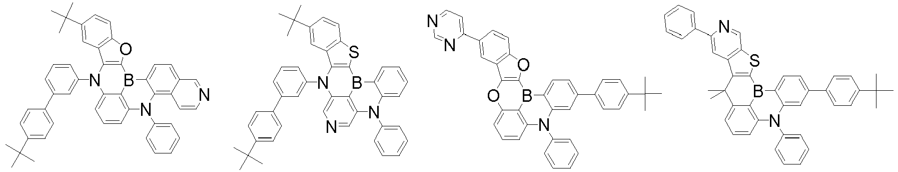

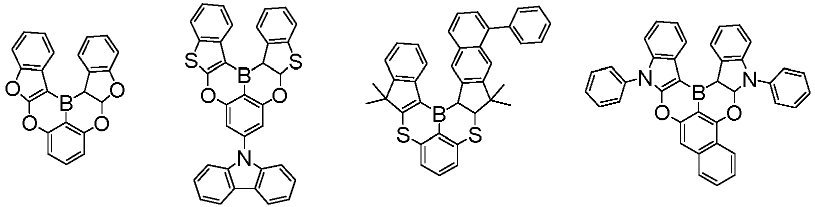

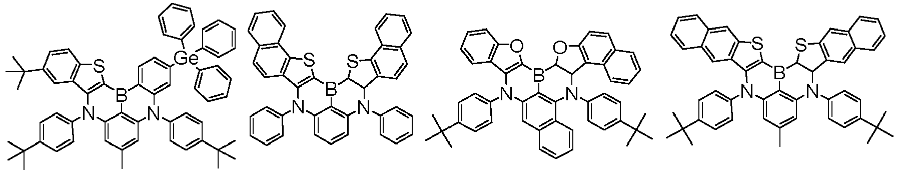

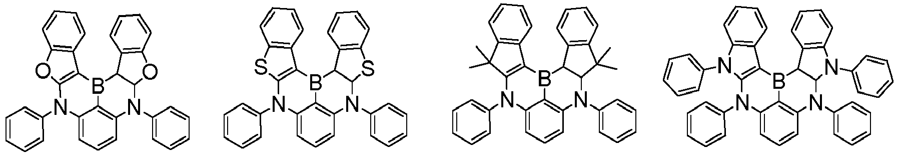

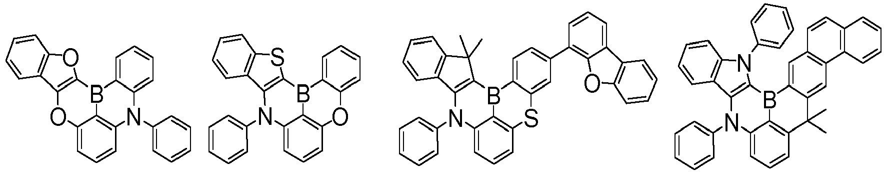

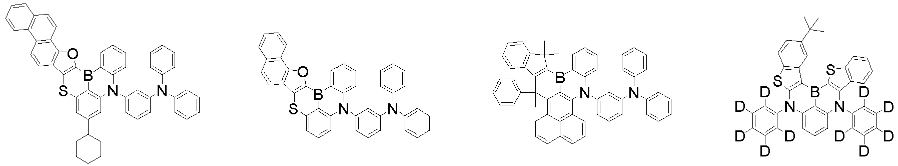

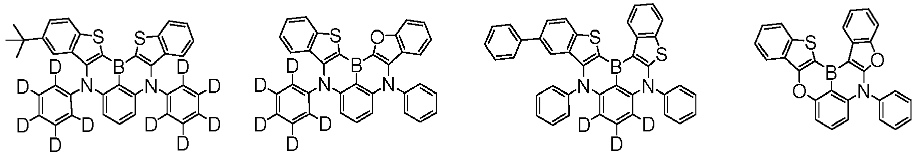

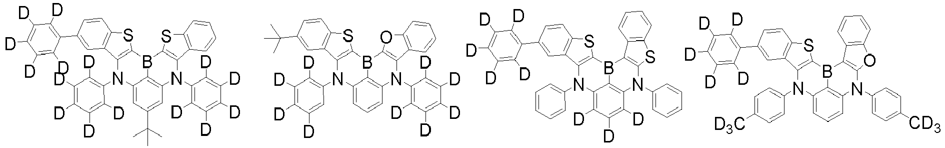

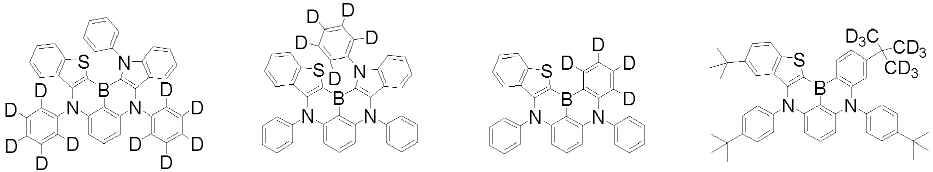

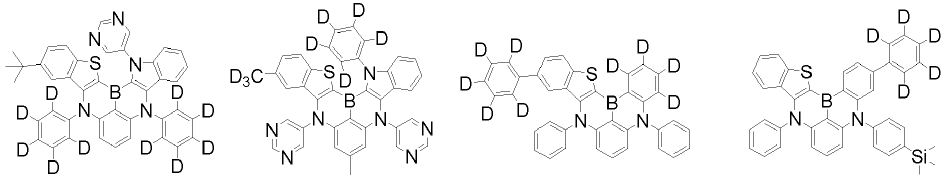

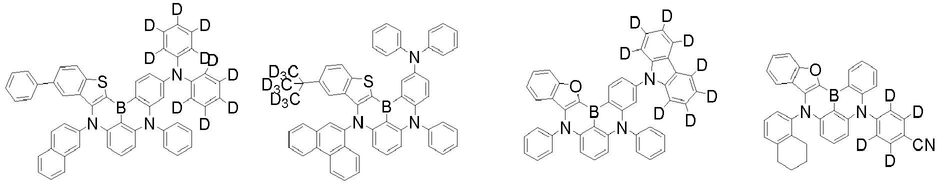

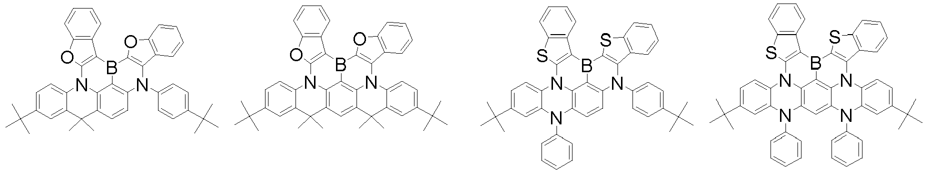

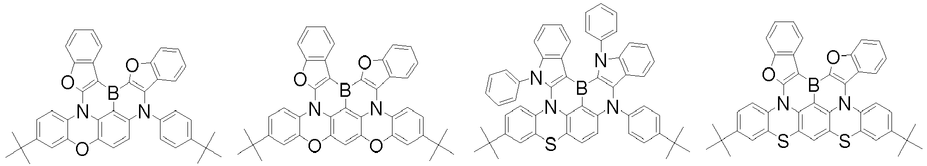

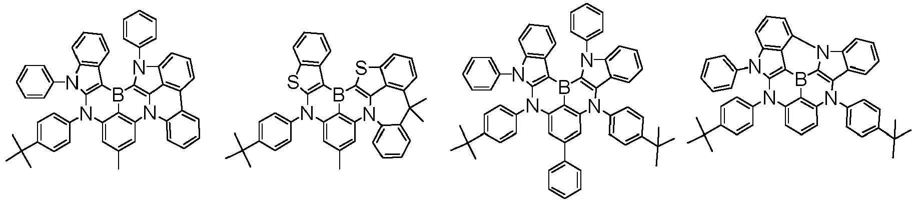

In addition, according to an embodiment of the present disclosure, examples of the compounds represented by Chemical Formulas D-7 to D-9 include, but are not limited to, the following compounds:

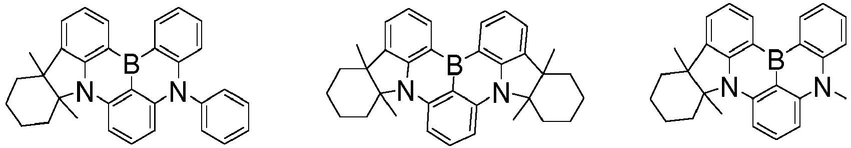

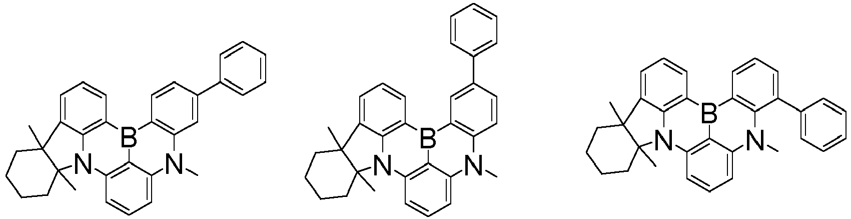

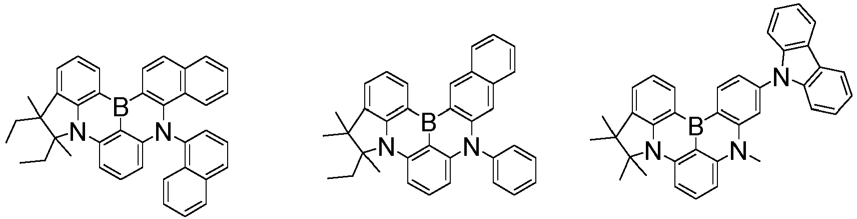

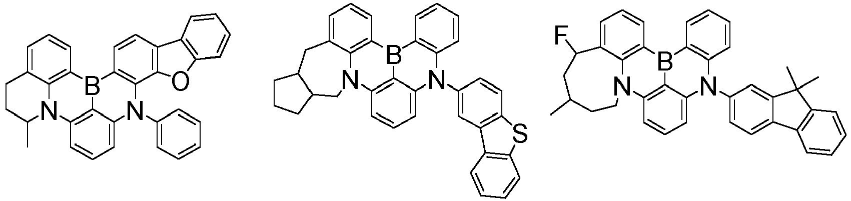

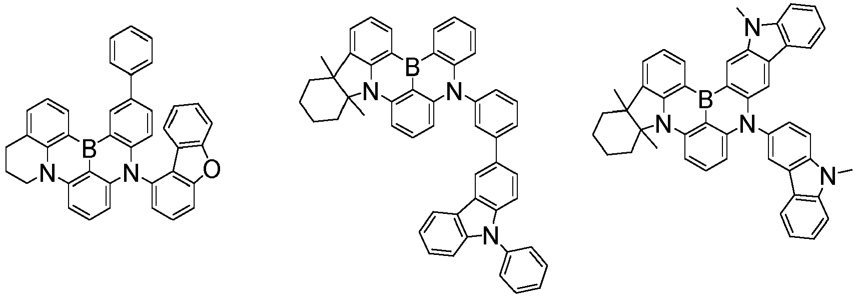

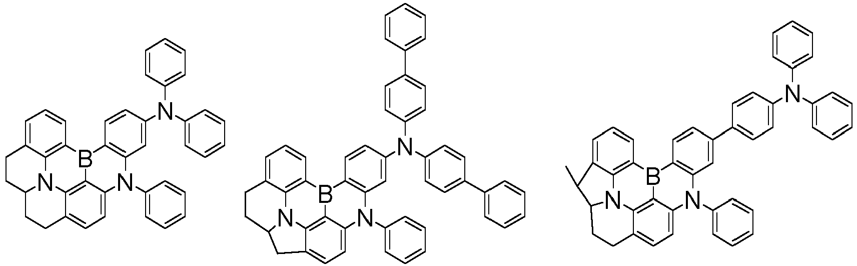

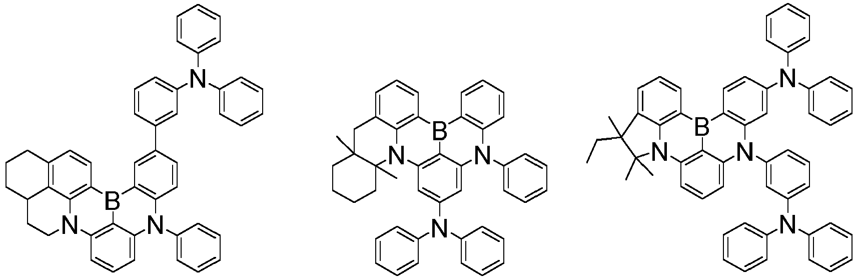

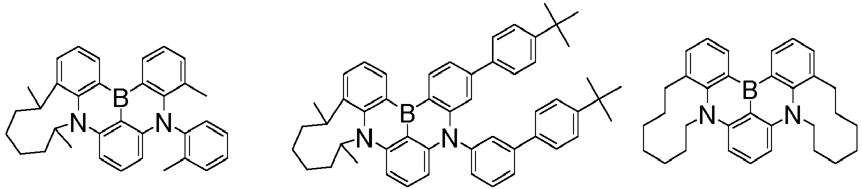

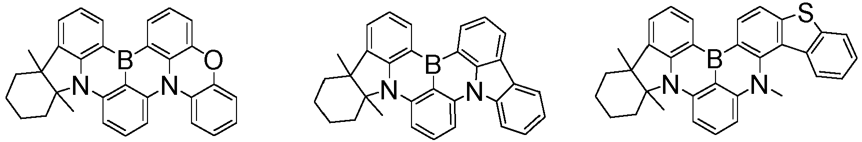

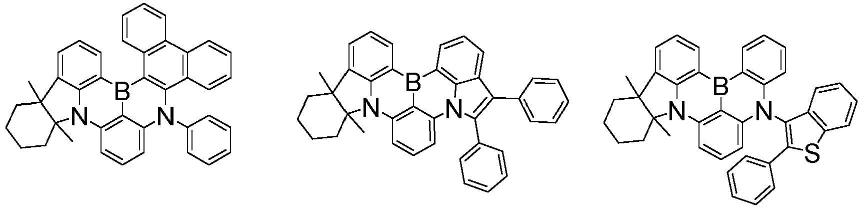

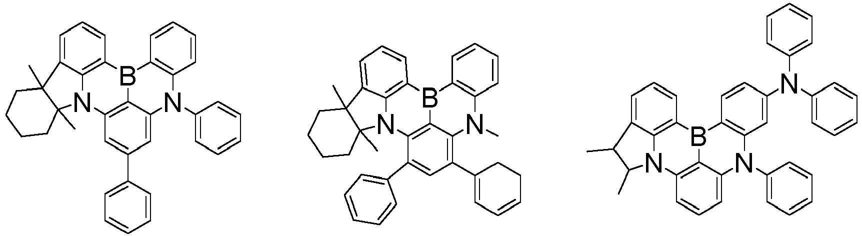

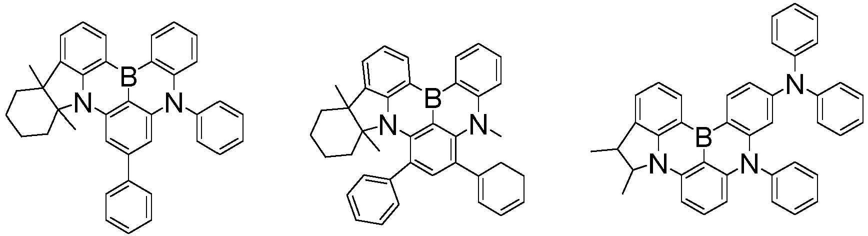

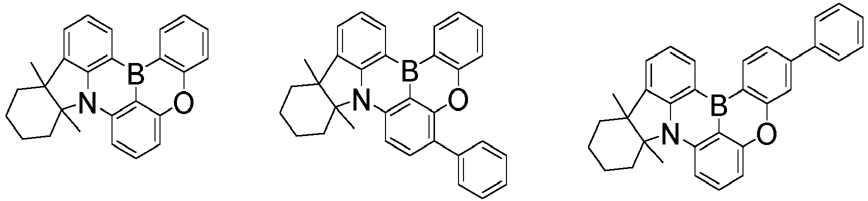

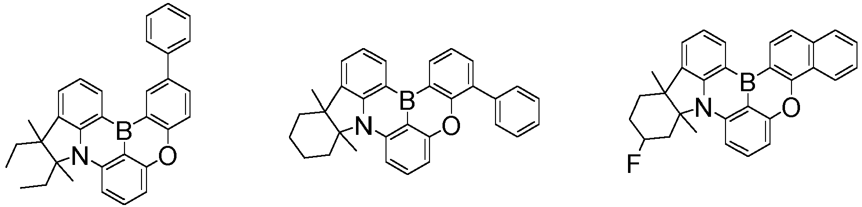

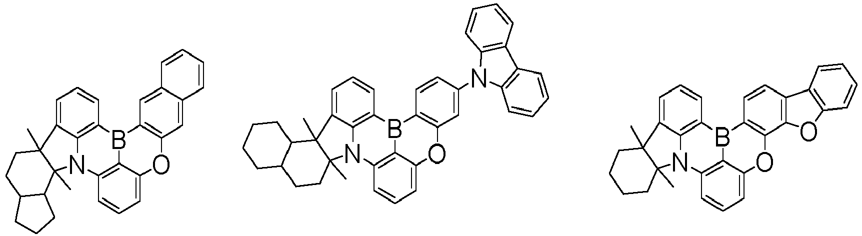

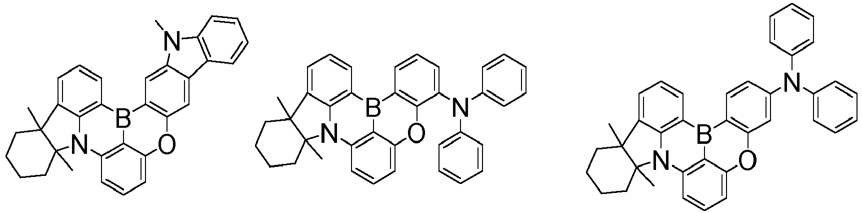

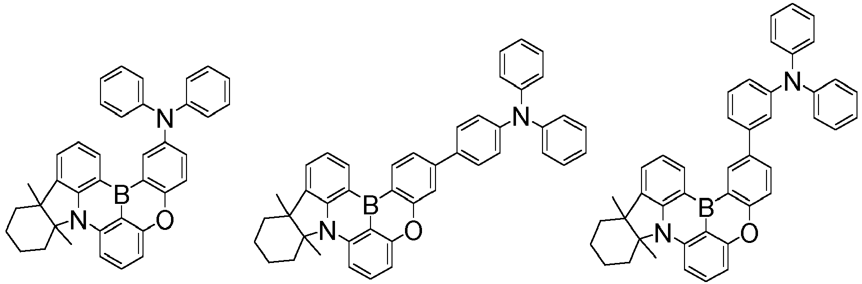

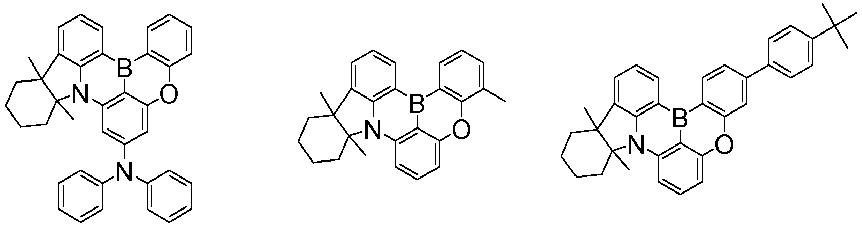

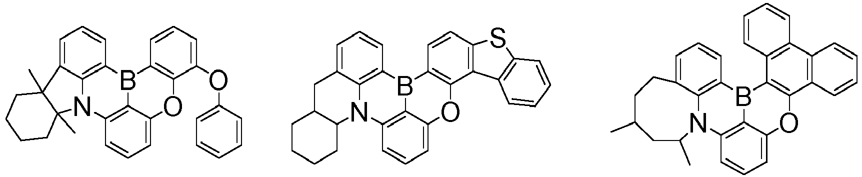

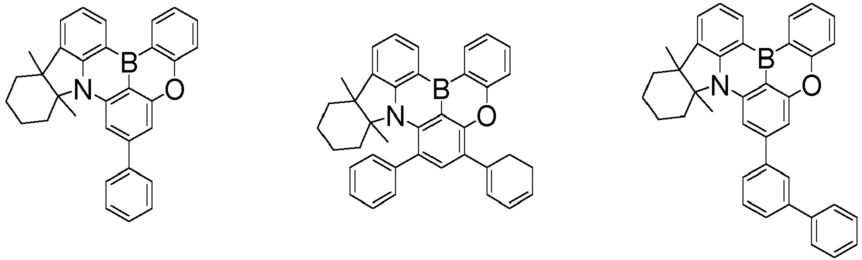

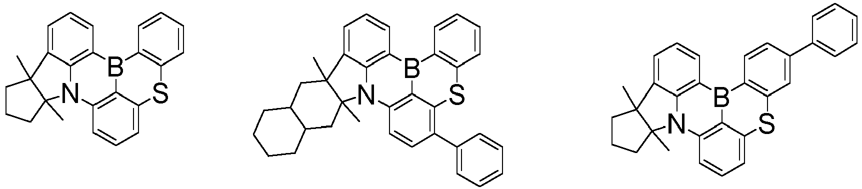

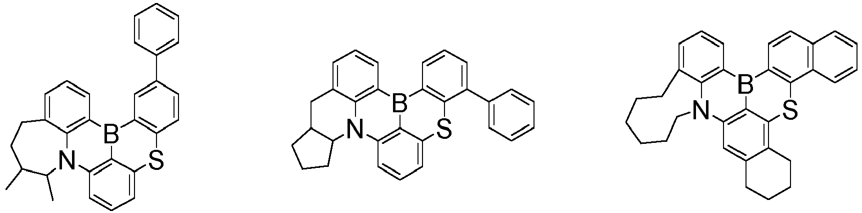

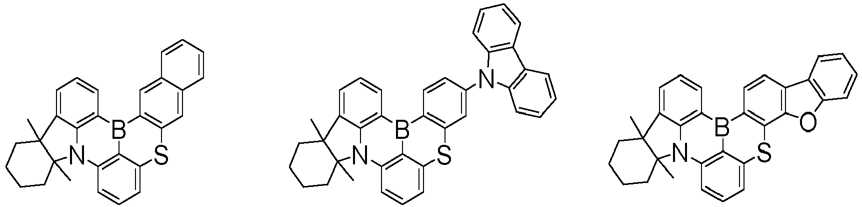

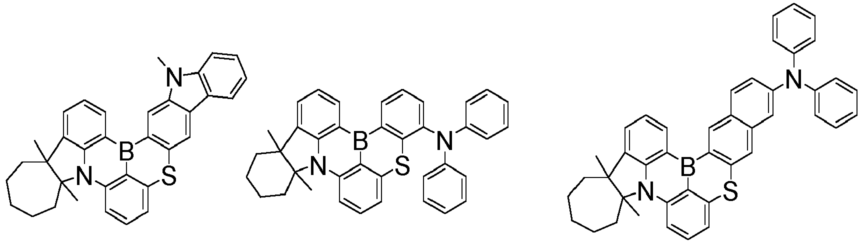

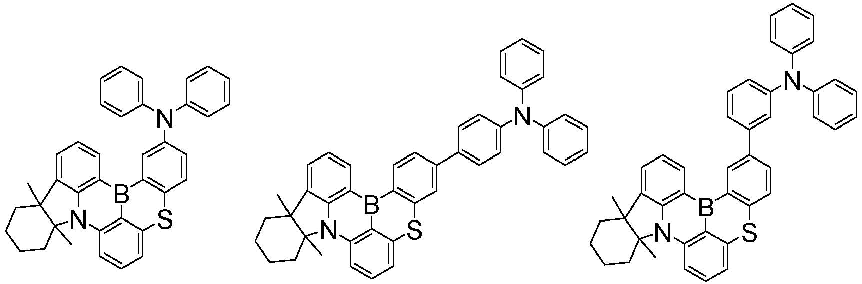

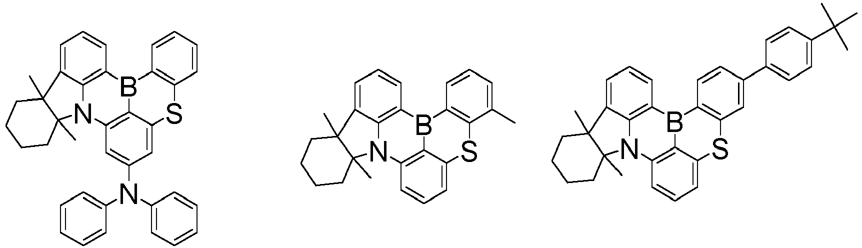

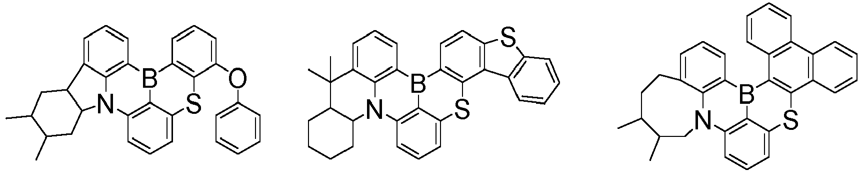

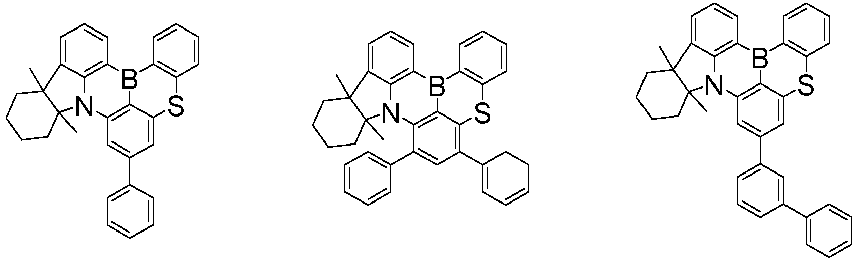

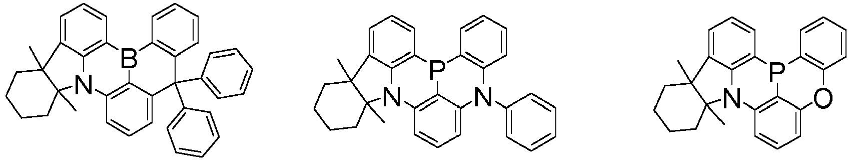

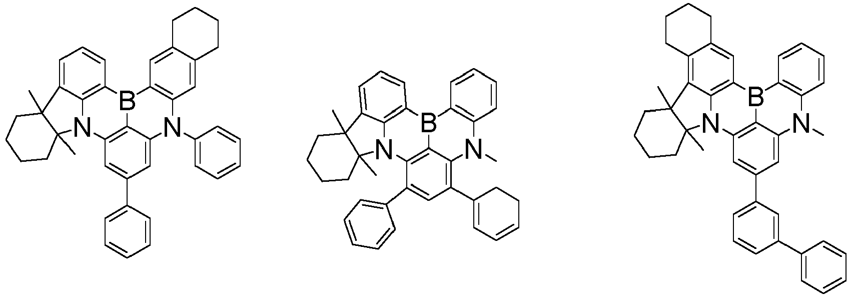

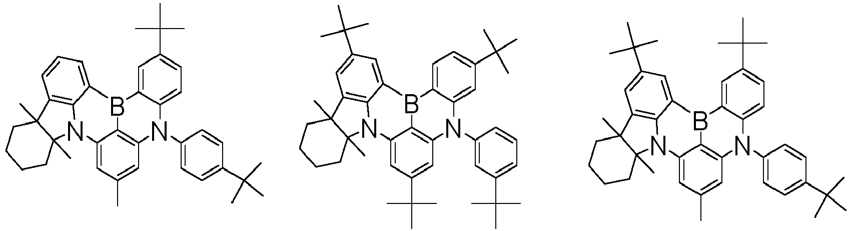

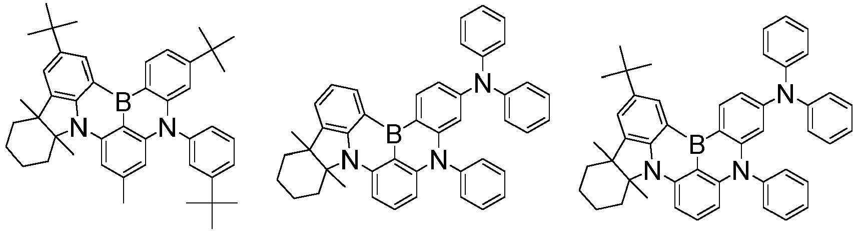

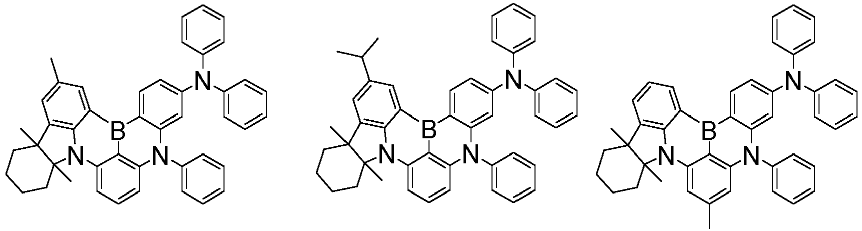

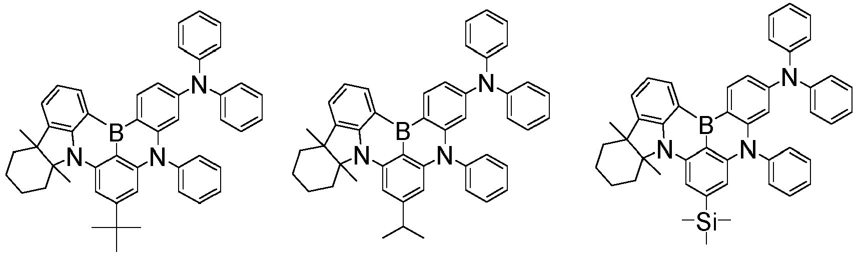

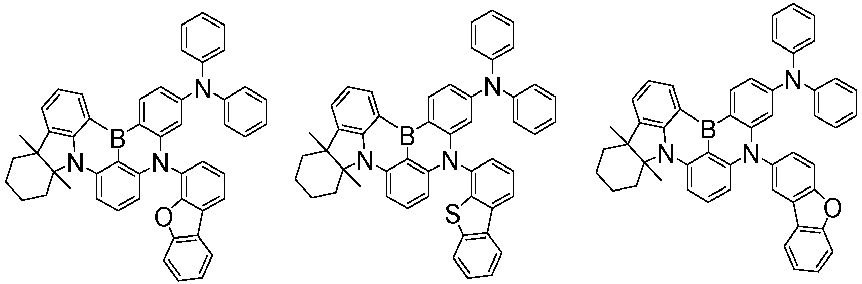

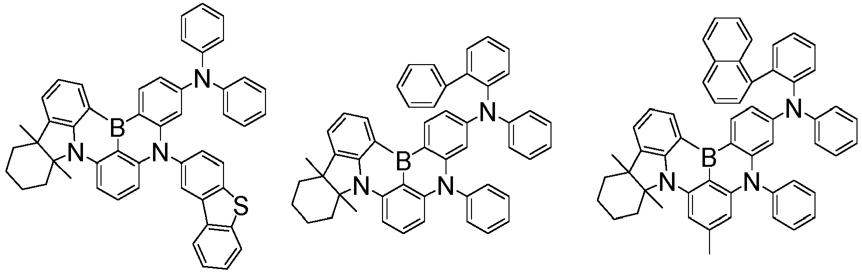

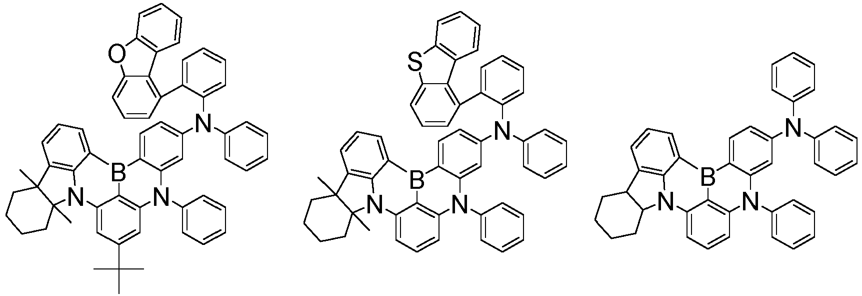

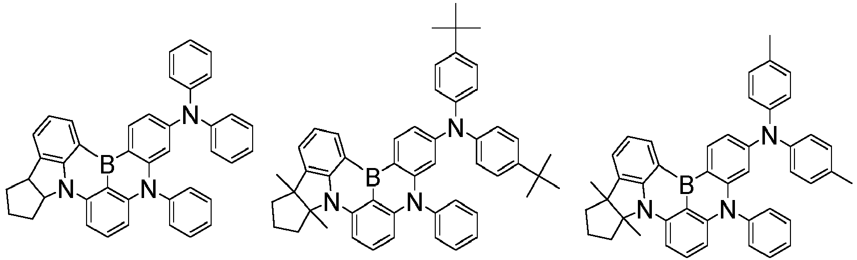

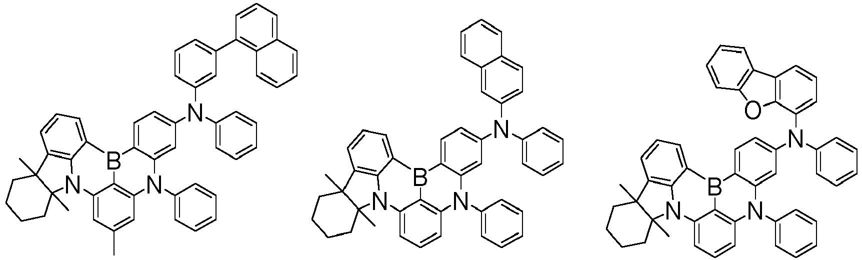

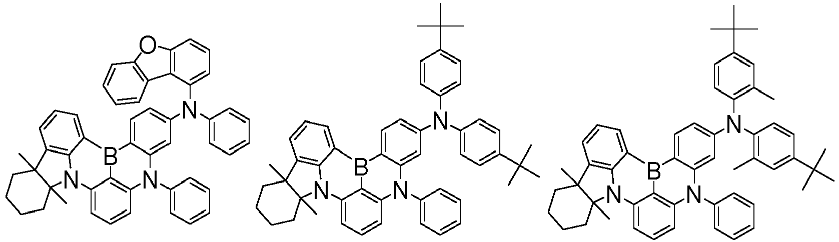

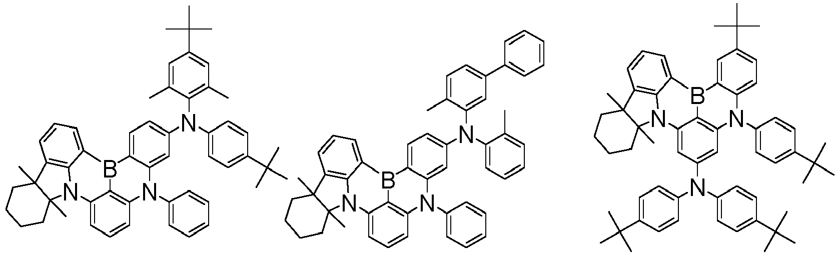

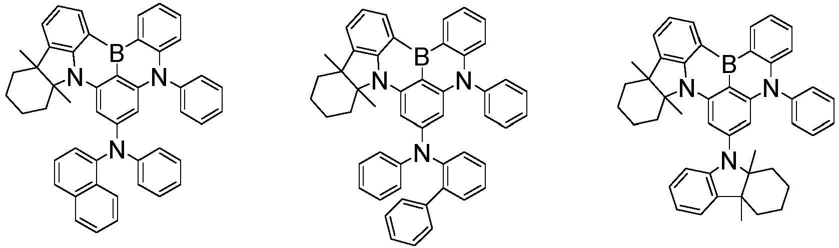

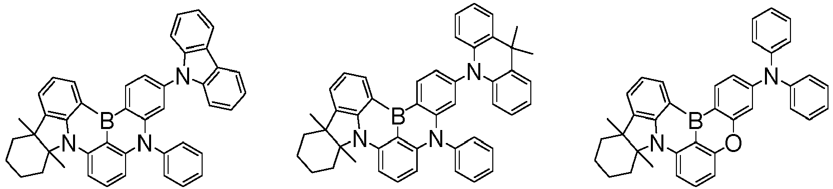

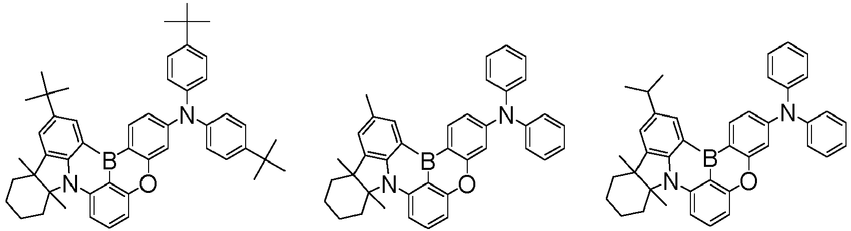

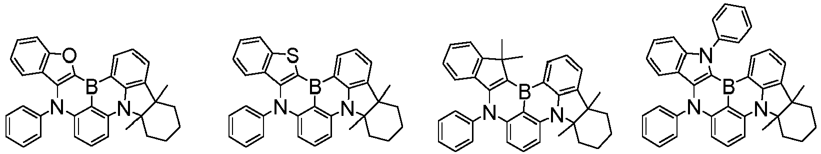

In an embodiment of the present disclosure, the compounds represented by Chemical Formulas D-10 to D-11 include, but are not limited to, the following compounds:

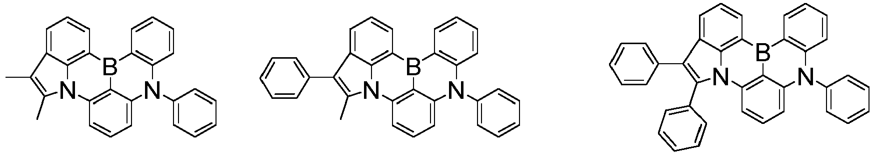

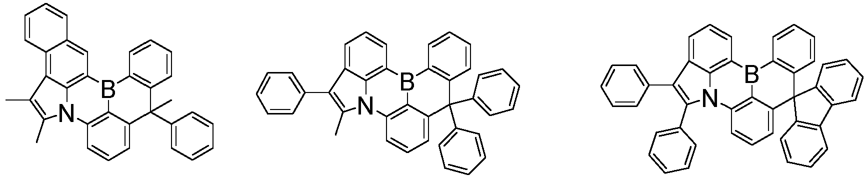

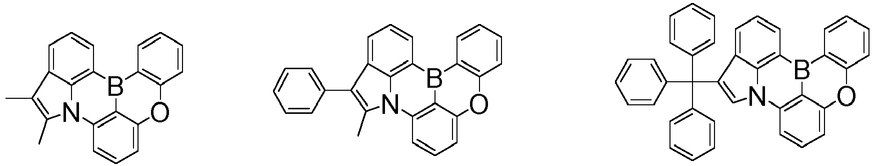

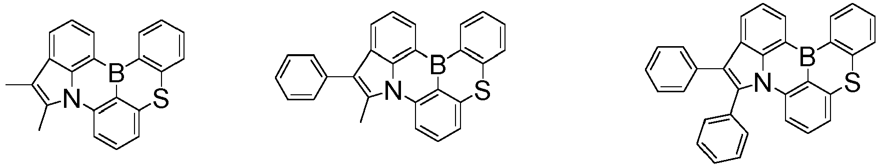

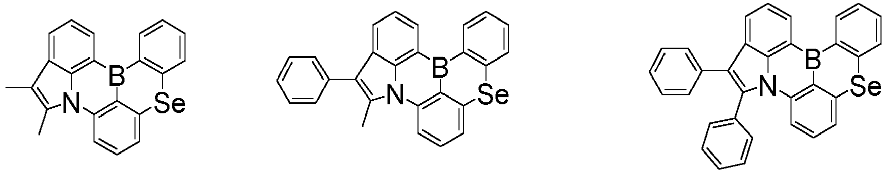

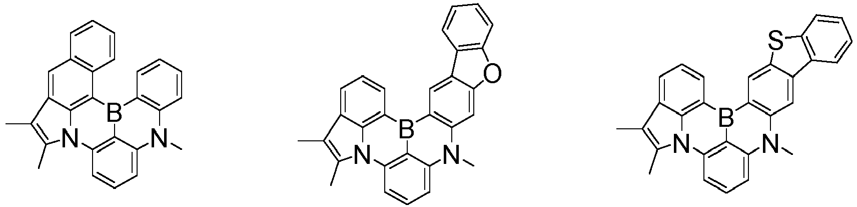

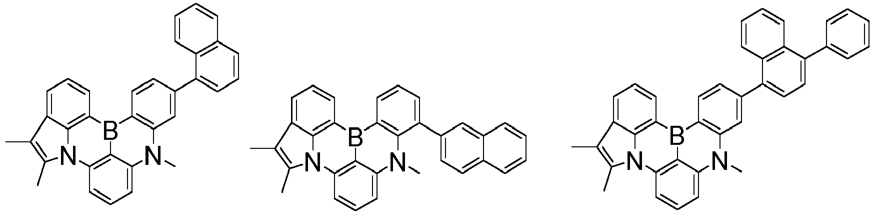

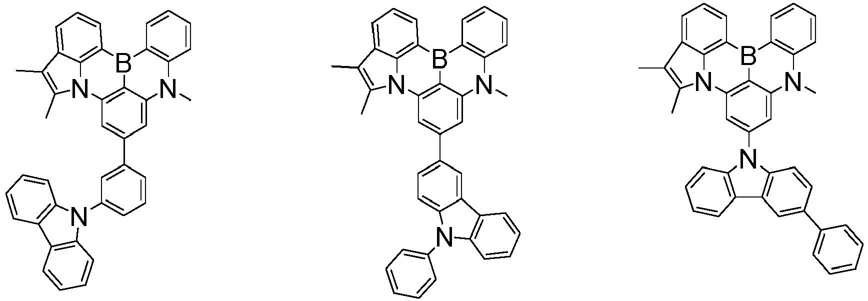

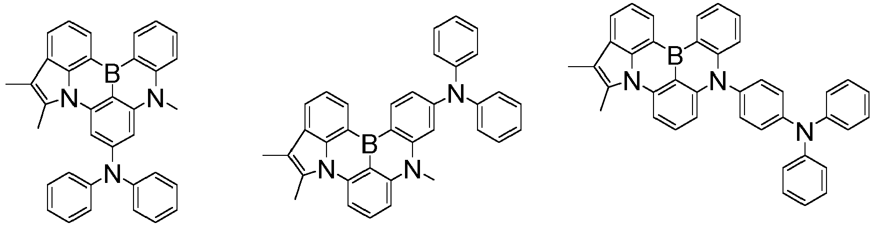

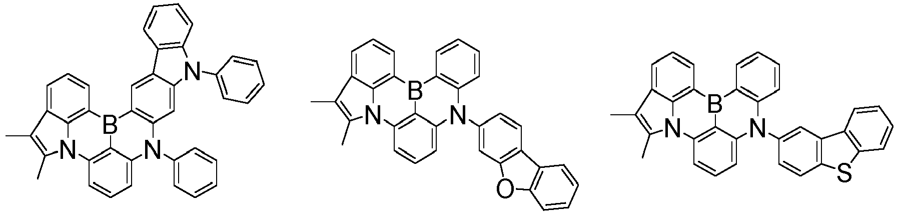

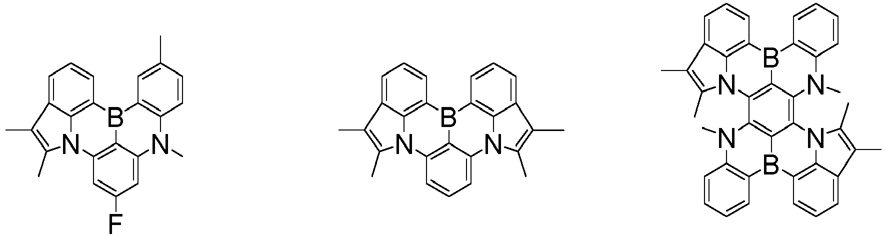

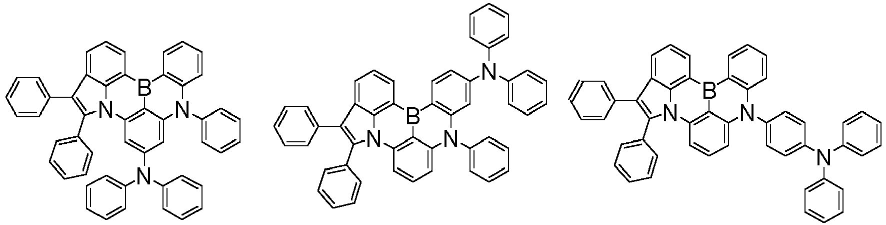

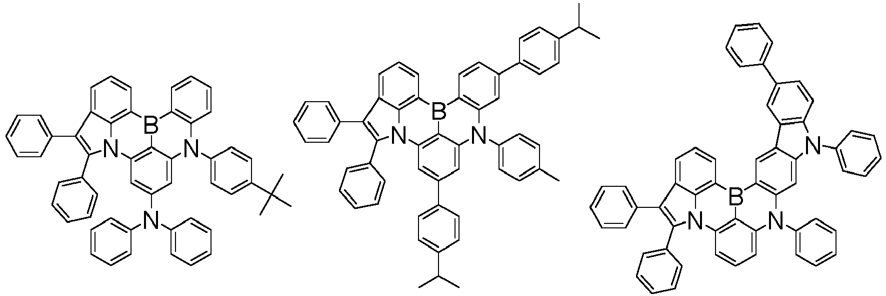

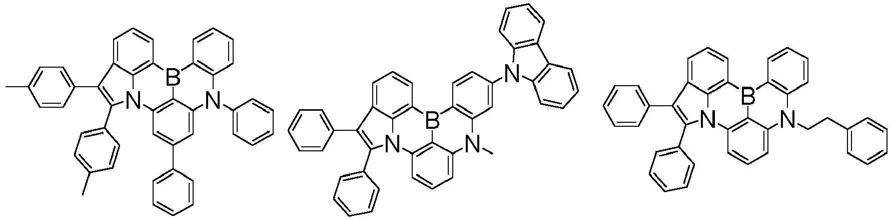

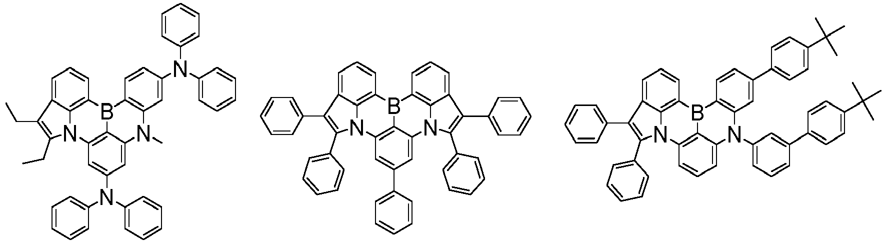

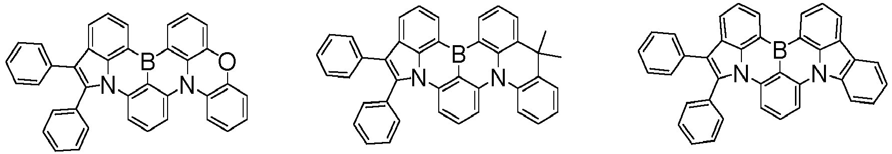

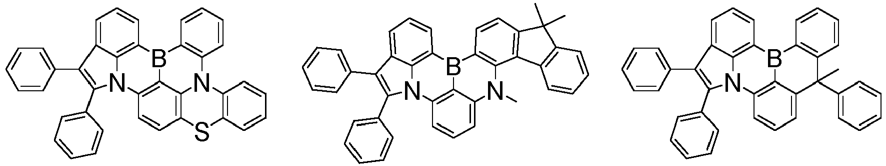

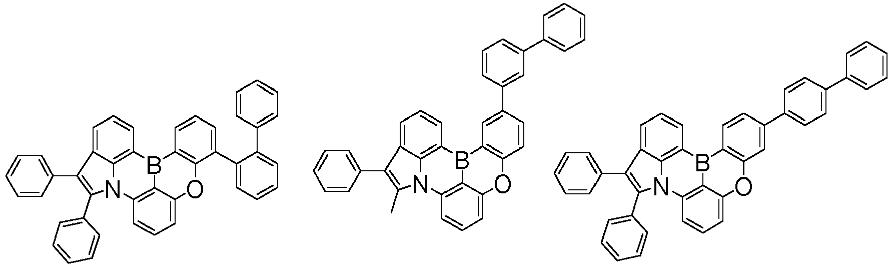

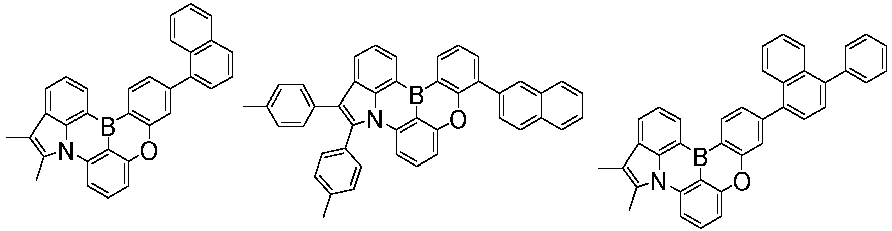

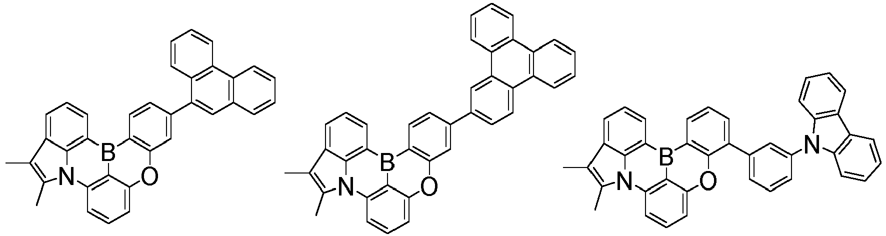

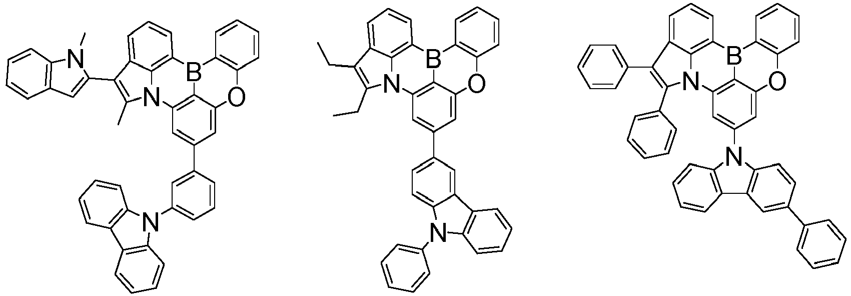

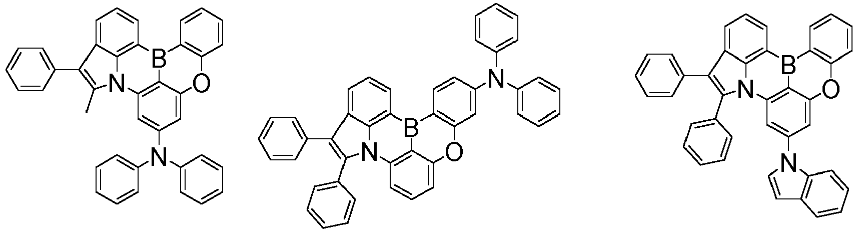

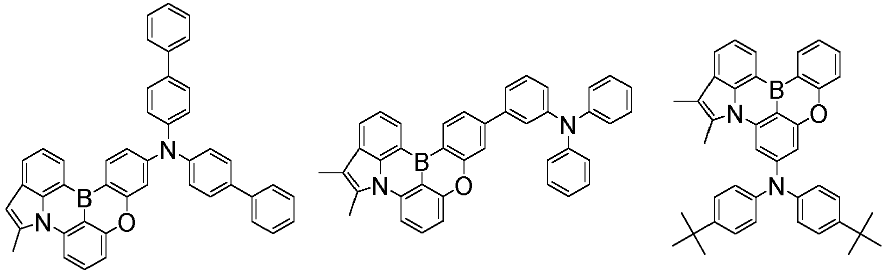

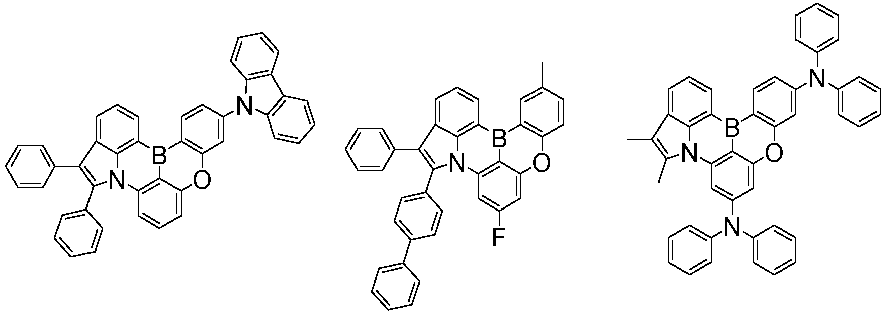

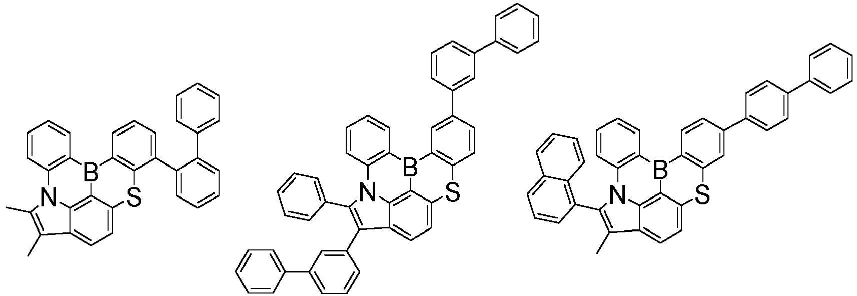

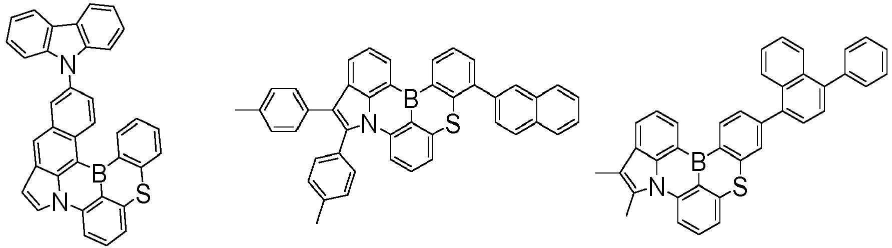

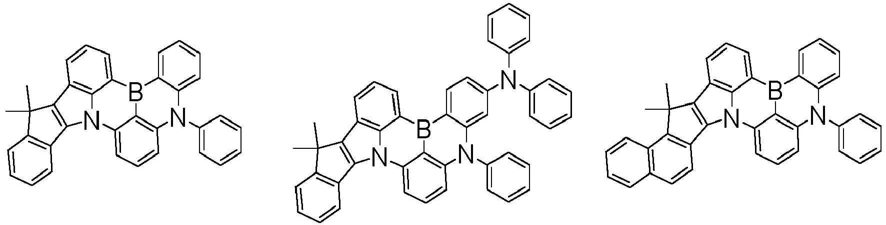

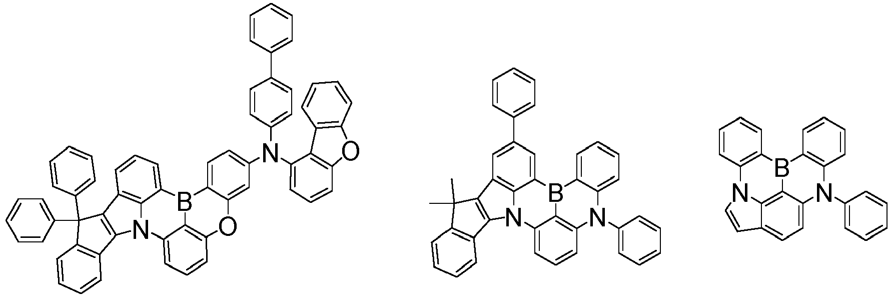

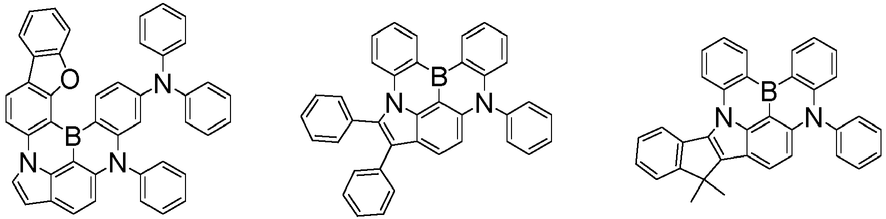

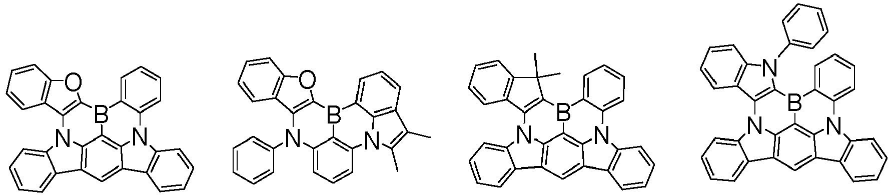

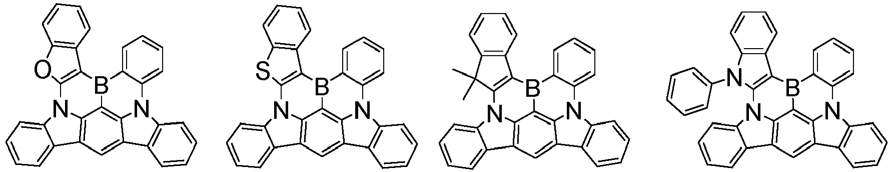

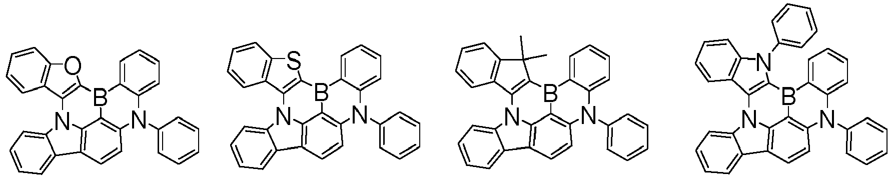

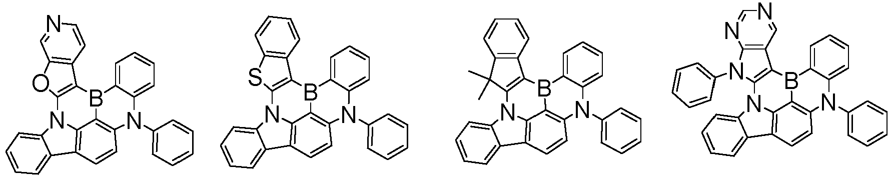

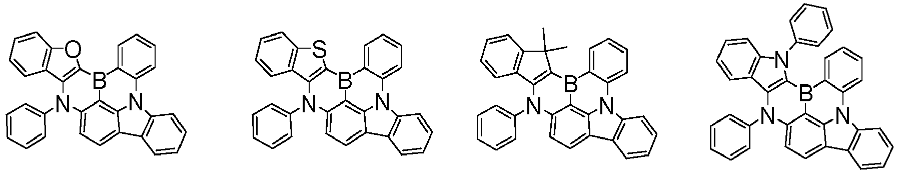

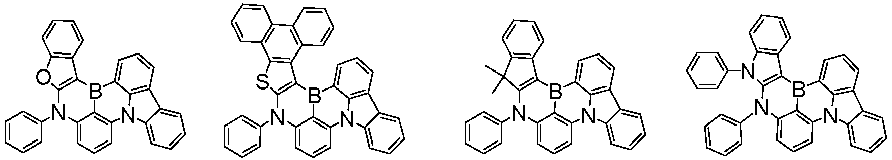

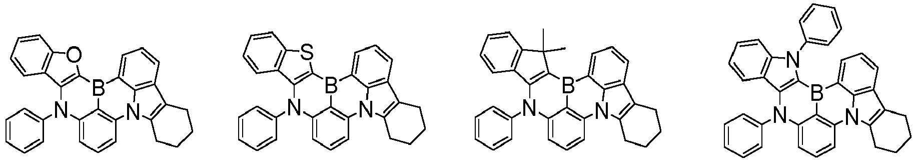

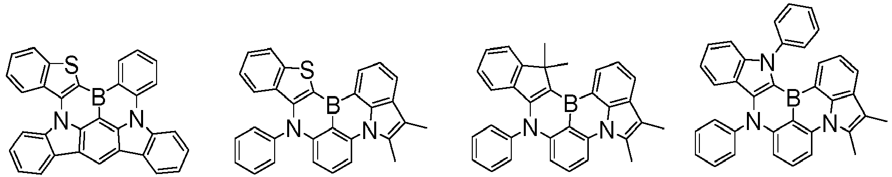

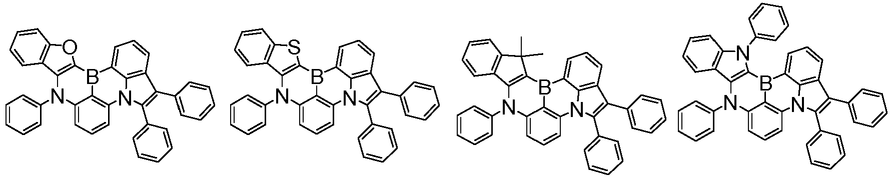

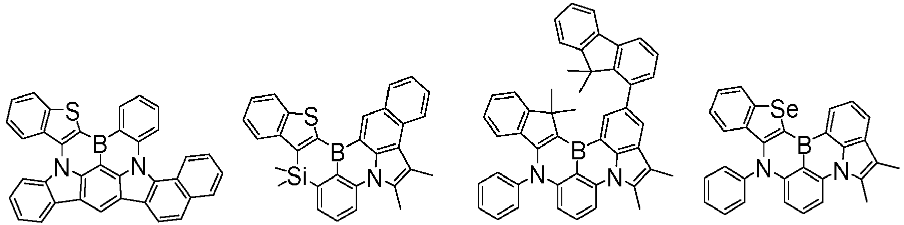

Among the dopant compounds according to the present disclosure, concrete examples of the compounds represented by Chemical Formulas D-2 and D-3 include, but are not limited to, the following compounds:

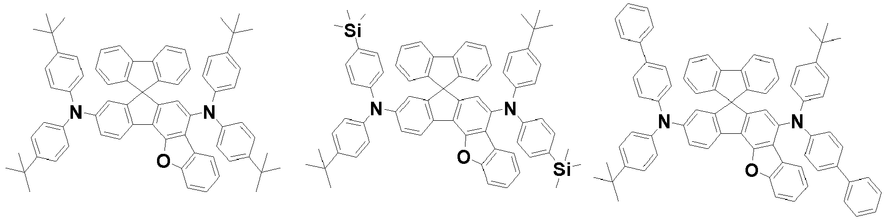

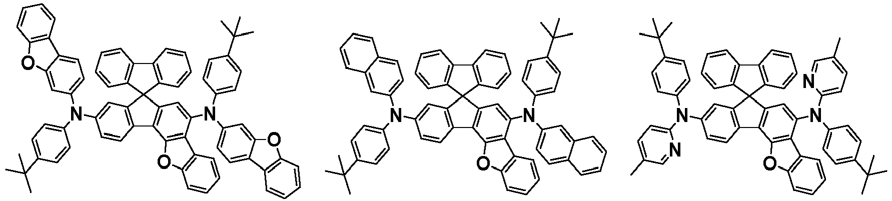

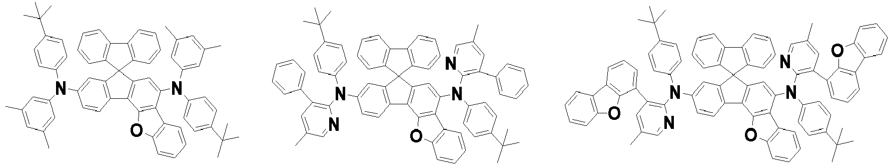

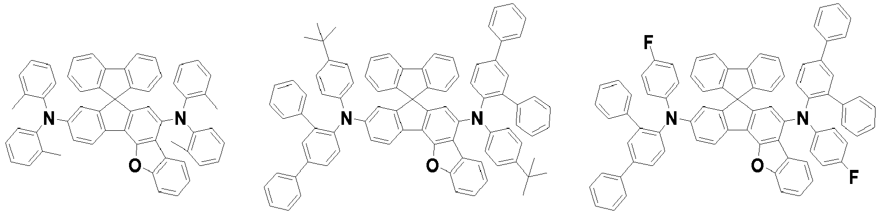

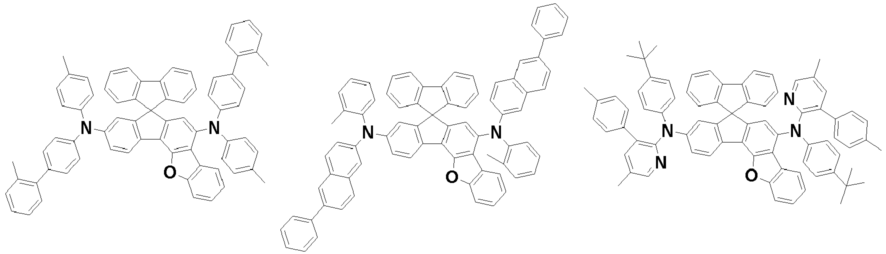

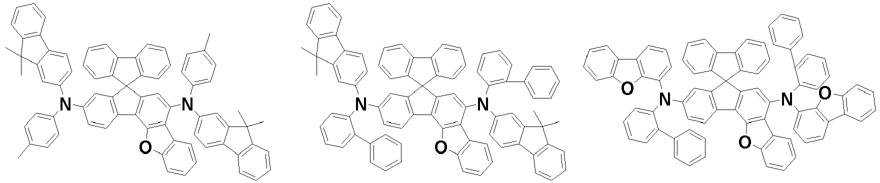

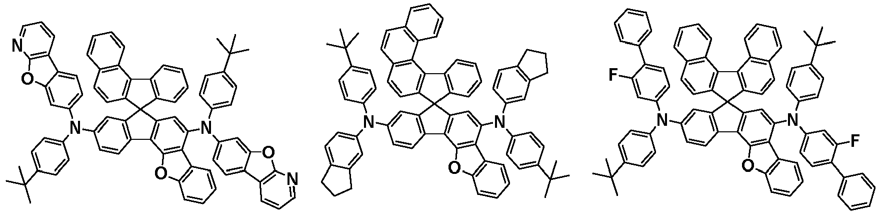

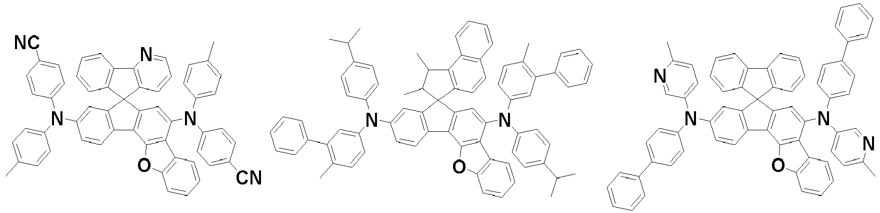

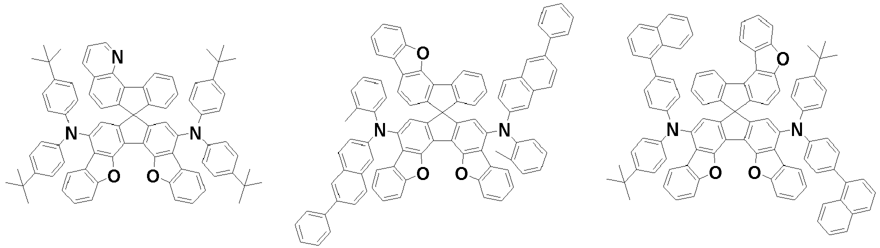

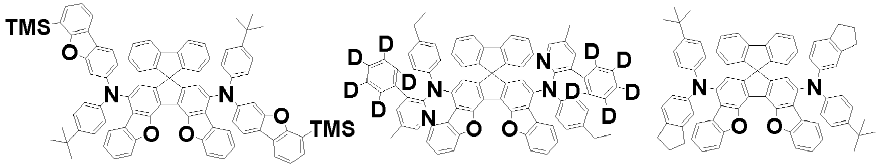

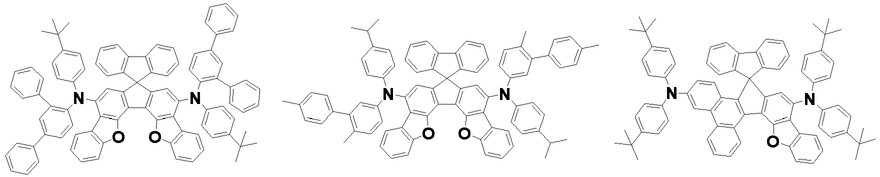

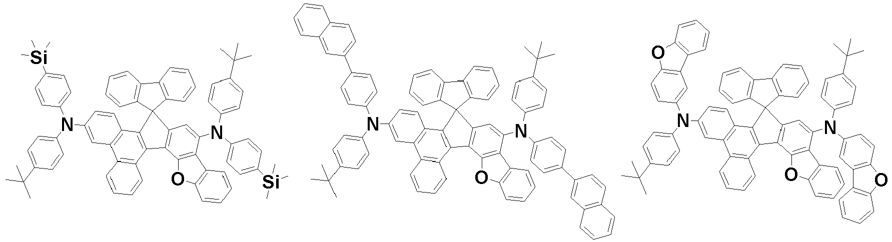

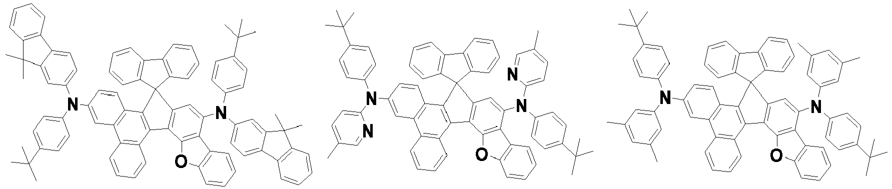

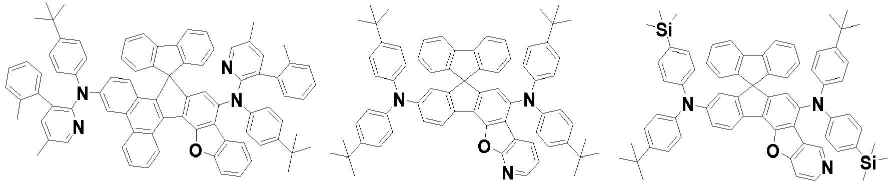

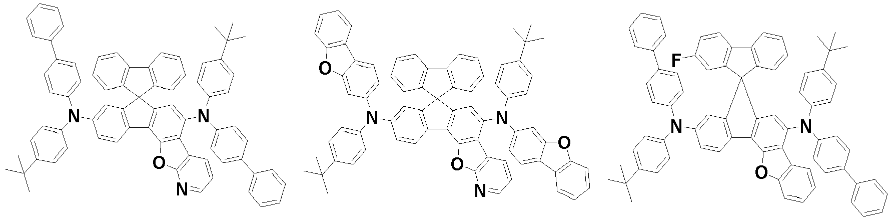

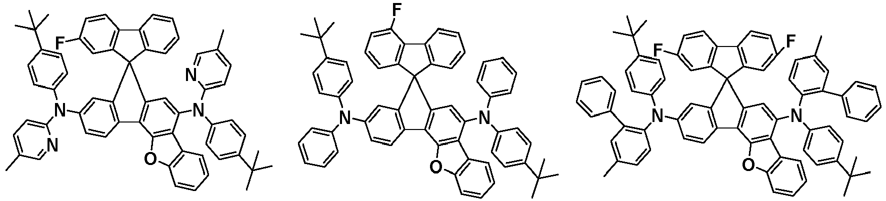

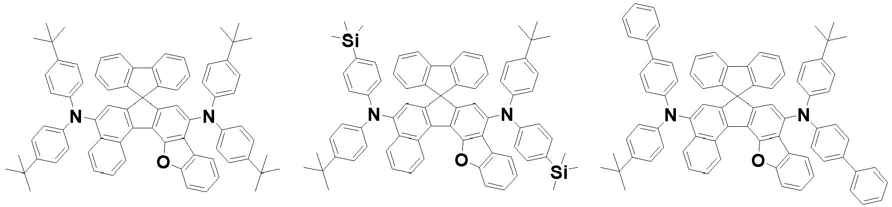

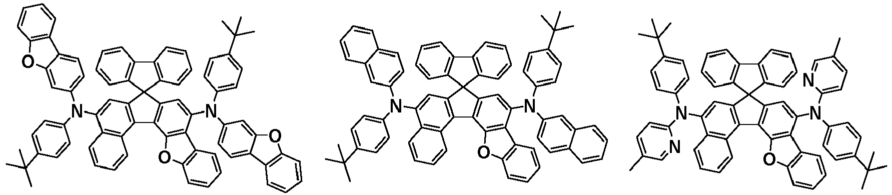

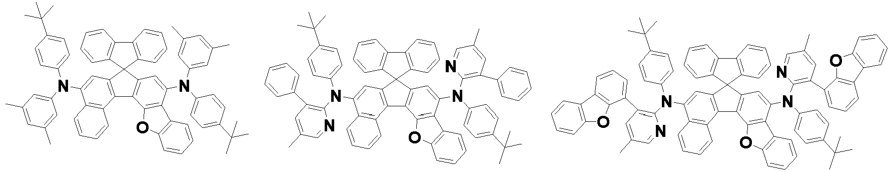

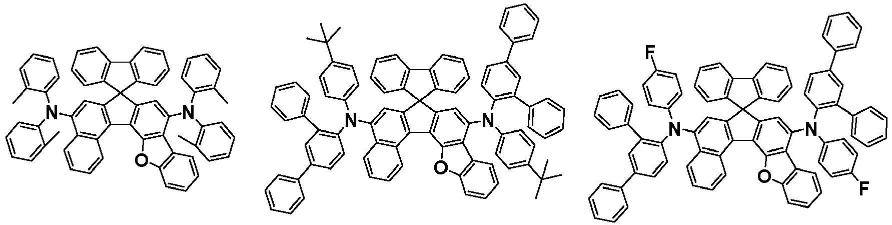

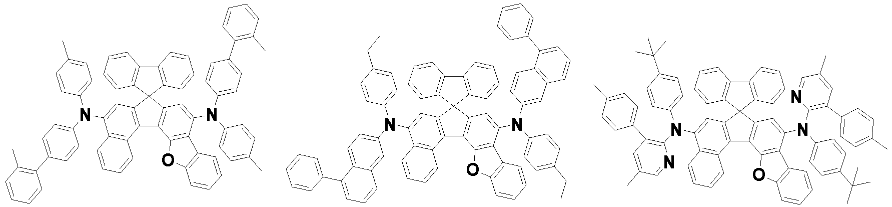

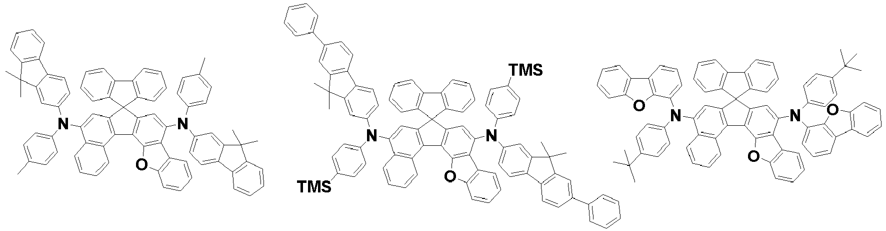

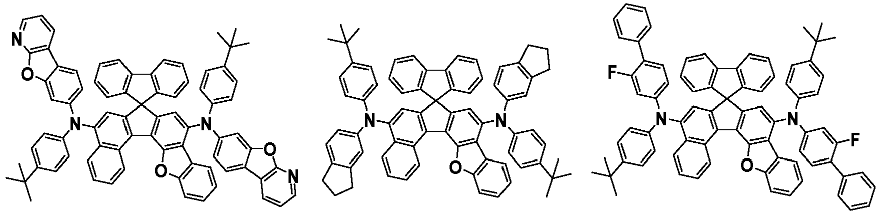

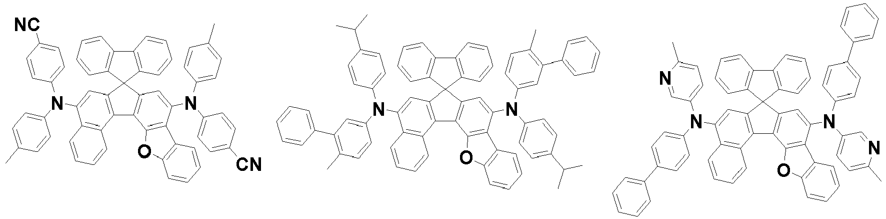

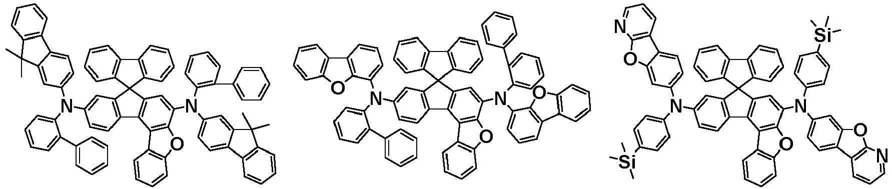

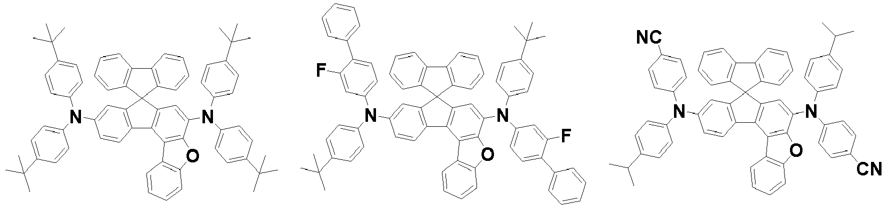

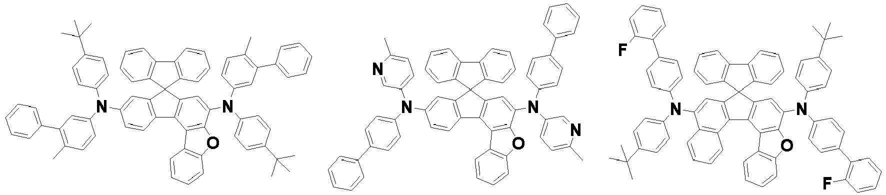

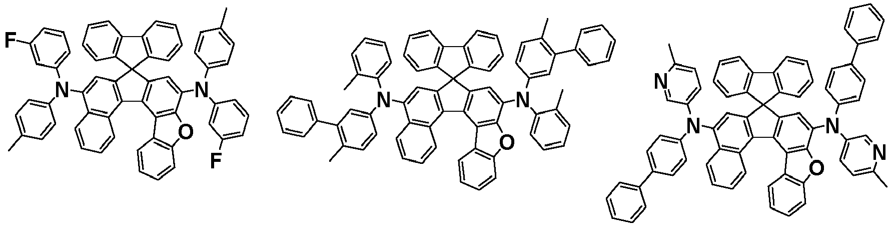

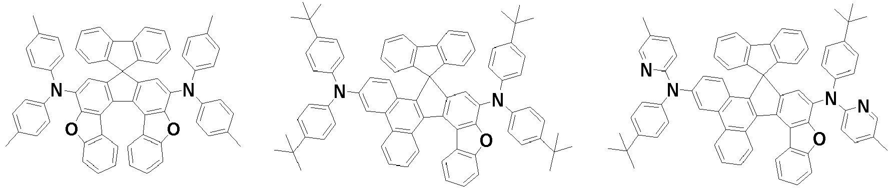

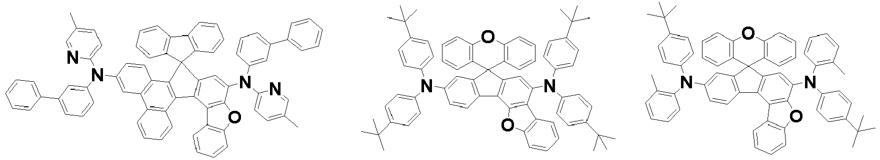

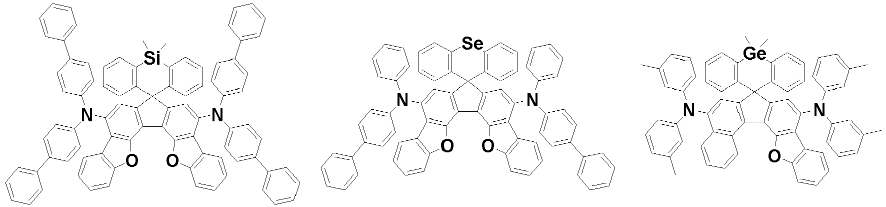

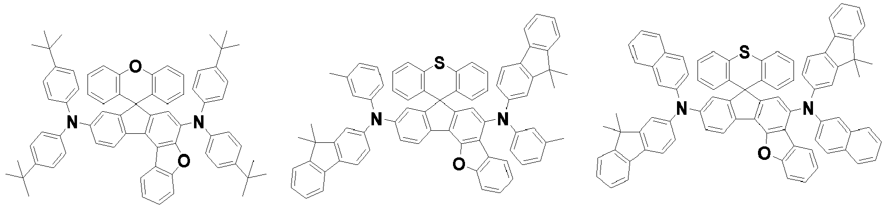

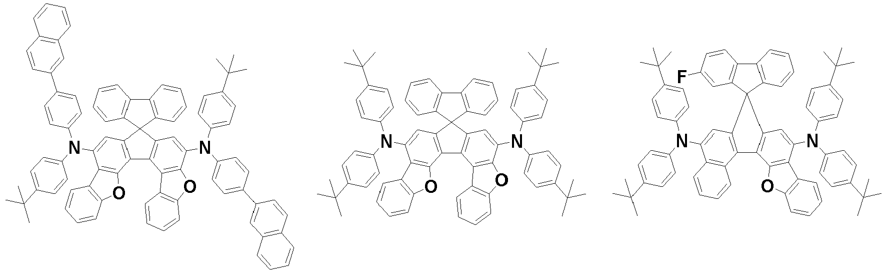

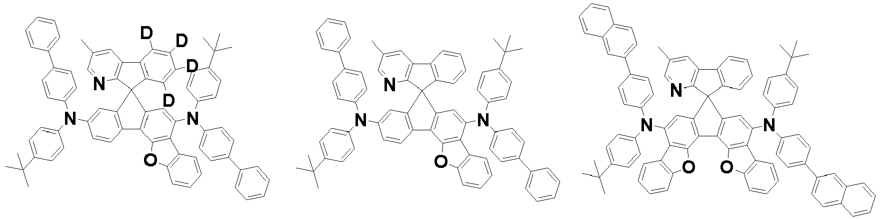

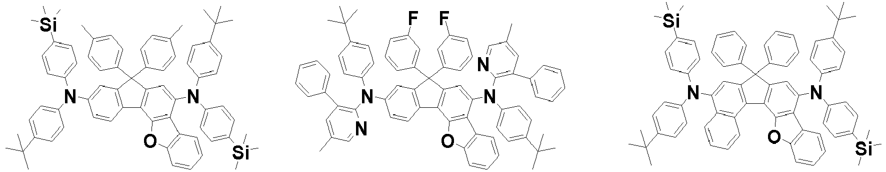

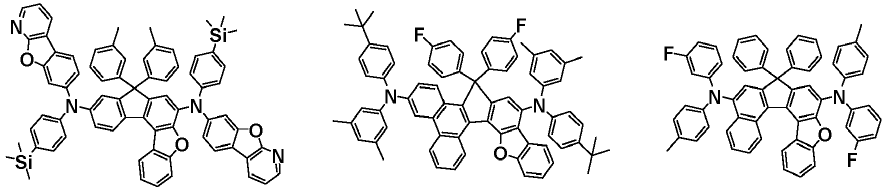

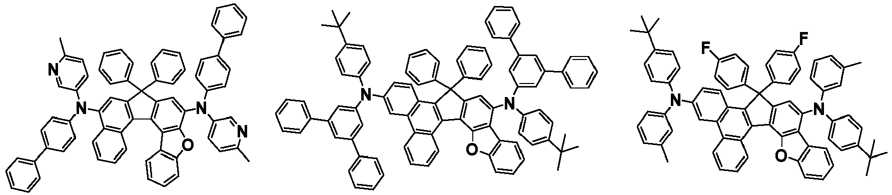

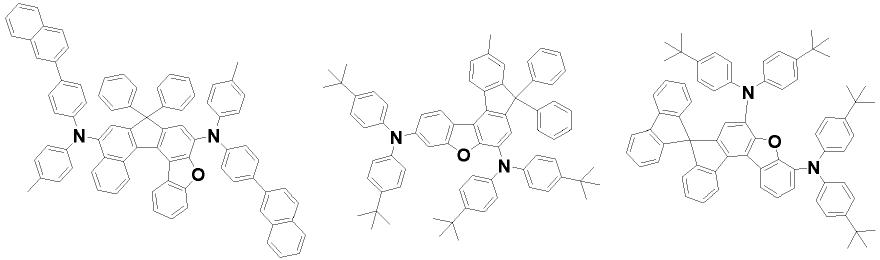

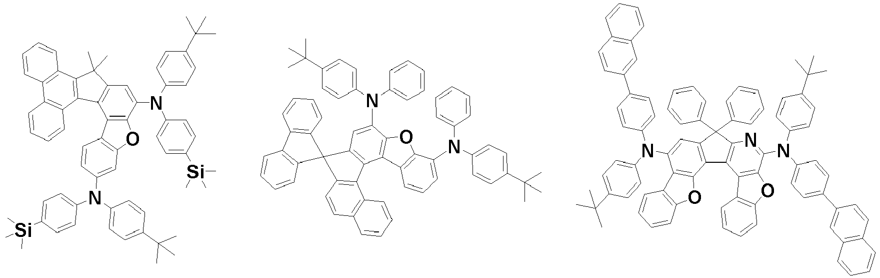

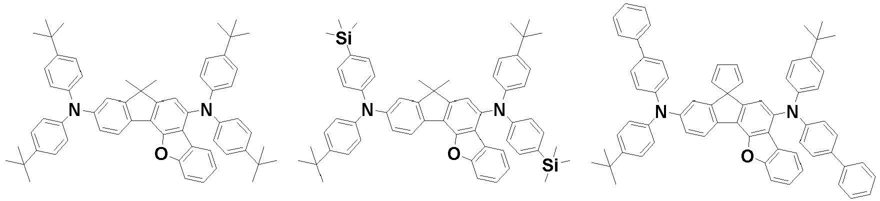

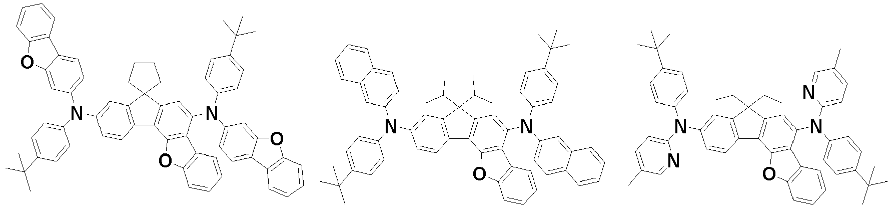

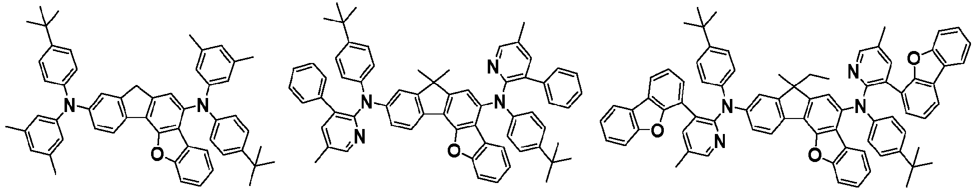

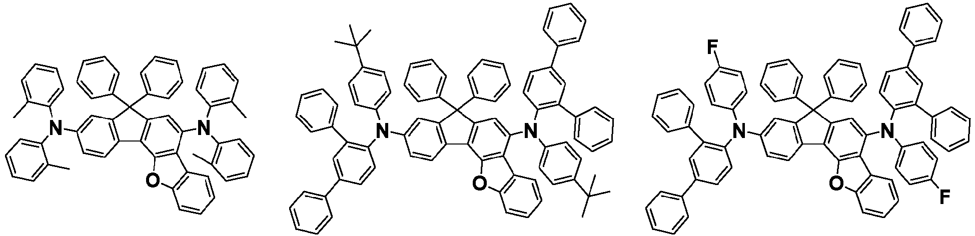

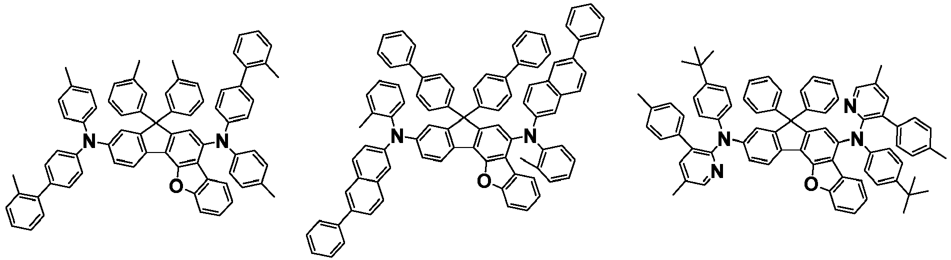

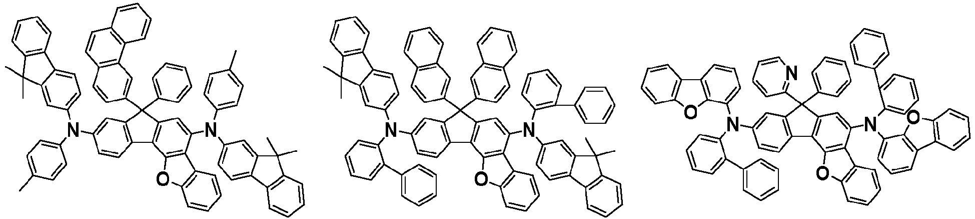

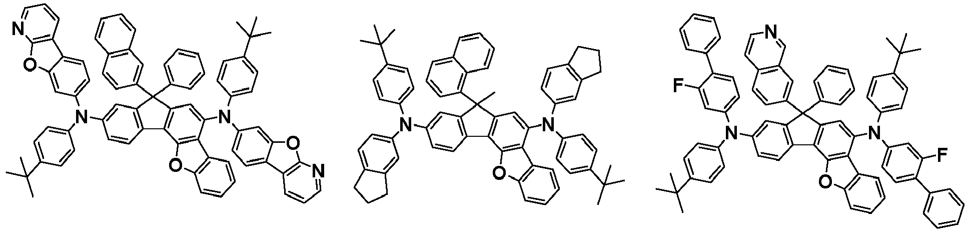

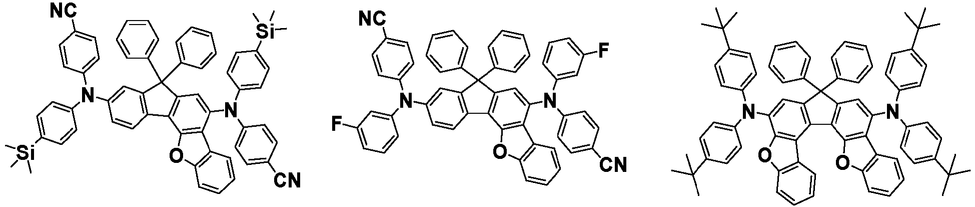

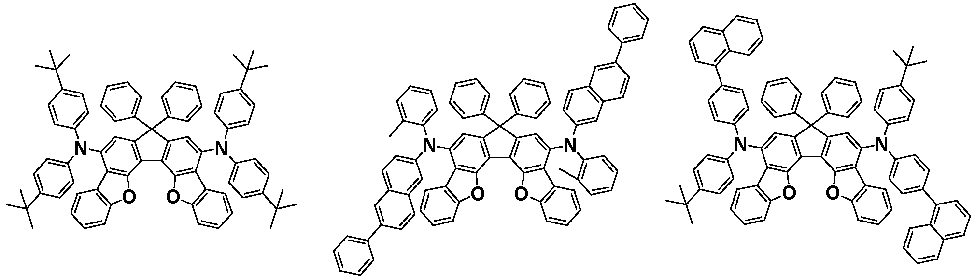

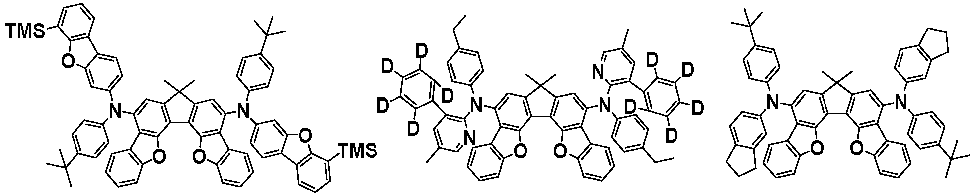

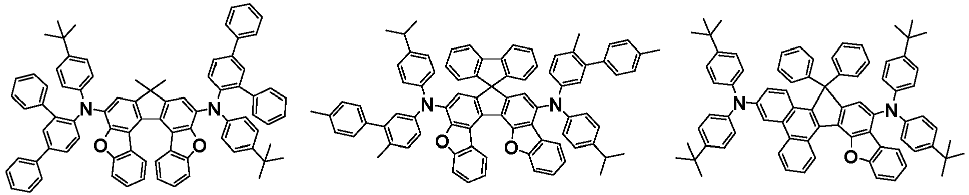

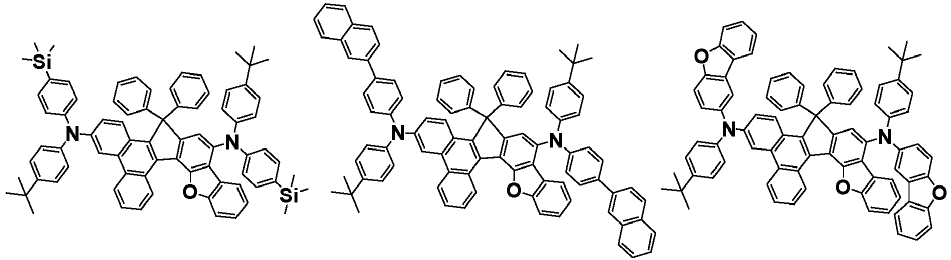

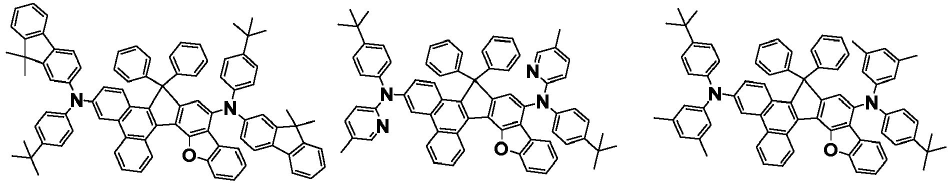

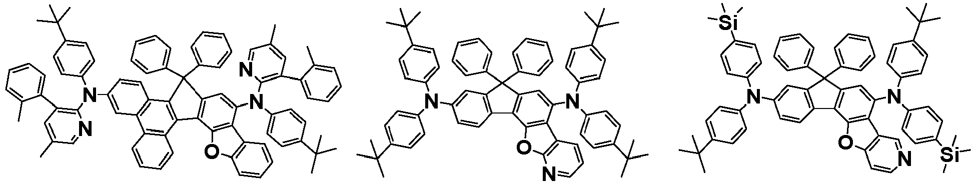

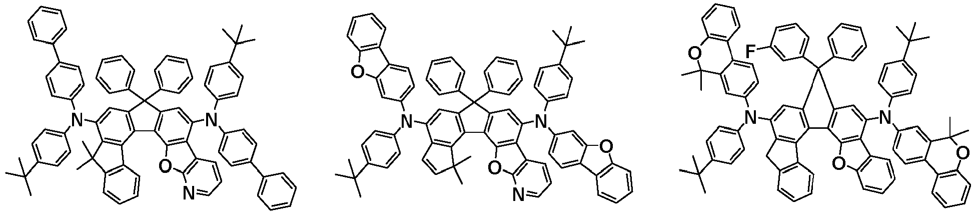

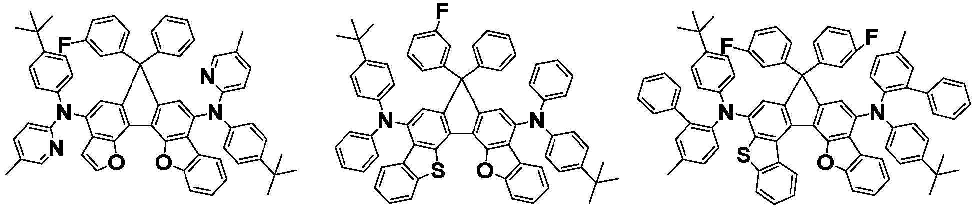

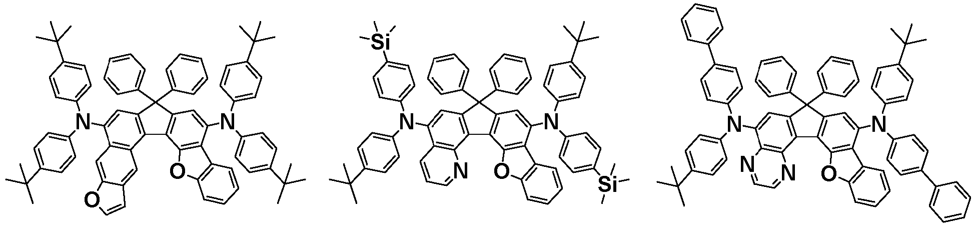

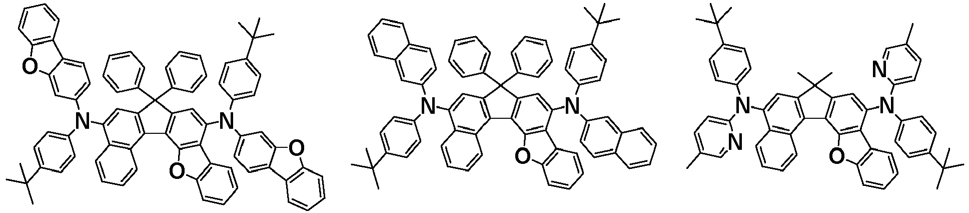

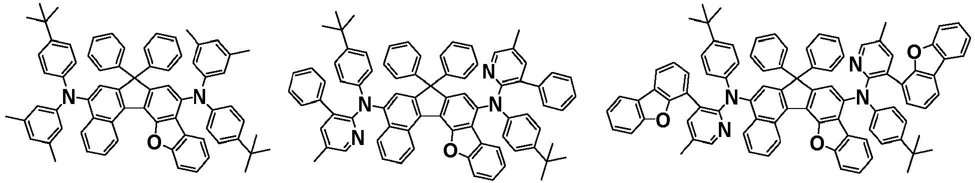

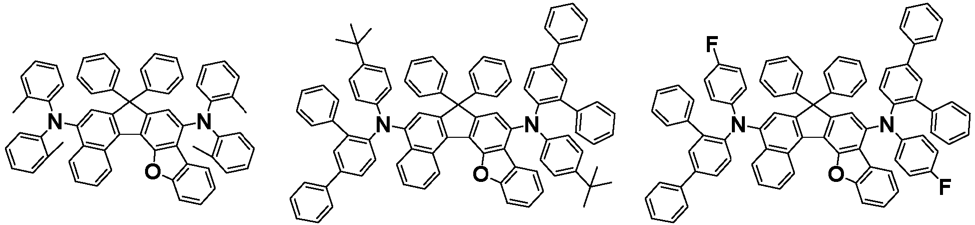

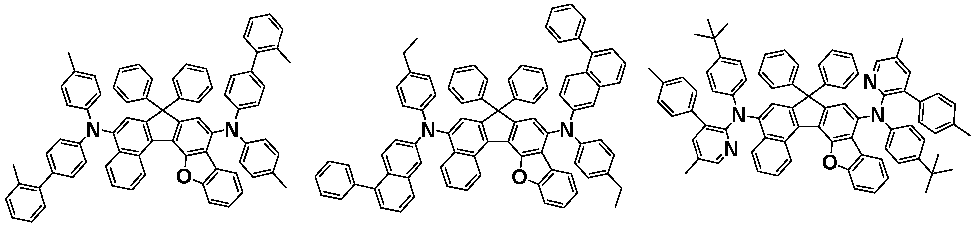

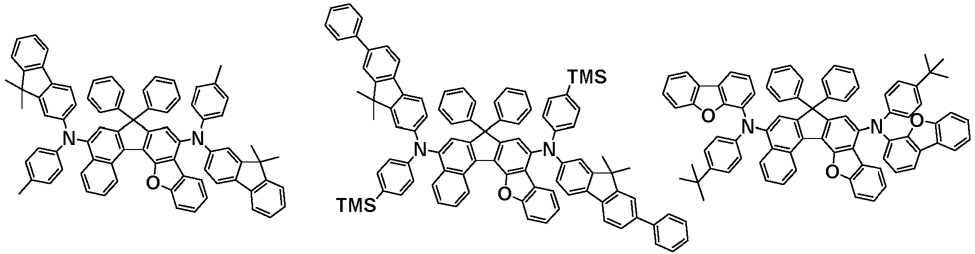

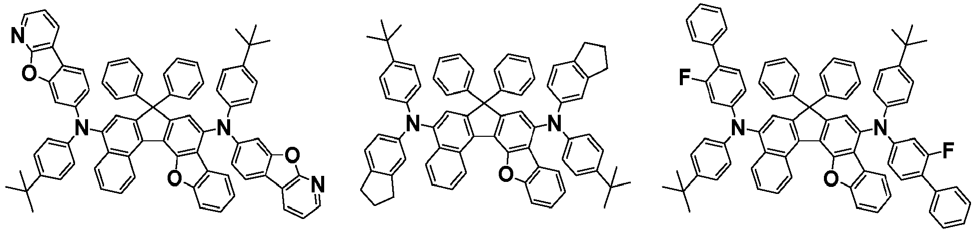

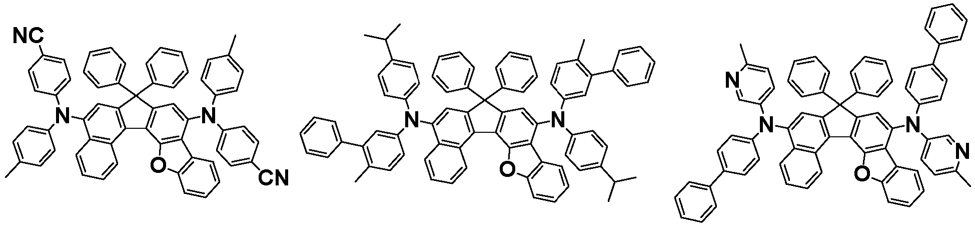

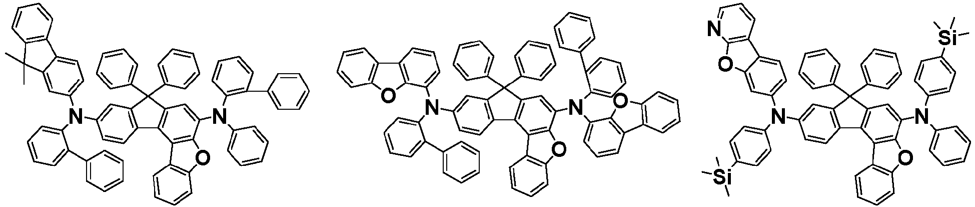

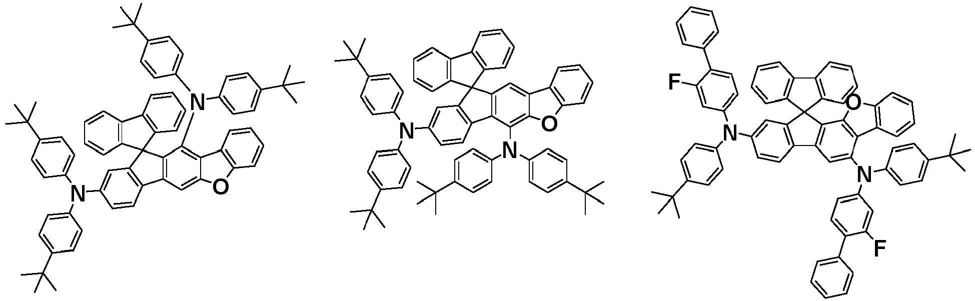

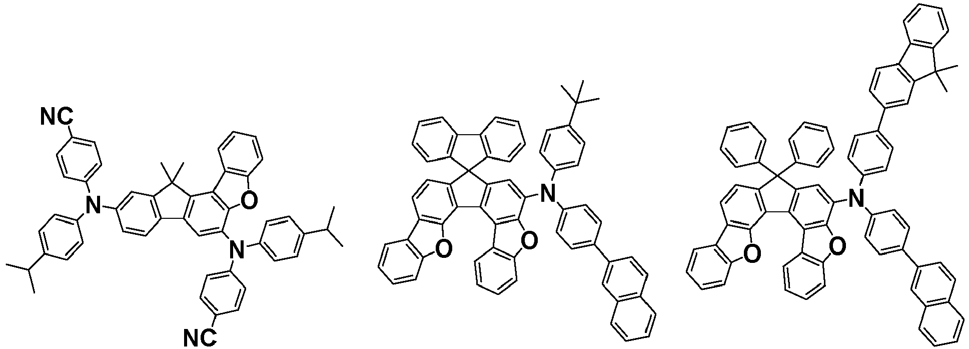

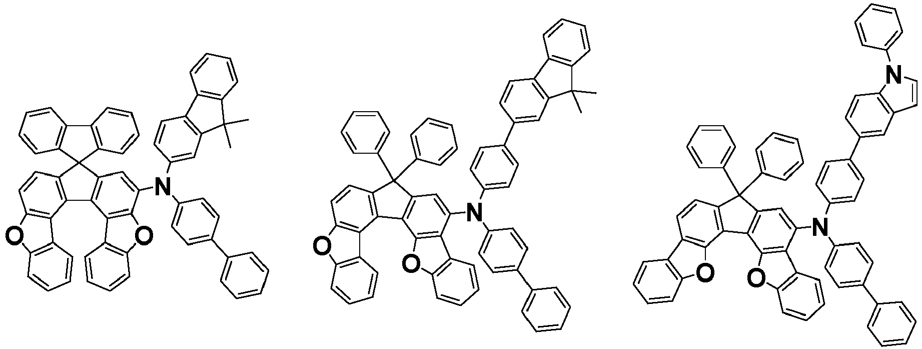

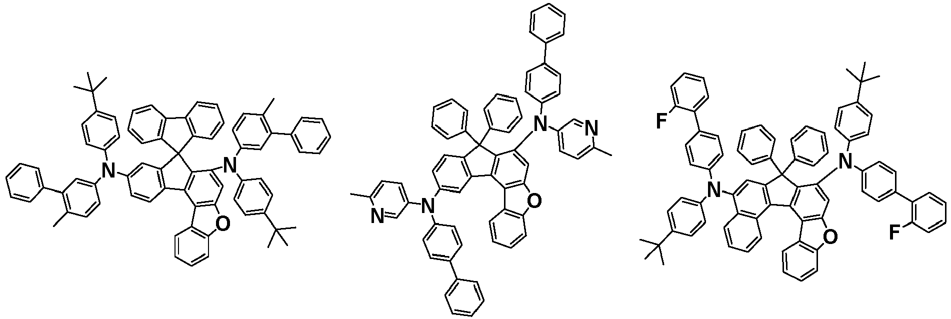

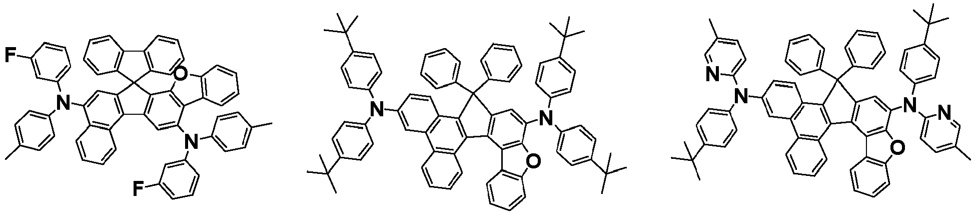

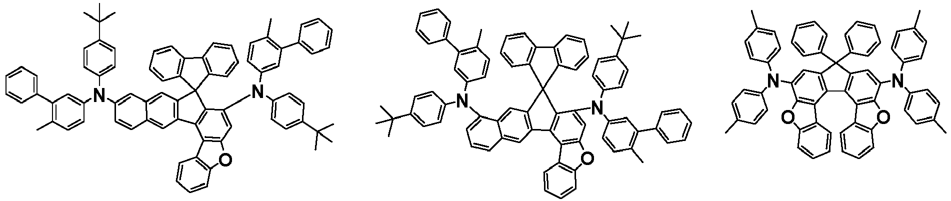

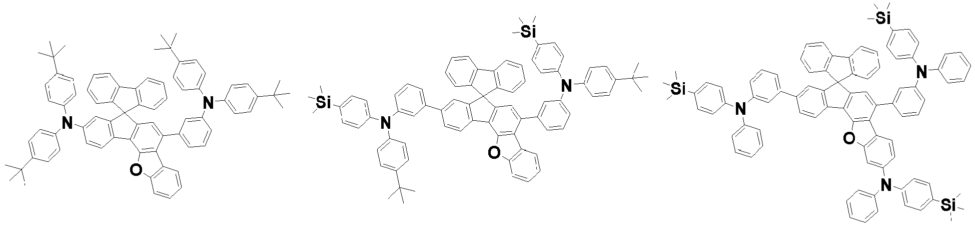

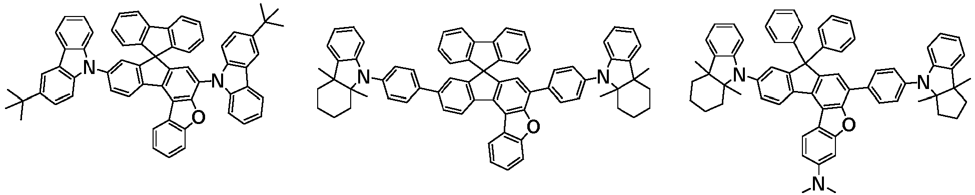

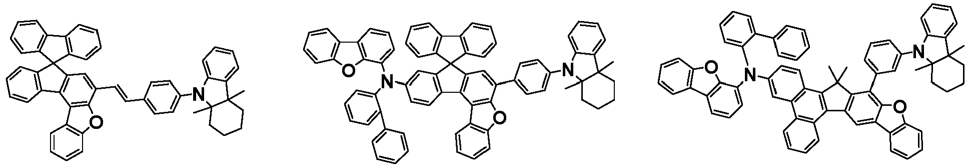

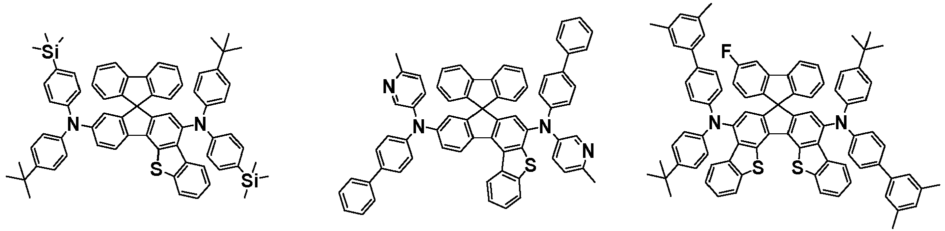

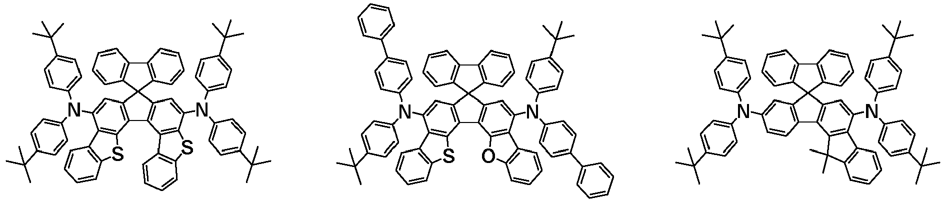

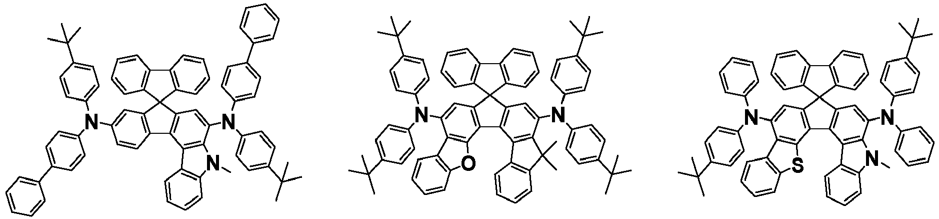

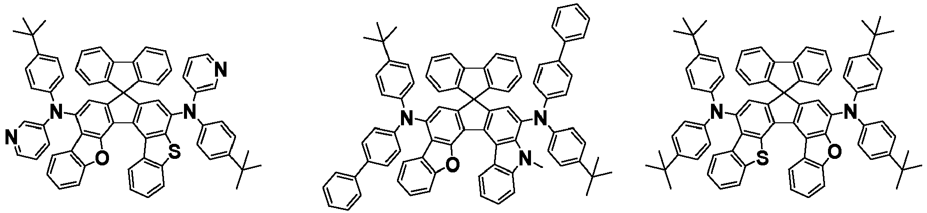

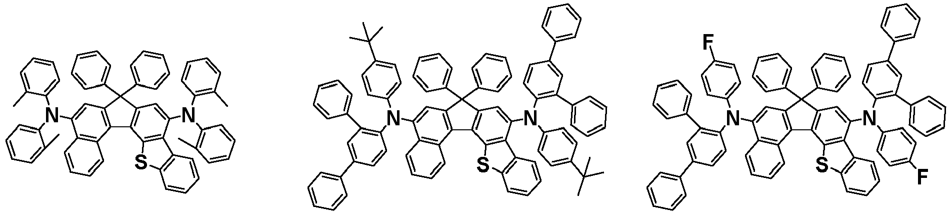

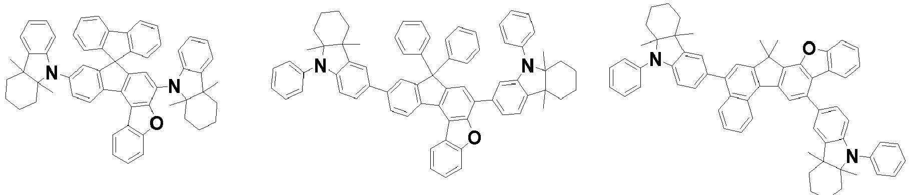

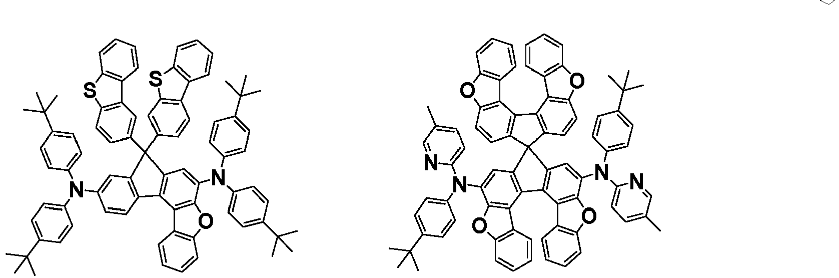

In a preferred embodiment thereof, the present disclosure provides an organic light-emitting diode sequentially including: an anode as a first electrode; a cathode as a second electrode facing the first electrode; a first light-emitting layer containing a first host and a first dopant therein; a second light-emitting layer containing a second host and a second dopant, both the light-emitting diodes being interposed between the anode and the cathode, wherein at least one of the first dopant and the second dopant within the light-emitting layers includes a compound represented by at least one of Chemical Formulas D-1 to D-3. With such structural features, the organic light-emitting diode according to the present disclosure can exhibit the properties of low voltage driving, longevity, and high luminous efficiency.

The content of the dopant in each of the light-emitting layers may range from about 0.01 to 20 parts by weight, based on 100 parts by weight of the host used therein, but is not limited thereto.

In addition, at least one of the first and second hosts in the first and second light-emitting layers may include at least one of the compounds represented by the following Chemical Formula B.

Of the first light-emitting diode and the second light-emitting diode, one may contain the anthracene derivative represented by Chemical Formula A above while the other light-emitting layer may contain a compound represented by the following Chemical Formula B: 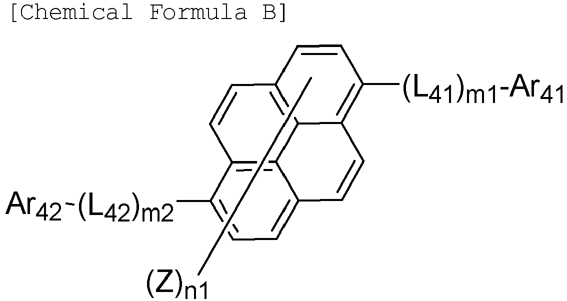 wherein,
L₄₁ and L₄₂, which are same or different, function as linkers and are each independently selected from a single bond, a substituted or unsubstituted arylene of 6 to 30 carbon atoms, and a substituted or unsubstituted heteroarylene of 6 to 30 carbon atoms,
m₁ and m₂, which are same or different, are each independently an integer of 1 or 2 wherein when m₁ and m₂ are each 2, the corresponding L₄₁'s and L₄₂'s are same or different;
Ar₄₁ and Ar₄₂, which are same or different, are each independently any one selected from a substituted or unsubstituted aryl of 6 to 50 carbon atoms, a substituted or unsubstituted heteroaryl of 2 to 50 carbon atoms, a substituted or unsubstituted alkyl of 1 to 30 carbon atoms, a substituted or unsubstituted cycloalkyl of 3 to 30 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted amine of 0 to 30 carbon atoms, a substituted or unsubstituted silyl of 0 to 30 carbon atoms, and a substituted or unsubstituted germanium of 0 to 30 carbon atoms;
Z is any one selected from a hydrogen atom, a deuterium atom, a substituted or unsubstituted alkyl of 1 to 30 carbon atoms, a substituted or unsubstituted alkenyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted heterocycloalkyl of 2 to 30 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a cyano, a nitro, and a halogen;
n₁ is an integer of 0 to 8, wherein when n₁ is 2 or higher, the corresponding Z's are same or different,
the aromatic carbon atom of the pyrene ring being bound with a hydrogen atom or deuterium atom when any of Z, Ar₄₁-(L₄₁)m₁-, and Ar₄₂-(L₄₂)m₂- is not bonded thereto.

According to an embodiment, the linkers L₄₁ and L₄₂ in Chemical Formula B, which are same or different, are each independently a single bond or a substituted or unsubstituted arylene of 6 to 18 carbon atoms.

According to an embodiment, at least one of Ar₄₁ and Ar₄₂ in Chemical Formula B may be a substituted or unsubstituted aryl of 6 to 18 carbon atoms or a substituted or unsubstituted heteroaryl of 3 to 18 carbon atoms, with preference for a substituted or unsubstituted heteroaryl of 3 to 18 carbon atoms.

According to an embodiment of the present disclosure, the compound represented by Chemical Formula B may be any one selected from the group consisting of the following compounds, but with no limitations thereto:

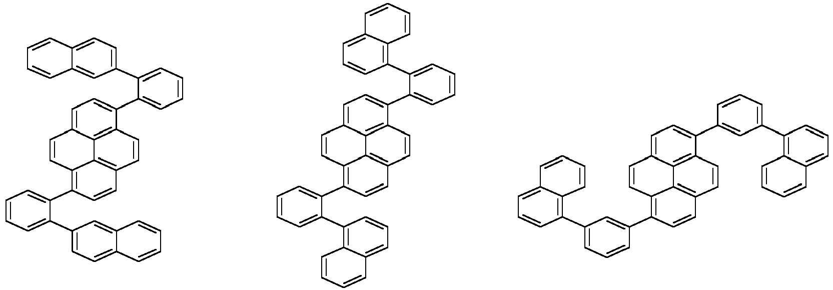

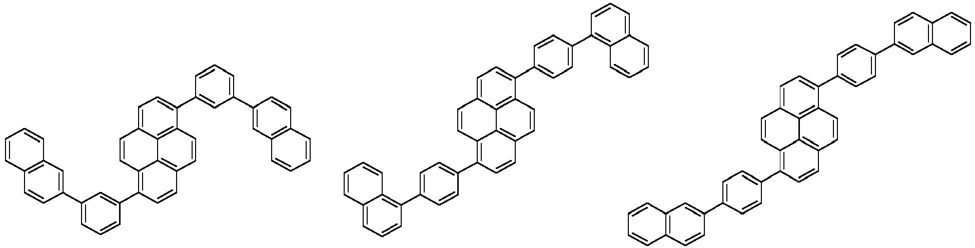

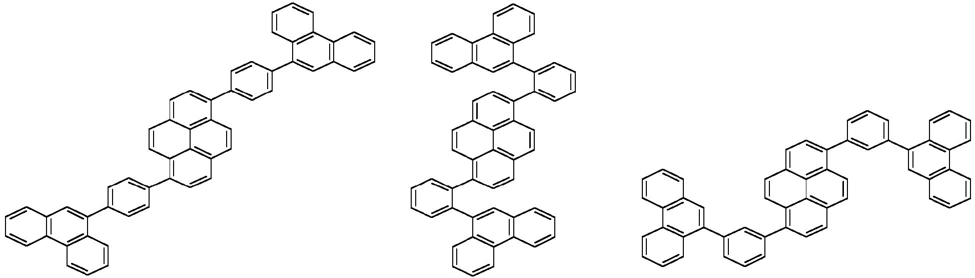

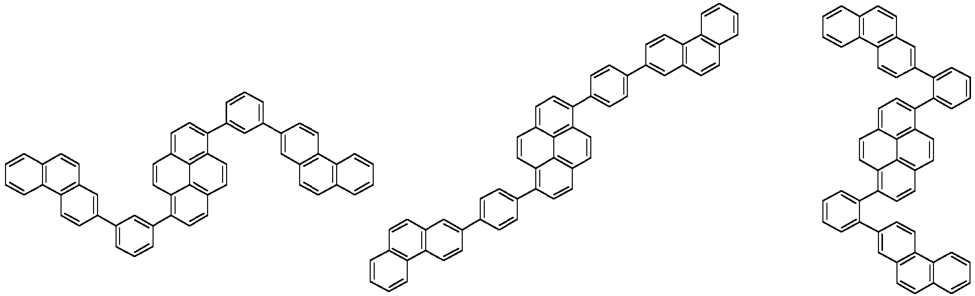

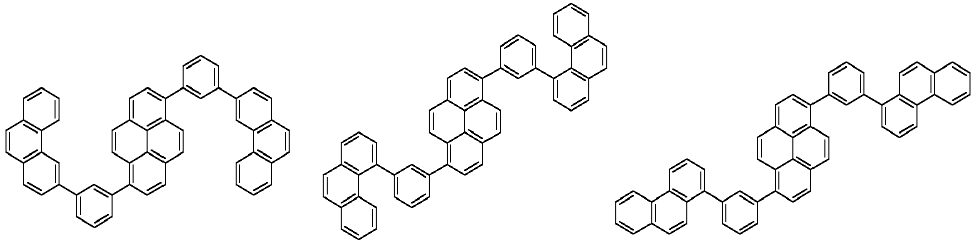

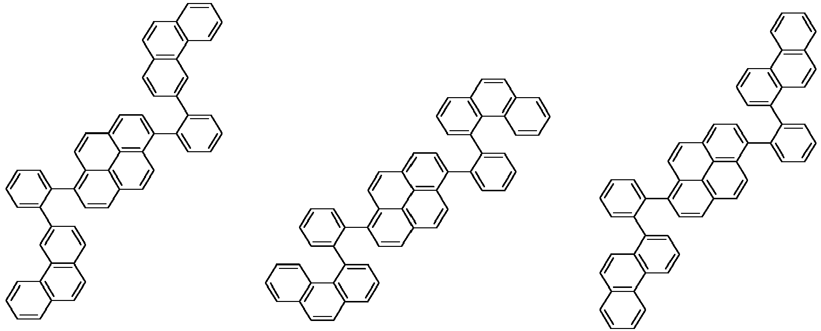

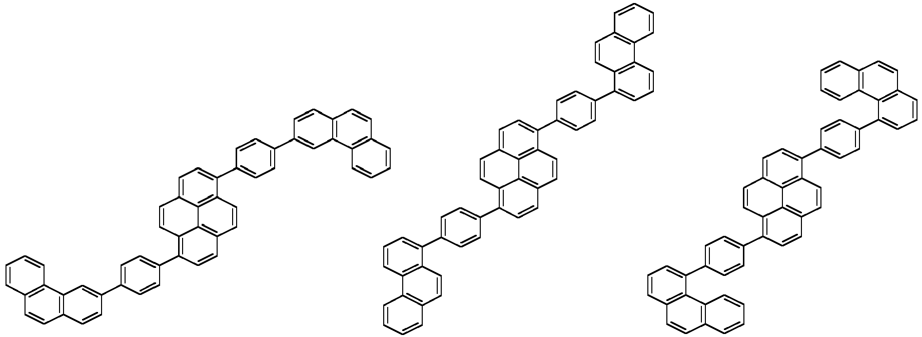

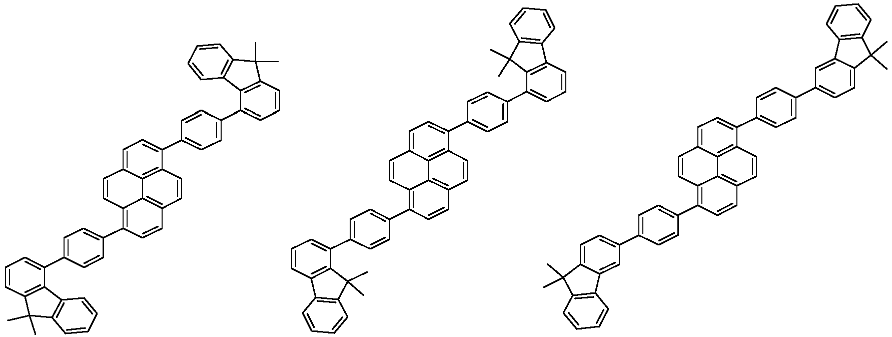

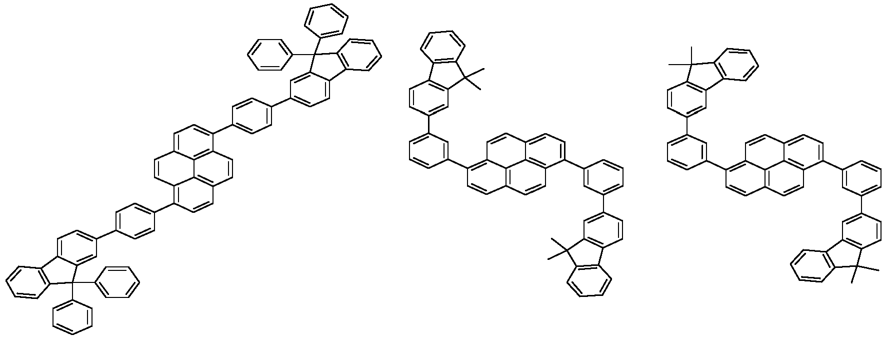

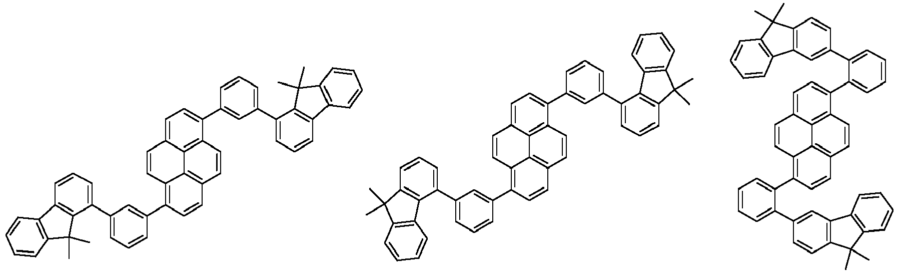

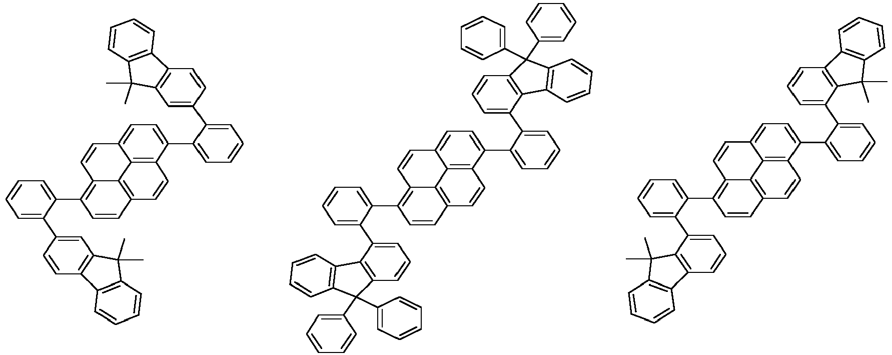

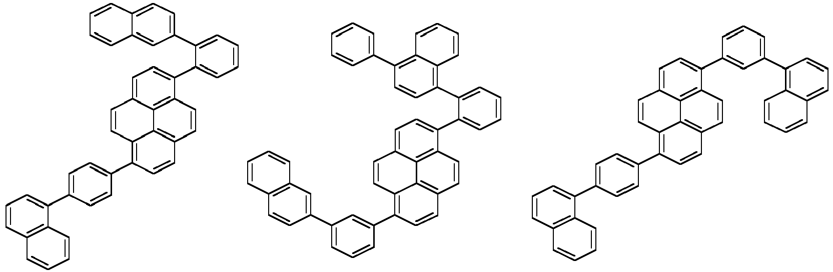

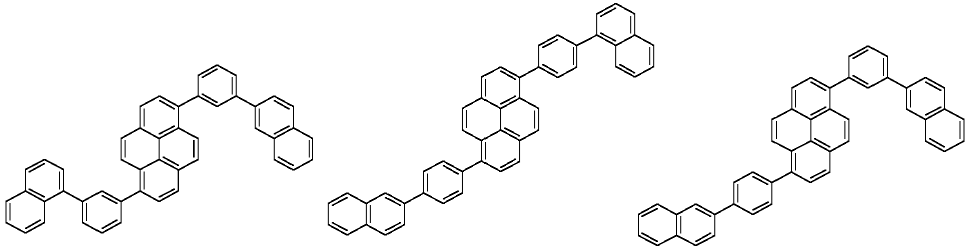

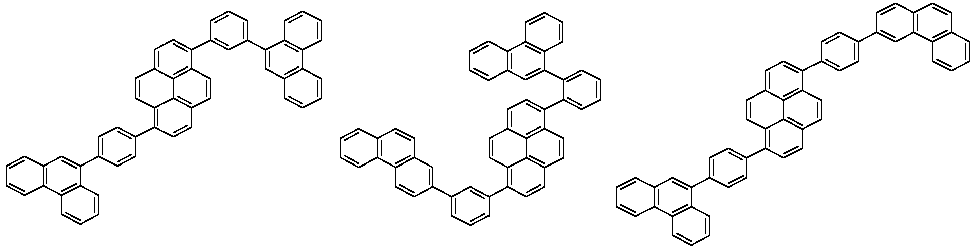

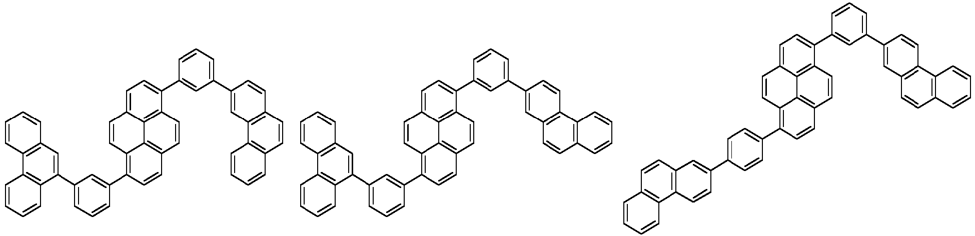

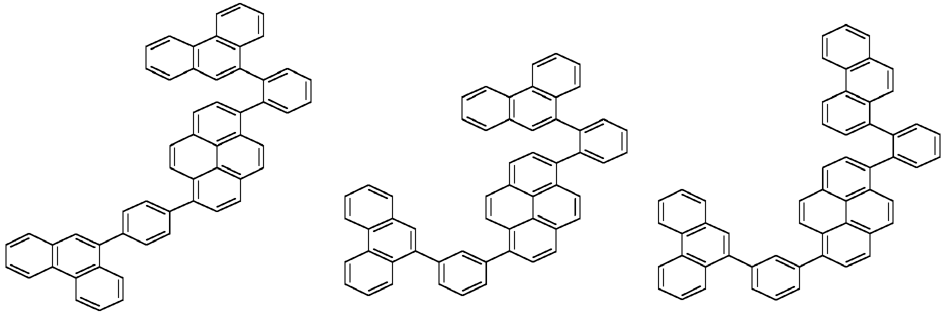

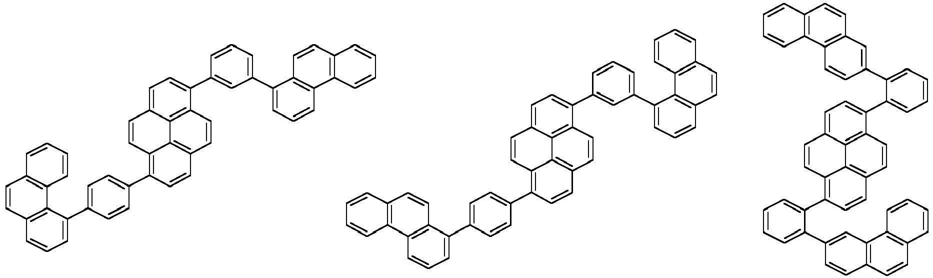

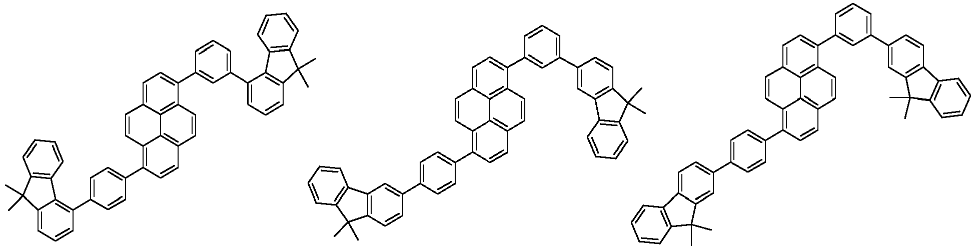

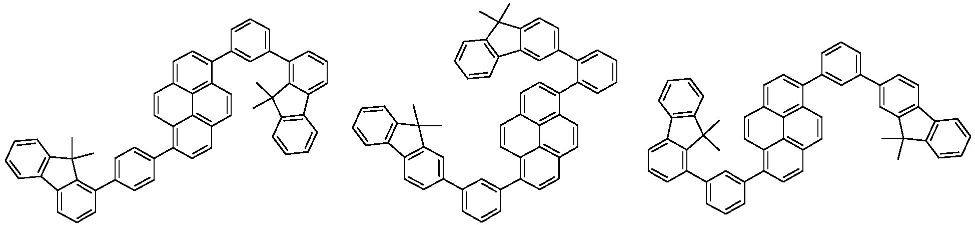

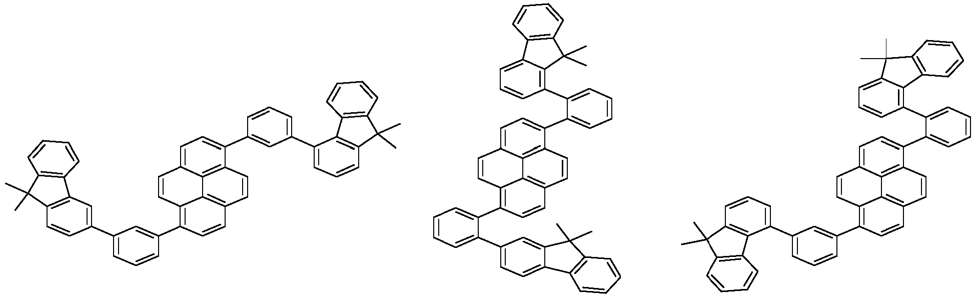

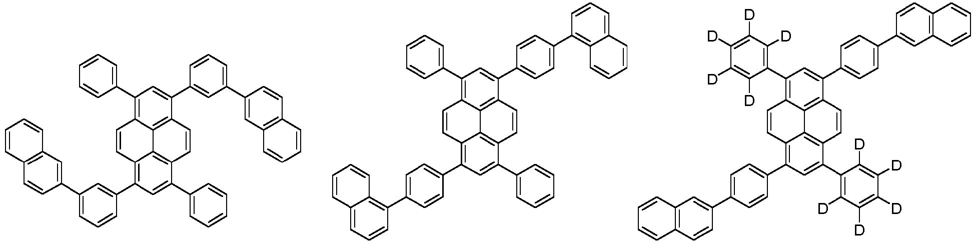

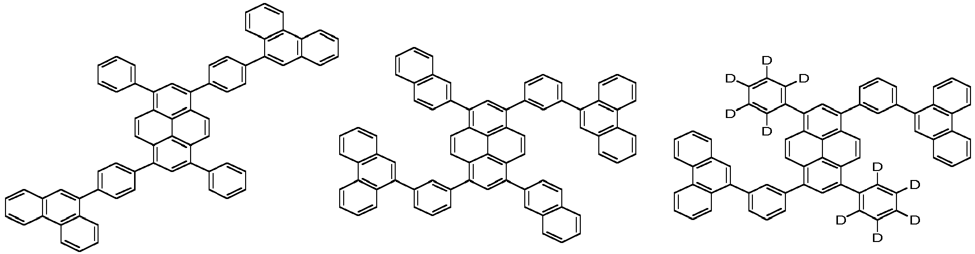

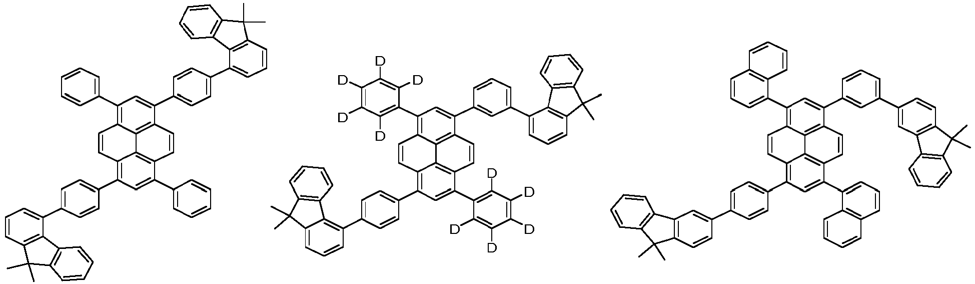

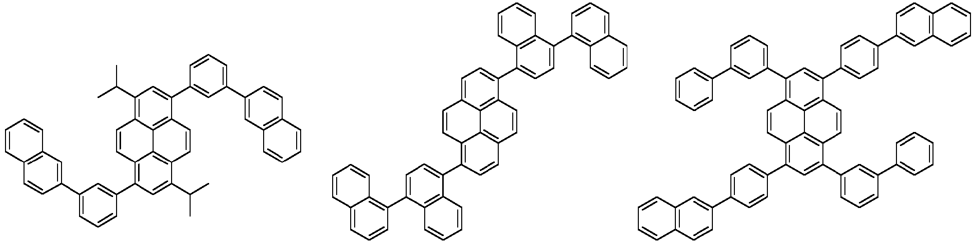

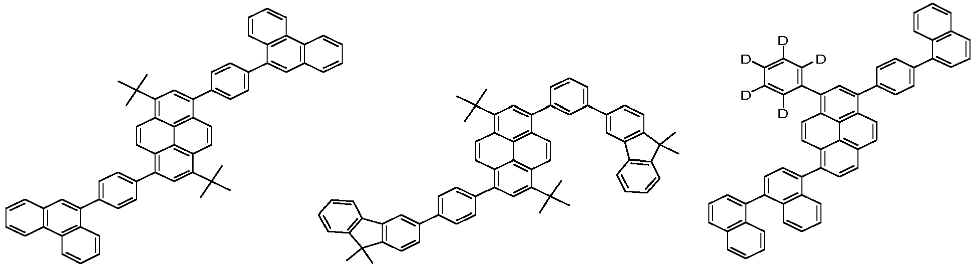

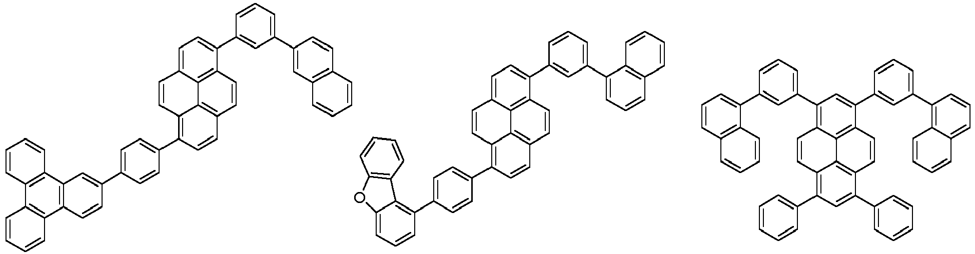

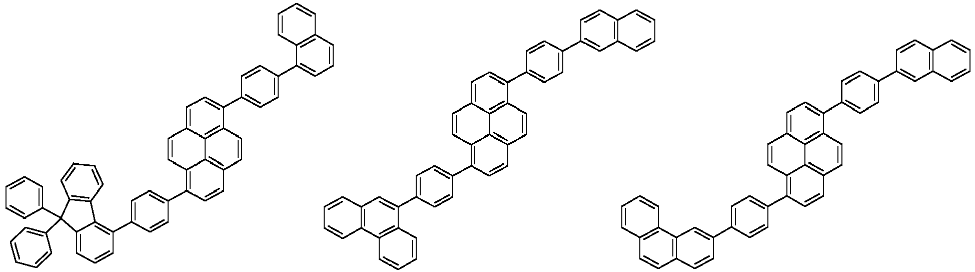

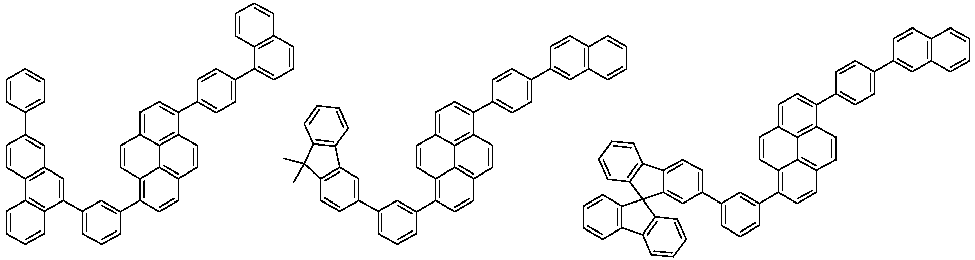

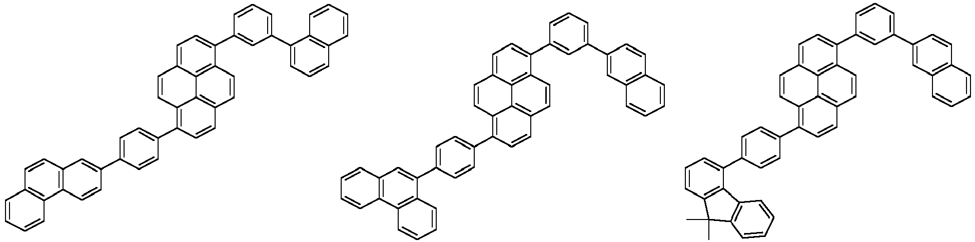

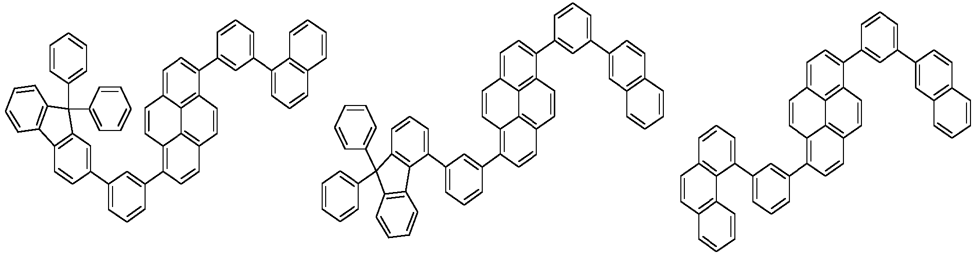

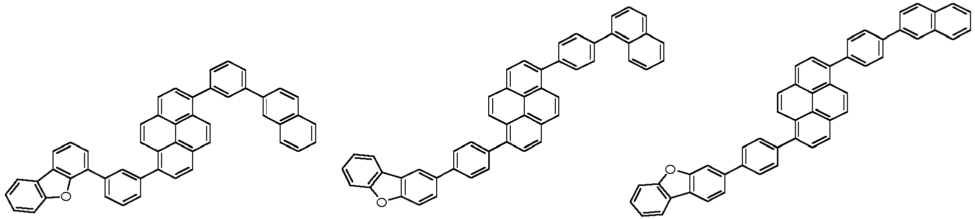

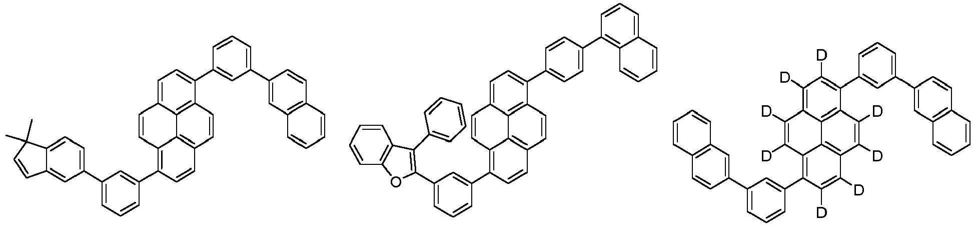

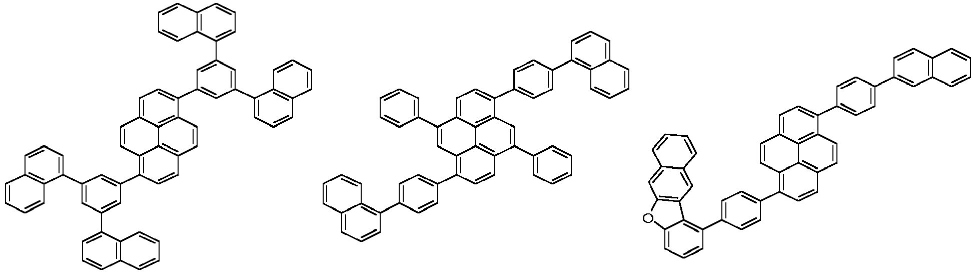

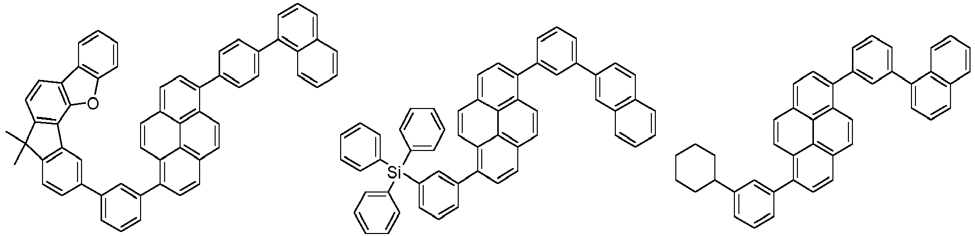

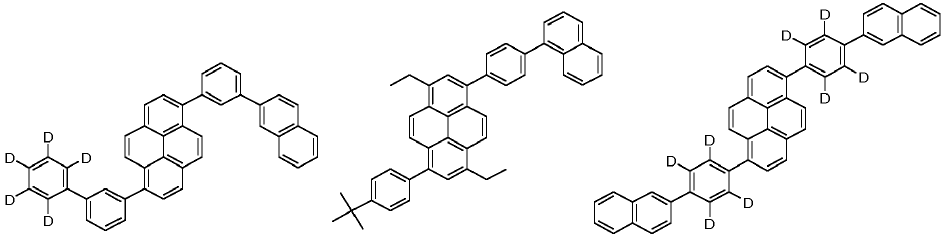

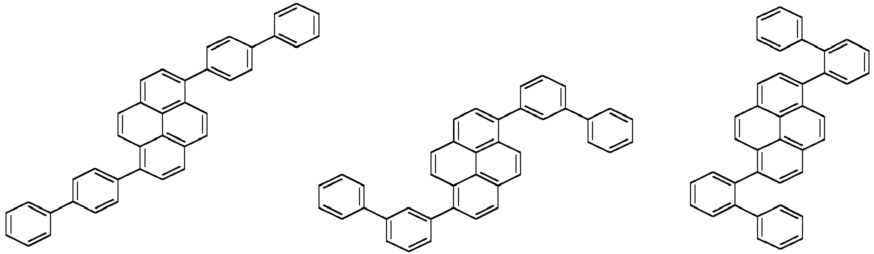

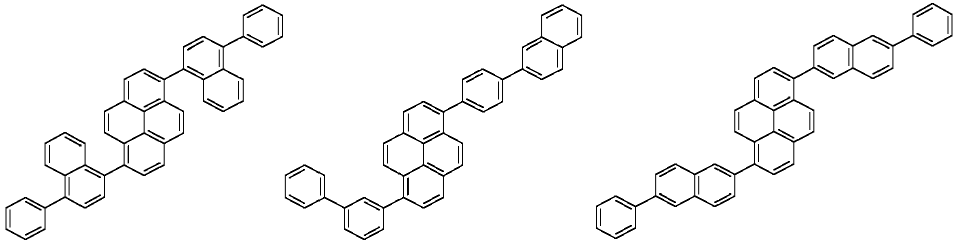

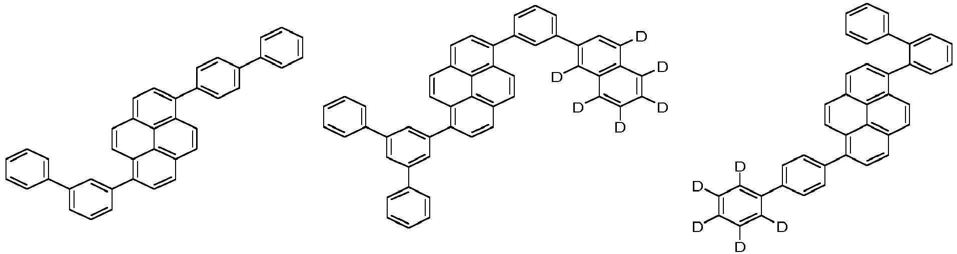

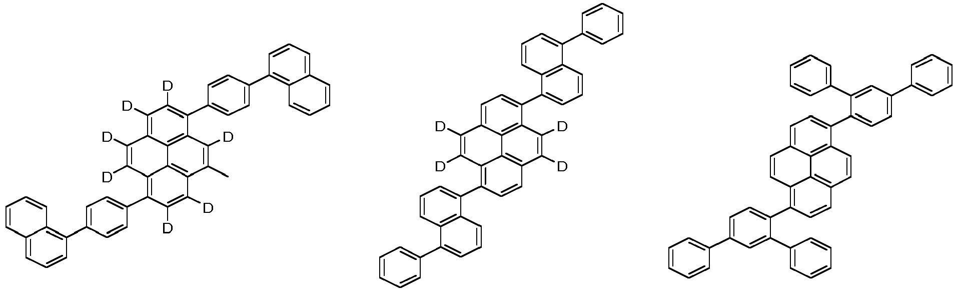

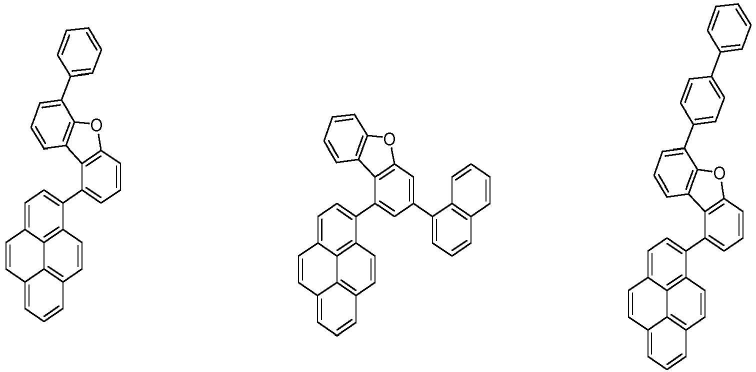

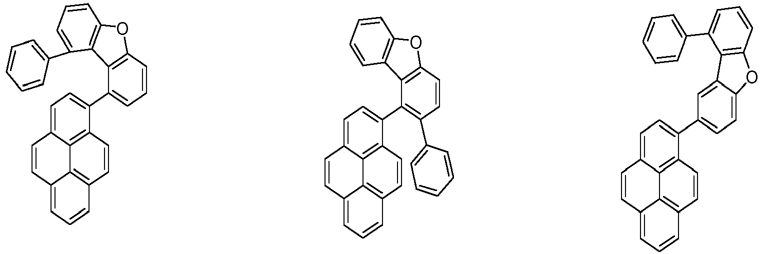

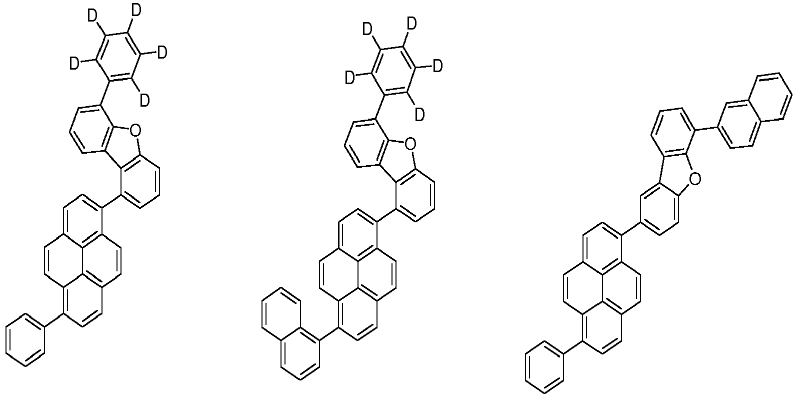

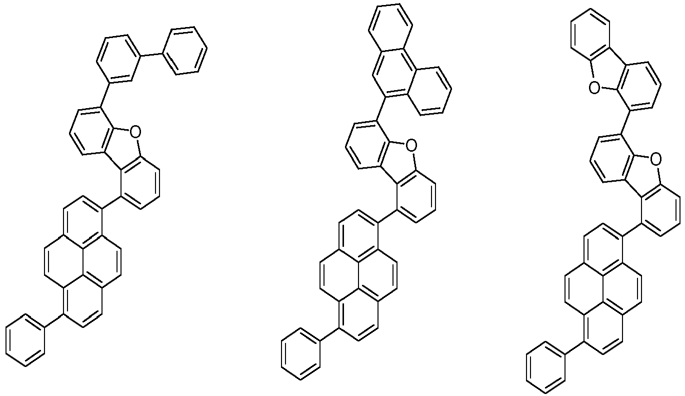

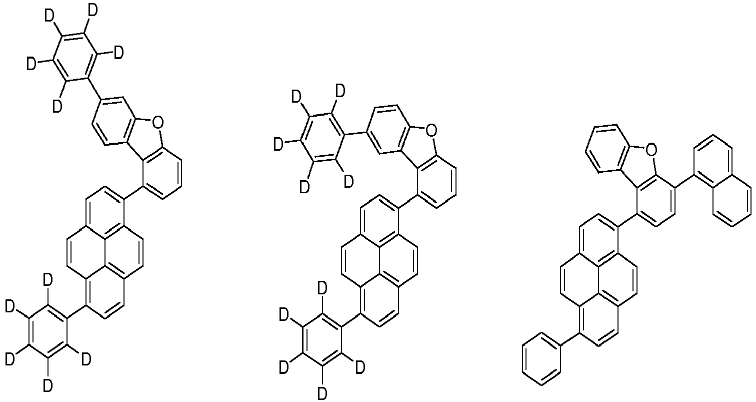

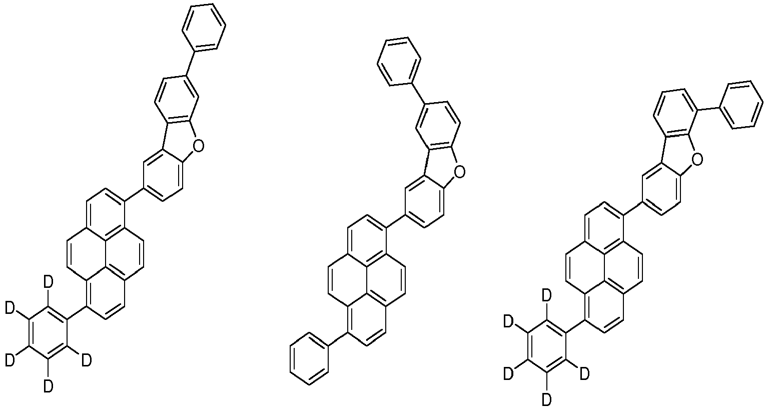

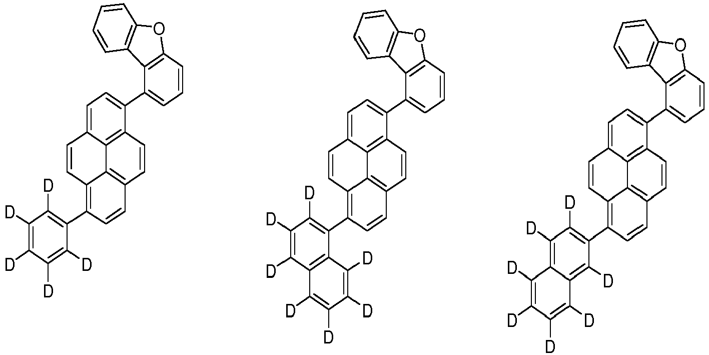

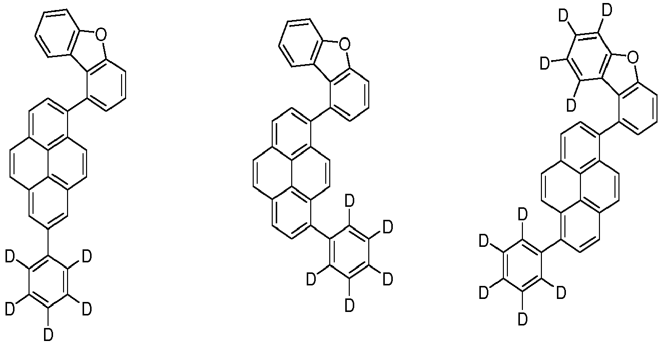

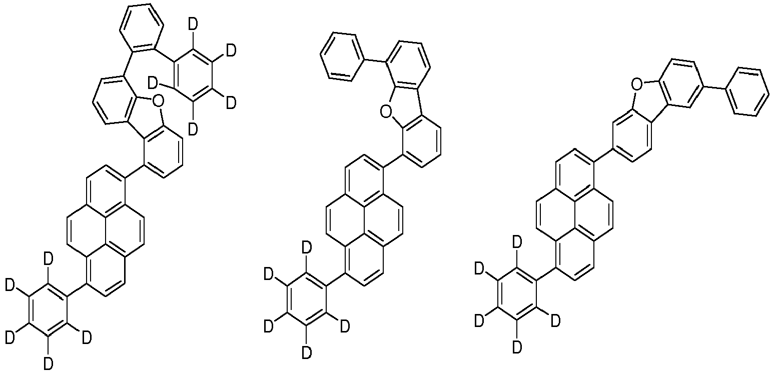

In addition to the above-mentioned dopants and hosts, the light-emitting layers may further include various hosts and dopant materials.

Below, the organic light-emitting diode of the present disclosure will be explained with reference to the drawing. The Figure is a schematic cross-sectional view of the structure of an organic light-emitting diode according to an embodiment of the present disclosure. As shown in the Figure, the organic light-emitting diode according to an embodiment of the present disclosure sequentially includes: an anode (20); a hole transport layer (40); a first light-emitting layer (50-A) containing a first host and a first dopant; a second light-emitting layer (50-B) containing a second host and a second dopant; an electron transport layer (60); and a cathode (80), sequentially, wherein the anode and the cathode serve as a first electrode and a second electrode, respectively, with the interposition of the hole transport layer between the anode and the light-emitting layer, and the electron transport layer between the light-emitting layer and the cathode.

Furthermore, the organic light-emitting diode according to an embodiment of the present disclosure may include a hole injection layer (30) between the anode (20) and the hole transport layer (40), and an electron injection layer (70) between the electron transport layer (60) and the cathode (80).

Reference is made to the Figure with regard to the organic light emitting diode of the present disclosure and the fabrication method therefor.

First, a substrate (10) is coated with an anode electrode material to form an anode (20). So long as it is used in a typical organic electroluminescence (EL) device, any substrate may be used as the substrate (10). Preferable is an organic substrate or transparent plastic substrate that exhibits excellent transparency, surface smoothness, ease of handling, and waterproofness. As the anode electrode material, indium tin oxide (ITO), indium zinc oxide (IZO), tin oxide (SnO₂), or zinc oxide (ZnO), which are transparent and superior in terms of conductivity, may be used.

A hole injection layer material is applied on the anode (20) by thermal deposition in a vacuum or by spin coating to form a hole injection layer (30). Subsequently, thermal deposition in a vacuum or by spin coating may also be conducted to form a hole transport layer (40) with a hole transport layer material on the hole injection layer (30).

So long as it is typically used in the art, any material may be selected for the hole injection layer without particular limitations thereto. Examples include, but are not limited to, 2-TNATA [4,4',4"-tris(2-naphthylphenyl-phenylamino)-triphenylamine], NPD [N,N'-di(1-naphthyl)-N,N'-diphenylbenzidine)], TPD [N,N'-diphenyl-N,N'-bis(3-methylphenyl)-1,1'-biphenyl-4,4'-diamine], DNTPD [N,N'-diphenyl-N,N'-bis-[4-(phenyl-m-tolyl-amino)-phenyl]-biphenyl-4,4'-diamine], and HAT-CN (2,3,6,7,10,11-hexacyanohexaazatriphenylene).

Any material that is typically used in the art may be selected for the hole transport layer without particular limitations thereto. Examples include, but are not limited to, N,N'-bis(3-methylphenyl)-N,N'-diphenyl-[1,1-biphenyl]-4,4'-diamine (TPD) and N,N'-di(naphthalen-1-yl)-N,N'-diphenylbenzidine (a-NPD).

In an embodiment of the present disclosure, an electron blocking layer may be additionally disposed on the hole transport layer. Functioning to prevent the electrons injected from the electron injection layer from entering the hole transport layer from the light-emitting layer, the electron blocking layer is adapted to increase the life span and luminous efficiency of the diode. The electron blocking layer may be formed at a suitable position between the light emitting layer and the hole injection layer. Particularly, the electron blocking layer may be formed between the light emitting layer and the hole transport layer.

Next, the first light-emitting layer (50-A) and the second light-emitting layer (50-B) may be deposited on the hole transport layer (40) or the electron blocking layer by deposition in a vacuum or by spin coating.

Here, the light-emitting layer may contain a host and a dopant and the materials are as described above.

In some embodiments of the present disclosure, the light-emitting layer particularly ranges in thickness from 50 to 2,000 Å.

Meanwhile, the electron transport layer (60) is applied on the light-emitting layer by deposition in a vacuum and spin coating.

A material for use in the electron transport layer (60) functions to stably carry the electrons injected from the electron injection electrode (cathode), and may be an electron transport material known in the art. Examples of the electron transport material known in the art include quinoline derivatives, particularly, tris(8-quinolinolate)aluminum (Alq₃), Liq, TAZ, BAlq, beryllium bis(benzoquinolin-10-olate) (Bebq2), Compound 201, Compound 202, BCP, and oxadiazole derivatives such as PBD, BMD, and BND, but are not limited thereto:

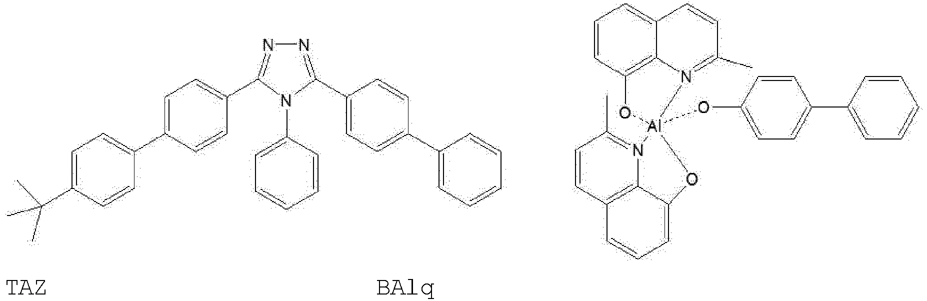

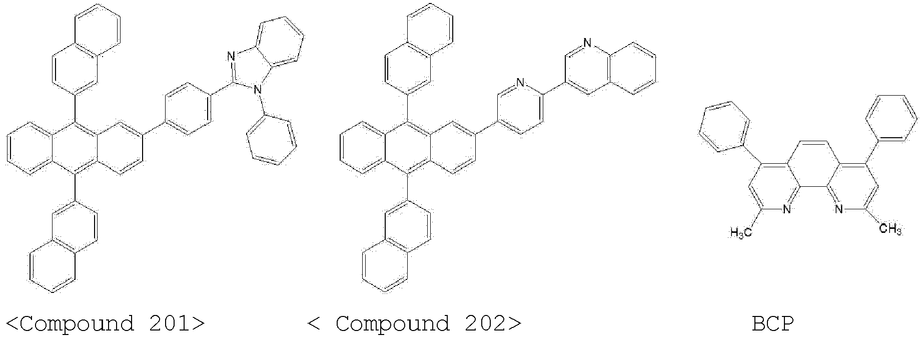

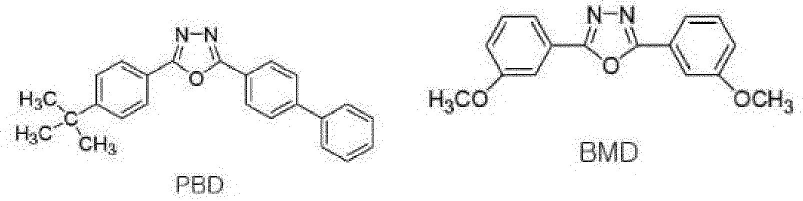

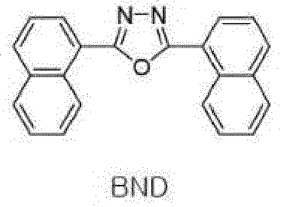

In the organic light emitting diode of the present disclosure, an electron injection layer (EIL) (70) that functions to facilitate electron injection from the cathode may be deposited on the electron transport layer (60). The material for the EIL is not particularly limited.

Any material that is conventionally used in the art can be available for the electron injection layer without particular limitations. Examples include CsF, NaF, LiF, Li₂O, and BaO. Deposition conditions for the electron injection layer may vary, depending on compounds used, but may be generally selected from condition scopes that are almost the same as for the formation of hole injection layers.

The electron injection layer (70) may range in thickness from about 1 Å to about 100 Å, and particularly from about 3 Å to about 90 Å. Given the thickness range for the electron injection layer, the diode can exhibit satisfactory electron injection properties without actually elevating a driving voltage.

In order to facilitate electron injection, the cathode (80) may be made of a material having a small work function, such as metal or metal alloy such as lithium (Li), magnesium (Mg), calcium (Ca), an alloy aluminum (Al) thereof, aluminum-lithium (Al-Li), magnesium-indium (Mg-In), and magnesium-silver (Mg-Ag). Alternatively, ITO or IZO may be employed to form a transparent cathode for an organic light-emitting diode.

Furthermore, at least one selected from among the layers may be deposited using a single-molecule deposition process or a solution process.

Here, the deposition process is a process by which a material is vaporized in a vacuum or at a low pressure and deposited to form a layer, and the solution process is a method in which a material is dissolved in a solvent and applied for the formation of a thin film by means of inkjet printing, roll-to-roll coating, screen printing, spray coating, dip coating, spin coating, etc.

Additionally, the organic light-emitting diode of the present disclosure may be applied to a device selected from among a flat panel display device, a flexible display device, a monochrome or grayscale flat illumination device, a monochrome or grayscale flexible illumination device, a vehicle display device, and a display device for virtual or augmented reality.

Below, the present disclosure will be elucidated in more detail with reference to the following Examples. However, it would be obvious to those skilled in the art that the Examples are to illustrate the present disclosure, but the scope of the present disclosure is not limited thereto.

A better understanding of the present disclosure may be obtained through the following examples which are set forth to illustrate, but are not to be construed as limiting the present disclosure.

### SYNTHESIS EXAMPLES (Synthesis of Host Compounds)

### SYNTHESIS EXAMPLE 1: Synthesis of [A-20]

### Synthesis Example 1-1 : Synthesis of 1-a

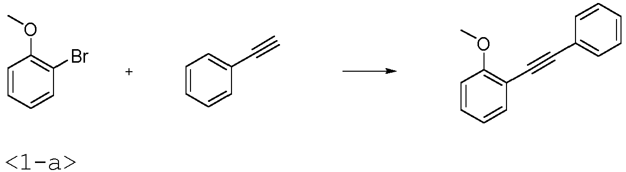

In a 1 L reactor, 2-bromoanisole (30 g), phenylacetylene (38.5 g), bis(triphenylphosphine)palladium (II) dichloride (2.41 g), copper(I) iodide (1.63 g), and triphenylphosphine (0.45 g) were added to triethylamine (300 mL) and stirred overnight under reflux. After completion of the reaction, the reaction mixture was cooled to room temperature and filtered with hexane. The filtrate was concentrated and purified by column chromatography to afford <1-a>. (25 g, 74%)

### Synthesis Example 1-2 : Synthesis of 1-b

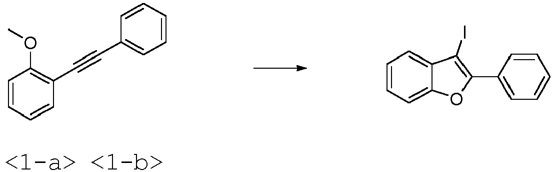

In a 1 L reactor, a solution of <1-a> (25 g) in dichloromethane was purged with nitrogen. Iodine (45.7 g) was added before stirring at room temperature for 12 hours. After completion of the reaction, an aqueous sodium thiosulfate solution was added to remove residual iodine. Extraction with dichloromethane and purification by column chromatography afforded <1-b> (31 g, 81%).

### Synthesis Example 1-3 : Synthesis of [A-20]

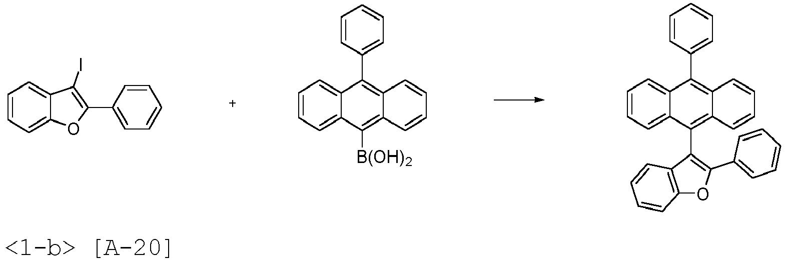

In a 1 L reactor <1-b> (31 g), 10-phenylanthracene-9-boronic acid (31.7 g), potassium carbonate 26.8 g, tetrakis(triphenylphosphine)palladium(0) (2.24 g), toluene (210 mL), and ethanol (90 mL) were stirred together overnight at 110°C under reflux. The reaction mixture was cooled to room temperature and subjected to extraction with ethyl acetate/distilled water. The organic layer was concentrated, followed by purification through column chromatography to afford [A-20]. (19 g, 44%)
MS (MALDI-TOF) : m/z 446.17 [M⁺]

### SYNTHESIS EXAMPLE 2. Synthesis of [A-30]

### Synthesis Example 2-1 : Synthesis of 2-a

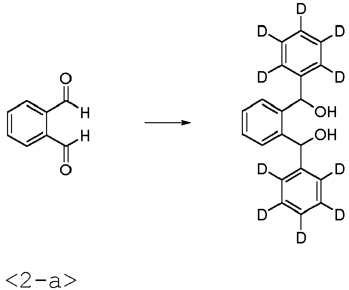

In a 2 L reactor, bromobenzene (d5) (60.4 g) and tetrahydrofuran (480 mL) were chilled together to -78°C and stirred. To the chilled solution was added drops of n-butyl lithium (223.6 mL) and stirred at the same temperature for 1 hour. A solution of O-phthalaldehyde (20 g) in tetrahydrofuran (100 mL) was dropwise added and stirred. After completion of the reaction, an aqueous ammonium chloride solution (200 mL) was added to terminate the reaction. Extraction with ethyl acetate and then purification by column chromatography afforded <2-a>. (40 g, 89%)

### Synthesis Example 2-2 : Synthesis of 2-b

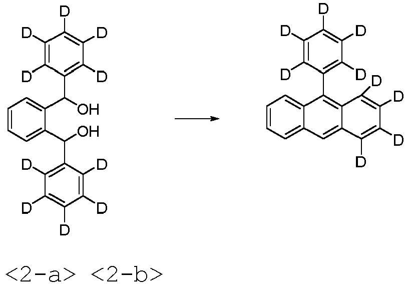

In a 500 mL reactor, <2-a> (40 g) was dissolved in acetic acid (200 mL). To this reaction solution was added hydrogen bromide (2 mL), followed by stirring at 80°C for 2 hours. After completion of the reaction, the reaction mixture was cooled to room temperature and slowly poured to distilled water (500 mL) in a beaker and stirred. The solid thus formed was filtered and washed with distilled water. The solid was isolated by column chromatography to afford <2-b> (13 g, 37%).

### Synthesis Example 2-3 : Synthesis of 2-c

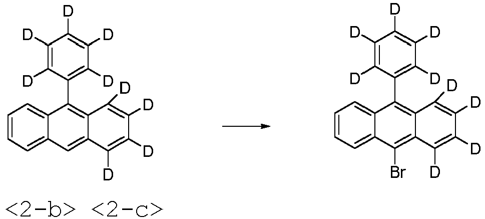

In a 500 ml reactor, <2-b> (13 g) was dissolved in N,N-dimethyl formamide (130 mL) and stirred at room temperature. A solution of N-bromosuccinimide (10.5 g) in N,N-dimethyl formamide (40 mL) was dropwise added. The reaction was terminated under the monitoring of thin layer chromatography. The reaction mixture was poured to distilled water (500 mL) in a beaker and stirred. The solid thus formed was filtered and washed with distilled water. Purification by column chromatography afforded <2-c>. (14 g, 83%)

### Synthesis Example 2-4 : Synthesis of 2-d

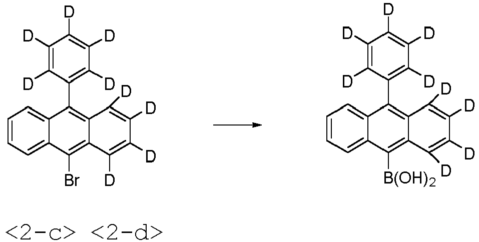

In a 500 ml reactor, <2-c> (50 g) was dissolved in tetrahydrofuran (500 mL) and chilled to -78°C before addition of drops of n-butyl lithium (100 mL). The solution was stirred for 5 hours, added with trimethylborate (18 mL), and stirred overnight at room temperature. After completion of the reaction, the reaction mixture was acidified with 2 N HCl and recrystallized to afford <2-d>. (25 g, 56%)

### Synthesis Example 2-5 : Synthesis of [A-30]

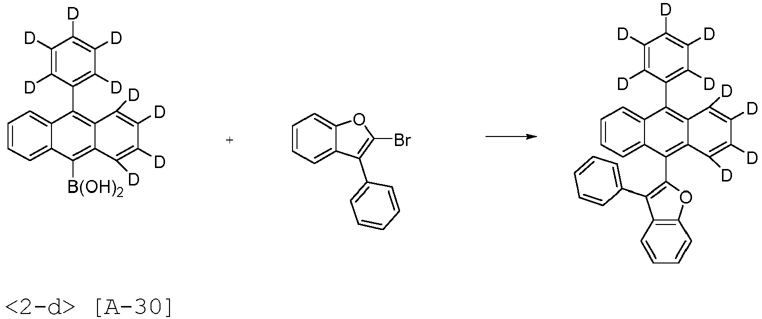

The same procedure as in Synthesis Example 1-3 was carried out, with the exception of using 2-bromo-3-phenylbenzofuran and <2-d> instead of <1-b> and 10-phenylanthracene-9-boronic acid, respectively, to afford [A-30] (yield 30%).
MS (MALDI-TOF) : m/z 455.22 [M⁺]

### SYNTHESIS EXAMPLE 3. Synthesis of [A-57]

### Synthesis Example 3-1 : Synthesis of 3-a

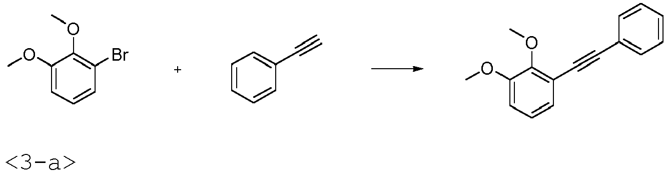

The same procedure as in Synthesis Example 1-1 was carried out, with the exception of using 3-bromoveratrole instead of 2-bromoanisole, to afford <3-a>. (yield 79%)

### Synthesis Example 3-2 : Synthesis of 3-b

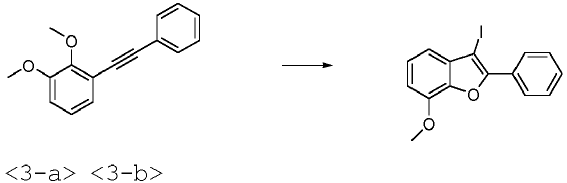

The same procedure as in Synthesis Example 1-2 was carried out, with the exception of using <3-a> instead of <1-a>, to afford <3-b>. (yield 63%)

### Synthesis Example 3-3 : Synthesis of 3-c

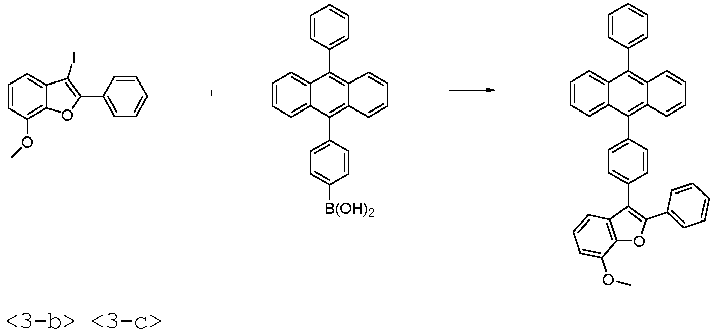

The same procedure as in Synthesis Example 1-3 was carried out, with the exception of using <3-b> and 4-(10-phenylanthracene-9-yl)benzeneboronic acid instead of <1-b> and 10-phenylanthracene-9-boronic acid, respectively, to afford <3-c>. (yield 61%)

### Synthesis Example 3-4 : Synthesis of 3-d

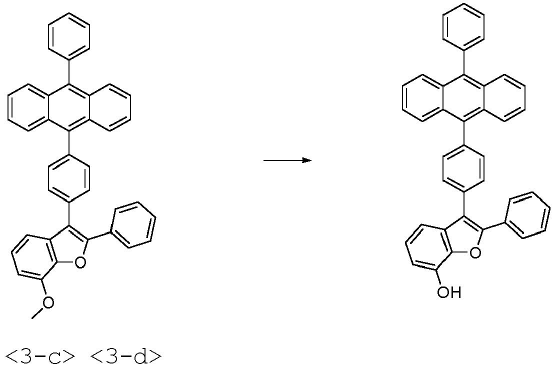

In a 500 ml reactor, <3-c> (20 g) was dissolved in dichloromethane. The temperature of the reactor was decreased to 0°C. Then, BBr₃ (13.6 g) was slowly added. The temperature was elevated to room temperature. After completion of the reaction, cold distilled water was slowly added to terminate the reaction. Extraction with dichloromethane and distilled water. The organic layer was concentrated, by purification through column chromatography to afford <3-d>. (17 g, 87%)

### Synthesis Example 3-5 : Synthesis of 3-e

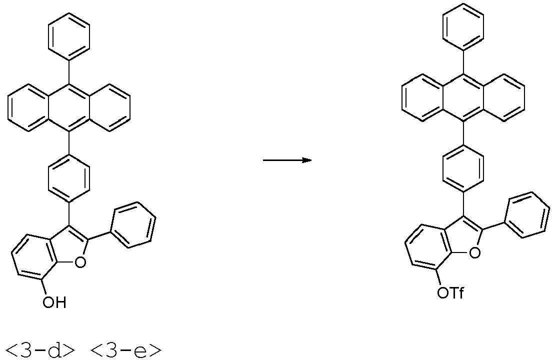

In a 500 ml reactor <3-d> (17 g) was dissolved in dichloromethane (170 mL). The temperature of the reactor was decreased to 0°C and then trifluoromethanesulfonic acid anhydride (10.7 g) was slowly added. The temperature was slowly increased to room temperature at which the solution was stirred for 3 hours. Cold distilled water was slowly added to terminate the reaction. After extraction with dichloromethane and distilled water, the organic layer was concentrated and purified by column chromatography to afford <3-e>. (17 g, 80%)

### Synthesis Example 3-6 : Synthesis of [A-57]

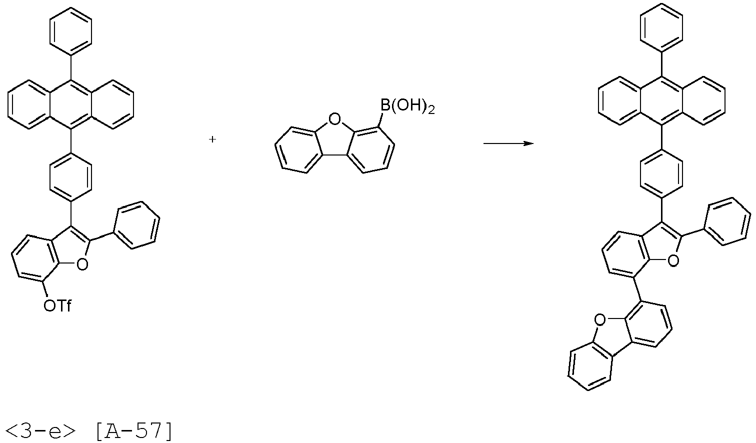

The same procedure as in Synthesis Example 1-3 was carried out, with the exception of using <3-e> and 4-dibenzofuran boronic acid instead of <1-b> and 10-phenylanthracene-9-boronic acid, respectively, to afford [A-57]. (yield 45%)
MS (MALDI-TOF) : m/z 688.24 [M⁺]

### SYNTHESIS EXAMPLE 4. Synthesis of [A-58]

### Synthesis Example 4-1 : Synthesis of 4-a

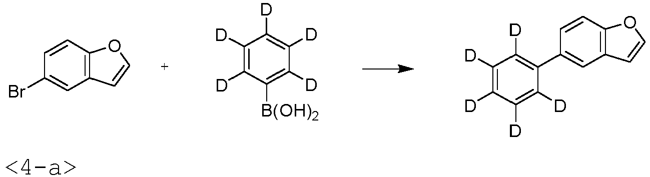

The same procedure as in Synthesis Example 1-3 was carried out, with the exception of using 5-bromobenzofuran and (phenyl-d5)boronic acid instead of <1-b> and 10-phenylanthracene-9-boronic acid, respectively, to afford <4-a>. (yield 70%)

### Synthesis Example 4-2 : Synthesis of 4-b

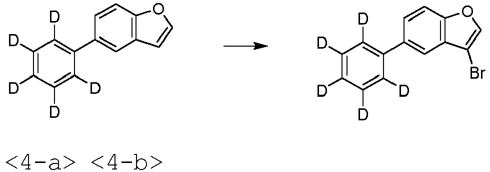

In a 500 ml reactor, a solution of <4-a> (21.2 g) in dichloromethane was chilled to -10°C and then bromine was added and stirred for 1 hour. An aqueous sodium thiosulfate solution was added to the mixture and stirred. After layer separation, the organic layer was concentrated in a vacuum. Ethanol was added to the concentrate and chilled to -10°C before adding a solution of potassium hydroxide in ethanol. Thereafter, the resulting mixture was refluxed for 4 hours at an elevated temperature. After completion of the reaction, the reaction mixture was subjected to layer separation. The organic layer thus formed was concentrated in a vacuum, followed by purification through column chromatography to afford <4-b>. (20 g, 70%)

### Synthesis Example 4-3 : Synthesis of 4-c

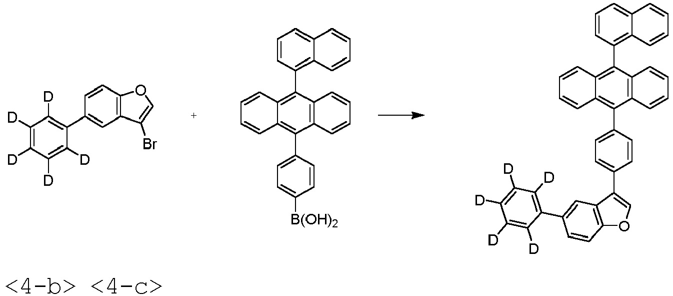

The same procedure as in Synthesis Example 1-3 was carried out, with the exception of using <4-b> and (4-(10-naphthalen-1-yl)anthracen-9-yl)benzeneboronic acid instead of <1-b> and 10-phenylanthracene-9-boronic acid, respectively, to afford <4-c>. (yield 72%)

### Synthesis Example 4-4 : Synthesis of 4-d

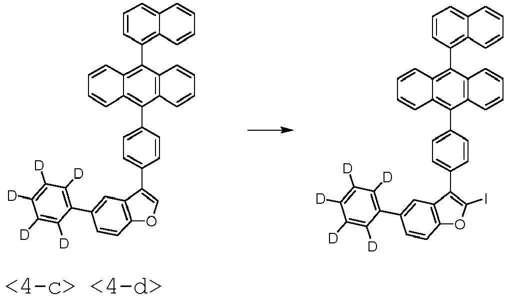

In a 500 ml reactor, a solution of <4-c> (20 g) in THF (250 mL) was chilled to -50°C before addition of n-butyl lithium (1.6M). After one hour, iodine was slowly added and the temperature was slowly raised to room temperature. At room temperature, an aqueous sodium thiosulfate solution was added to separate layers. The organic layer thus formed was concentrated in a vacuum, followed by purification through column chromatography to afford <4-d> (17 g, 70%)

### Synthesis Example 4-5 : Synthesis of [A-58]

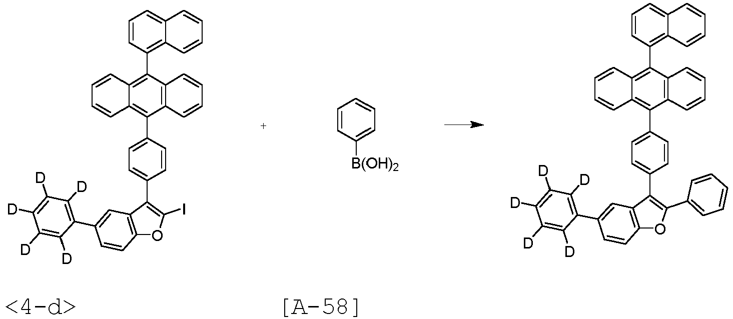

The same procedure as in Synthesis Example 1-3 was carried out, with the exception of using <4-d> and phenylboronic acid instead of <1-b> and 10-phenylanthracene-9-boronic acid, respectively, to afford [A-58]. (yield 47%)
MS (MALDI-TOF) : m/z 653.28 [M⁺]

### SYNTHESIS EXAMPLE 5. Synthesis of [A-68]

### Synthesis Example 5-1 : Synthesis of 5-a

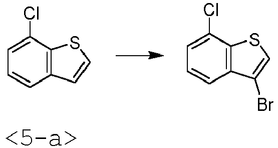

In a 500 ml reactor, 7-chlorobenzo[b]thiophene (30 g) and DMF were stirred together and then NBS was added and stirred for 6 hours under reflux. The addition of distilled water formed separated layers. The organic layer thus formed was concentrated in a vacuum, followed by purification through column chromatography to afford <5-a> (27 g, 62%)

### Synthesis Example 5-2 : Synthesis of 5-b

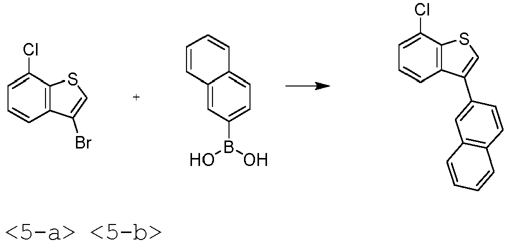

The same procedure as in Synthesis Example 1-3 was carried out, with the exception of using <5-a> and 2-naphthylboronic acid instead of <1-b> and 10-phenylanthracene-9-boronic acid, respectively, to afford <5-b>. (yield 68%)

### Synthesis Example 5-3 : Synthesis of 5-c

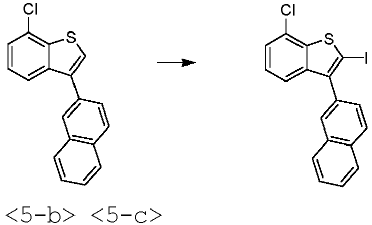

The same procedure as in Synthesis Example 4-4 was carried out, with the exception of using <5-b> instead of <4-c>, to afford <5-c>. (yield 70%)

### Synthesis Example 5-4 : Synthesis of 5-d

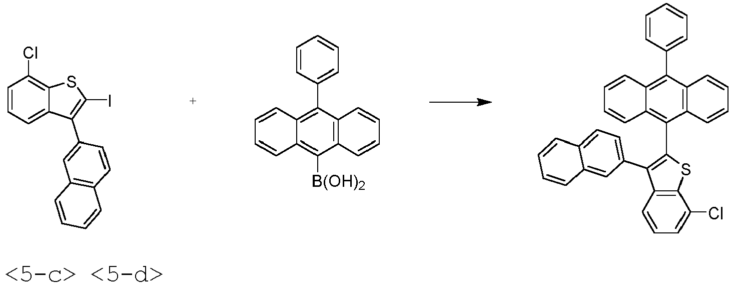

The same procedure as in Synthesis Example 1-3 was carried out, with the exception of using <5-c> instead of <1-b>, to afford <5-d>. (yield 63%)

### Synthesis Example 5-5 : Synthesis of 5-e

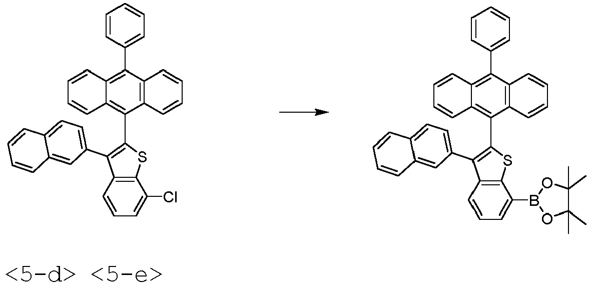

In a 1 L flask, <5-d> (30 g), bis(pinacolato)diboron (16.7 g), palladium(II) dichloride(diphenylphosphinoferocene) (1.3 g), potassium acetate (16.2 g), X-phos (2.6 g), and 1,4-dioxane (300 mL) were stirred under reflux. After completion of the reaction, concentration in a vacuum and purification through column chromatography afforded <5-e>. (27 g, 77%)

### Synthesis Example 5-6 : Synthesis of [A-68]

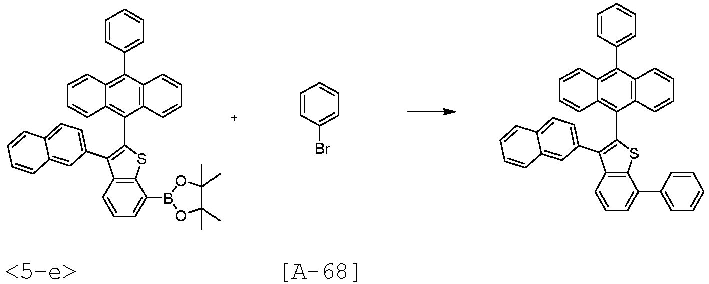

The same procedure as in Synthesis Example 1-3 was carried out, with the exception of using <5-e> and bromobenzene instead of <1-b> and 10-phenylanthracene-9-boronic acid, respectively to afford [A-68]. (yield 69%)
MS (MALDI-TOF) : m/z 588.19 [M⁺]

### SYNTHESIS EXAMPLE 6. Synthesis of [A-79]

### Synthesis Example 6-1 : Synthesis of 6-a

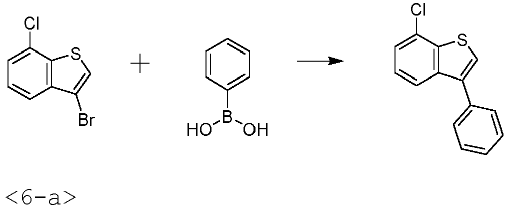

The same procedure as in Synthesis Example 5-2 was carried out, with the exception of using phenylboronic acid instead of 2-naphthylboronic acid, to afford <6-a>. (yield 70%)

### Synthesis Example 6-2 : Synthesis of 6-b

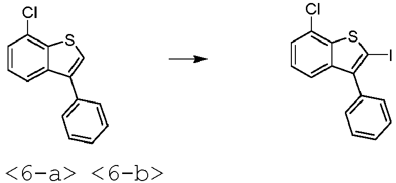

The same procedure as in Synthesis Example 4-4 was carried out, with the exception of using <6-a> instead of <4-c>, to afford <6-b>. (yield 70%)

### Synthesis Example 6-3 : Synthesis of 6-c

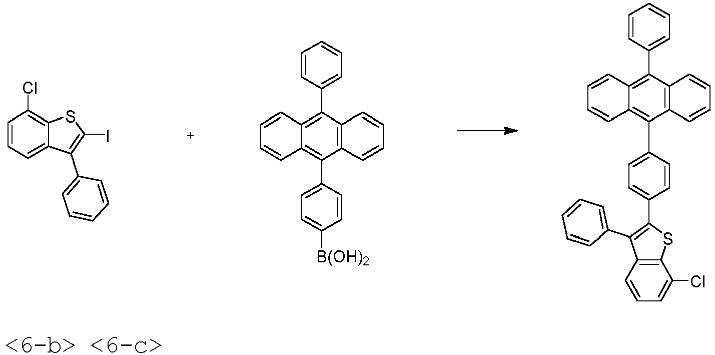

The same procedure as in Synthesis Example 1-3 was carried out, with the exception of using <6-b> and 4-(10-phenylanthracen-9-yl)benzeneboronic acid instead of <1-b> and 10-phenylanthracene-9-boronic acid, respectively, to afford <6-c>. (yield 65%)

### Synthesis Example 6-4 : Synthesis of 6-d

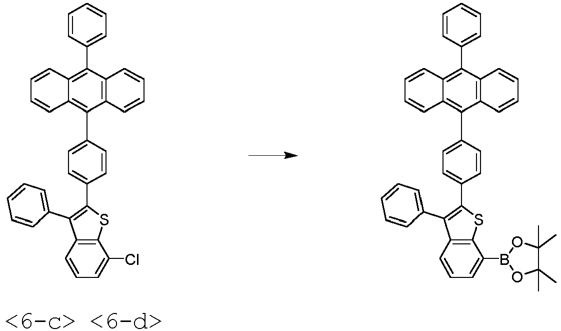

The same procedure as in Synthesis Example 5-5 was carried out, with the exception of using <6-c> instead of <5-d>, to afford <6-d>. (yield 72%)

### Synthesis Example 6-5 : Synthesis of [A-79]

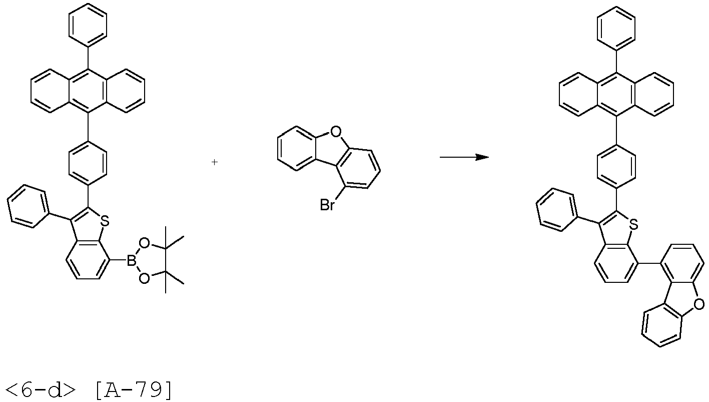

The same procedure as in Synthesis Example 1-3 was carried out, with the exception of using <6-d> and 1-bromodibenzo[b,d]furan instead of <1-b> and 10-phenylanthracene-9-boronic acid, respectively, to afford [A-79]. (yield 75%)
MS (MALDI-TOF) : m/z 704.22 [M⁺]

### SYNTHESIS EXAMPLE 7. Synthesis of A-89

### Synthesis Example 7-1 : Synthesis of 7-a

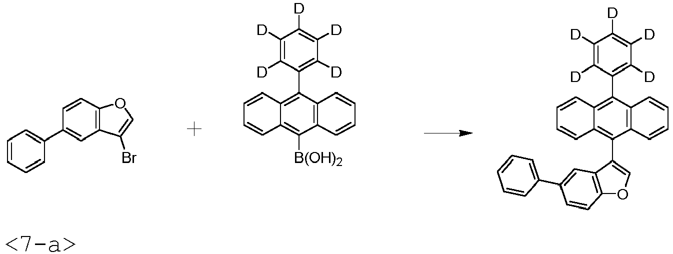

The same procedure as in Synthesis Example 1-3 was carried out, with the exception of using 3-bromo-5-phenylbenzofuran and 10-(phenyl-d5)-anthracene-9boronic acid instead of <1-b> and 10-phenylanthracene-9-boronic acid, respectively, to afford <7-a>. (yield 31%)

### Synthesis Example 7-2 : Synthesis of 7-b

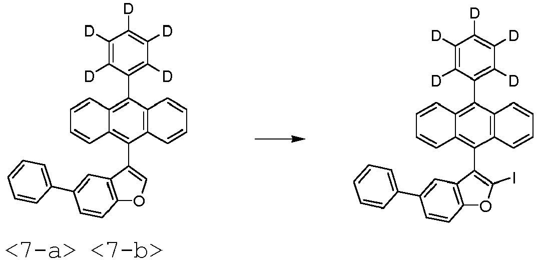

The same procedure as in Synthesis Example 4-4 was carried out, with the exception of using <7-a> instead of <4-c>, to afford <7-b>. (yield 71%)

### Synthesis Example 7-3 : Synthesis of [A-89]

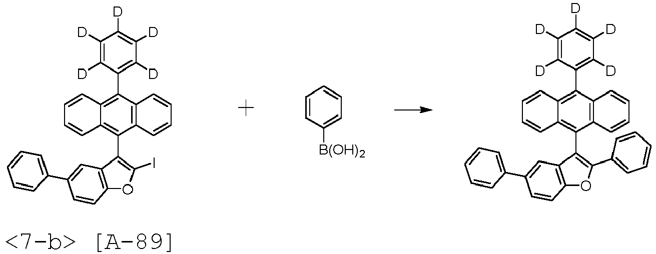

The same procedure as in Synthesis Example 1-3 was carried out, with the exception of using <7-b> and phenylboronic acid instead of <1-b> and 10-phenylanthracene-9-boronic acid, respectively, to afford [A-89]. (yield 51%)
MS (MALDI-TOF) : m/z 527.23 [M⁺]

### SYNTHESIS EXAMPLE 8. Synthesis of [A-90]

### Synthesis Example 8-1 : Synthesis of 8-a

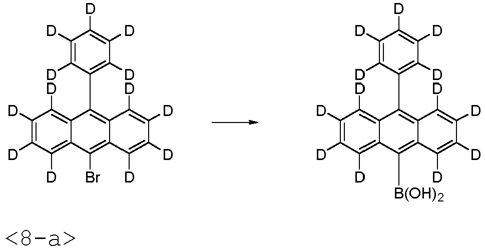

The same procedure as in Synthesis Example 2-4 was carried out, with the exception of using (anthracene-d8)-9-bromo-10-(phenyl-d5) instead of <2-c>, to afford <8-a>. (yield 55%)

### Synthesis Example 8-2 : Synthesis of 8-b

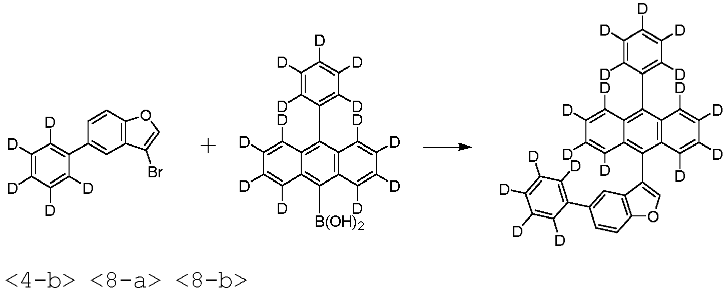

The same procedure as in Synthesis Example 4-3 was carried out, with the exception of using <8-a> instead of (4-(10-naphthalen-1-yl)anthracen-9-yl)benzeneboronic acid, to afford <8-b>. (yield 55%)

### Synthesis Example 8-3 : Synthesis of 8-c

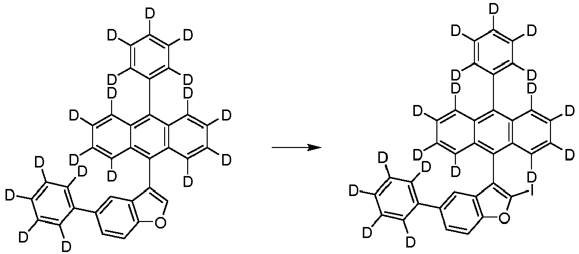

### <8-b> <8-c>

The same procedure as in Synthesis Example 4-4 was carried out, with the exception of using <8-b> instead of <4-c>, to afford <8-c>. (yield 67%)

### Synthesis Example 8-4 : Synthesis of [A-90]

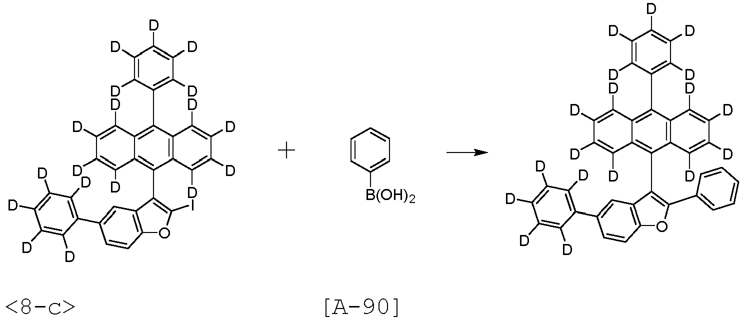

The same procedure as in Synthesis Example 7-3 was carried out, with the exception of using <8-c> instead of <7-b>, to afford [A-90]. (yield 47%)
MS (MALDI-TOF) : m/z 540.31 [M⁺]

### SYNTHESIS EXAMPLE 9. Synthesis of [A-91]

### Synthesis Example 9-1 : Synthesis of 9-a

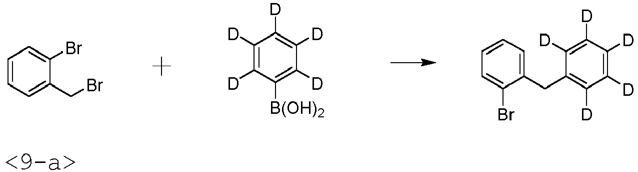

In a 500 ml reactor, bromobenzyl bromide (20 g), (phenyl-d5)boronic acid (10 g), sodium carbonate (10 g), and tetrakis(triphenylphosphine)palladium(0) (1.8 g) were stirred together at 50°C under reflux. After one hour, distilled water was added and stirred to form separated layers. The organic layer was isolated, filtered, washed with toluene, and concentrated in a vacuum. Thereafter, purification by column chromatography afforded <9-a> (16 g, 82%)

### Synthesis Example 9-2 : Synthesis of 9-b

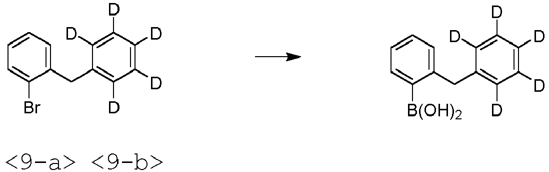

In a 500 ml reactor, a solution of <9-a> (20 g) in THF (200 mL) was chilled to -78°C and added with n-butyl lithium (1.6 M). Additionally, trimethylborate was slowly added and the temperature was slowly raised to room temperature. 2M HCl solution was added and stirred for 20 minutes to form separated layers. The organic layer was washed with distilled water and concentrated. Recrystallization in THF and heptane afforded <9-b> (11 g, 63%)

### Synthesis Example 9-3 : Synthesis of 9-c

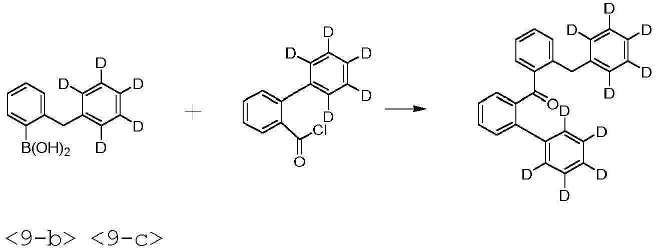

In a 500 ml reactor, <9-b> (15 g), cesium carbonate (34 g), tetrakis(triphenylphosphine)palladium(0) (2.4 g), and toluene (150 mL) were stirred together. Drops of 1,1'-(biphenyl-d5)-2-carbonyl chloride (20 g) were added, followed by refluxing at 110°C. After two hours, toluene and distilled water were added and stirred to form separated layers. The organic layer was isolated and concentrated in a vacuum, followed by purification through column chromatography to afford <9-c> (14 g, 57%) .

### Synthesis Example 9-4 : Synthesis of 9-d

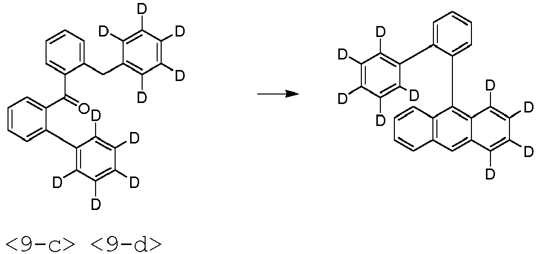

In a 500 ml reactor, <9-c> (20 g), In(OTf)₃ (3.1 g), and dichlorobenzene (120 mL) were stirred together at 110°C under reflux. After 24 hours, the reaction mixture was filtered at 50°C using Celite filter and washed with MC. The organic layer was isolated, concentrated in a vacuum, and purified by column chromatography. Then, recrystallization afforded <9-d> (8 g, 43%)

### Synthesis Example 9-5 : Synthesis of 9-e

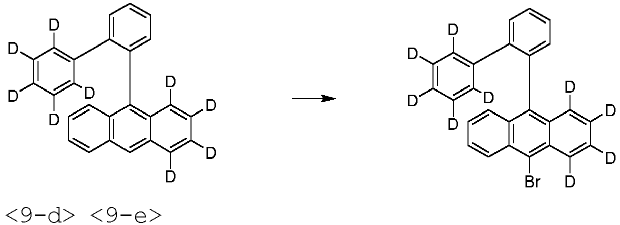

In a 500 ml reactor, a solution of <9-d> (30 g) in DMF (300 mL) was stirred, cooled to 0°C, and added with NBS (16 g) . The temperature was elevated to room temperature before stirring. After three hours, distilled water was added and stirred. After filtration and washing, purification was conducted by column chromatography. Thereafter, recrystallization in methanol afforded <9-e> (33 g, 89%)

### Synthesis Example 9-6 : Synthesis of 9-f

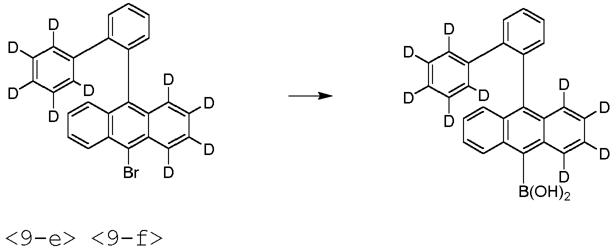

The same procedure as in Synthesis Example 2-4 was carried out, with the exception of using <9-e> instead of <2-c>, to afford <9-f>. (yield 53%)

### Synthesis Example 9-7 : Synthesis of [A-91]

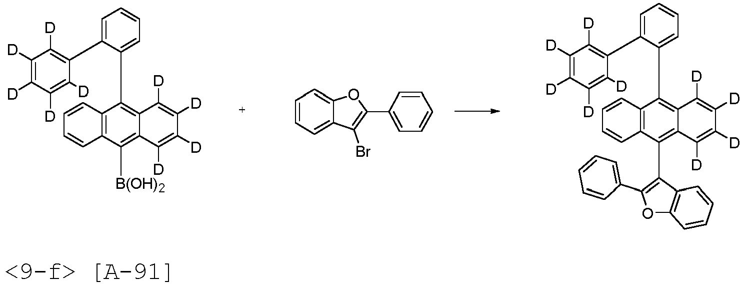

The same procedure as in Synthesis Example 1-3 was carried out, with the exception of using 3-bromo-2-phenylbenzofuran and <9-f> instead of <1-b> and 10-phenylanthracene-9-boronic acid, respectively, to afford [A-91]. (yield 52%)
MS (MALDI-TOF) : m/z 531.25 [M⁺]

### SYNTHESIS EXAMPLE 10. Synthesis of [A-92]

### Synthesis Example 10-1 : Synthesis of 10-a

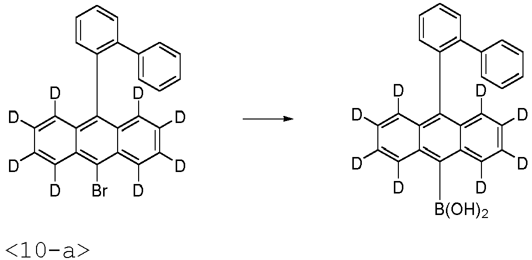

The same procedure as in Synthesis Example 2-4 was carried out, with the exception of using (anthracene-d8)-9-bromo-10-(1,1-biphenyl) instead of <2-c>, to afford <10-a>. (yield 52%)

### Synthesis Example 10-2 : Synthesis of 10-b

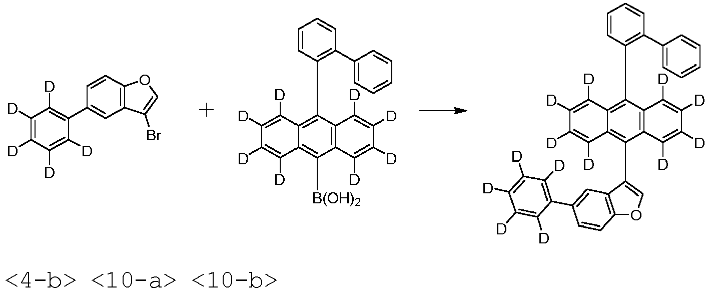

The same procedure as in Synthesis Example 4-3 was carried out, with the exception of using <10-a> instead of (4-(10-naphthalen-1-yl)anthracen-9-yl)benzeneboronic acid, to afford <10-b>. (yield 54%)

### Synthesis Example 10-3 : Synthesis of 10-c

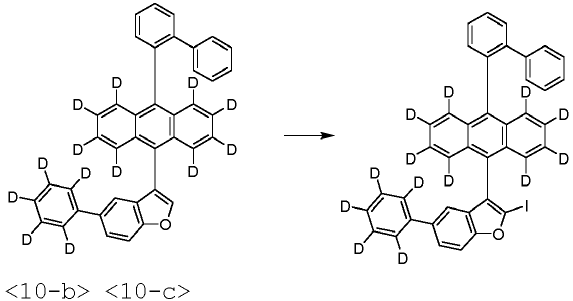

The same procedure as in Synthesis Example 4-4 was carried out, with the exception of using <10-b> instead of <4-c>, respectively, to afford <10-c>. (yield 64%)

### Synthesis Example 10-4 : Synthesis of [A-92]

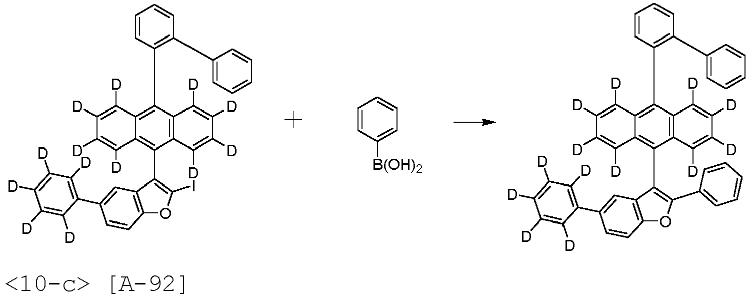

The same procedure as in Synthesis Example 7-3 was carried out, with the exception of using <10-c> instead of <7-b>, to afford [A-92]. (yield 45%)
MS (MALDI-TOF) : m/z 611.31 [M⁺]

### SYNTHESIS EXAMPLE 11. Synthesis of [A-116]

### Synthesis Example 11-1 : Synthesis of 11-a

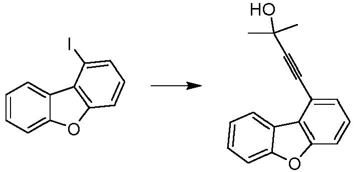

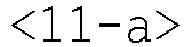

In a 500 mL flask, 1-iododibenzofuran (25 g), tetrakis(triphenylphosphine)palladium (0.98 g), and triethylamine (250 mL) were stirred together at room temperature, followed by adding drops of 2-methyl-3-buten-2-ol (8.3 mL). After completion of the reaction, an excess of heptane was added and the organic layer was concentrated in a vacuum to afford <11-a>. (15.3 g, 72%)

### Synthesis Example 11-2 : Synthesis of 11-b

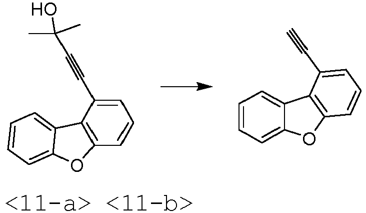

In a 500 mL flask, a solution of <11-a> (15.3 g) in toluene (100 mL) was heated to 70-75°C under a nitrogen atmosphere. Tetrabutylammonium hydroxide (1.59 g) was added and stirred. 2 M HCl was added to terminate the reaction. Following extraction with ethyl acetate, the organic layer was concentrated in a vacuum and purified by column chromatography to afford <11-b>. (10.6 g, 90%)

### Synthesis Example 11-3 : Synthesis of 11-c

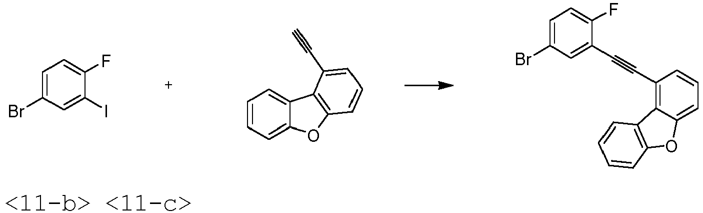

In a 300 mL flask, 1-bromo-4-fluoro-3-iodobenzene (17.8 g), tetrakis(triphenylphosphine)palladium (0.68 g), copper(I) iodide (0.56 g), and triethylamine (180 mL) were stirred together at room temperature, followed by adding drops of <11-b> (10.6 g). After completion of the reaction, the reaction mixture was added with an excess of heptane and filtered. The organic layer was concentrated in a vacuum and crystallization in heptane and filtration afforded <11-c> as a solid. (18.3 g, 85%)

### Synthesis Example 11-4 : Synthesis of 11-d

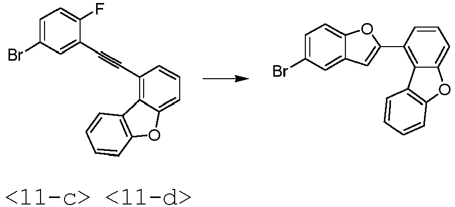

In a 500 mL flask, <11-c> (18.3 g), copper(I) iodide (0.95 g), potassium hydroxide (10.1 g), potassium iodide (1.66 g), and dimethyl sulfoxide (180 mL) were stirred together at 80-90°C. After completion of the reaction, the organic layer was concentrated in a vacuum and purification through column chromatography afforded <11-d>. (13.4 g, 74%)

### Synthesis Example 11-5 : Synthesis of [A-116]

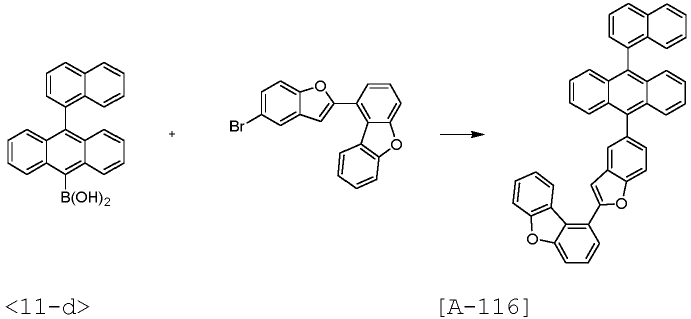

The same procedure as in Synthesis Example 1-3 was carried out, with the exception of using [10-naphthalen-1-yl)anthracen-9-yl]boronic acid and <11-d>instead of 10-phenylanthracene-9-boronic acid and <1-b>, respectively, to afford [A-116]. (yield 63%)
MS (MALDI-TOF) : m/z 586.19 [M⁺]

### SYNTHESIS EXAMPLE 12. Synthesis of [A-137]

### Synthesis Example 12-1 : Synthesis of [A-137]

The same procedure as in Synthesis Example 2-5 was carried out, with the exception of using 5-bromo-2-phenylbenzofuran instead of 2-bromo-3-phenylbenzofuran, to afford [A-137]. (yield 52%)
MS (MALDI-TOF) : m/z 455.22 [M⁺]

### SYNTHESIS EXAMPLE 13. [A-144]

### Synthesis Example 13-1 : Synthesis of 13-a

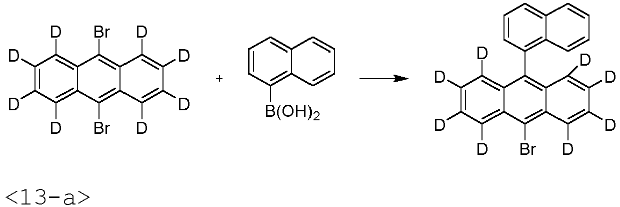

The same procedure as in Synthesis Example 1-3 was carried out, with the exception of using 9,10-dibromo(anthracene-d8) and 1-naphthaleneboronic acid instead of <1-b> and 10-phenylanthracene-9-boronic acid, respectively, to afford <13-a>. (yield 64%)

### Synthesis Example 13-2 : Synthesis of 13-b

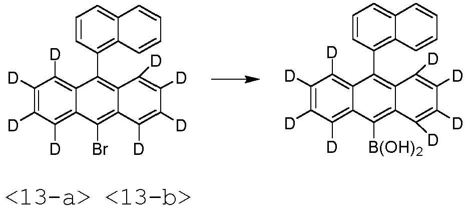

The same procedure as in Synthesis Example 2-4 was carried out, with the exception of using <13-a> instead of <2-c>, to afford <13-b>. (yield 75%)

### Synthesis Example 13-3 : Synthesis of 13-c

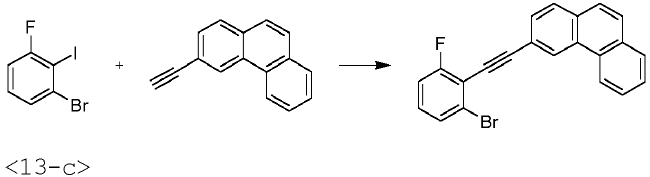

The same procedure as in Synthesis Example 11-3 was carried out, with the exception of using 1-bromo-3-fluoro-2-iodobenzene and 3-ethynyl phenanthrene instead of 1-bromo-4-fluoro-3-iodobenzene and <11-b>, respectively, to afford <13-c>. (yield 84%)

### Synthesis Example 13-4 : Synthesis of 13-d

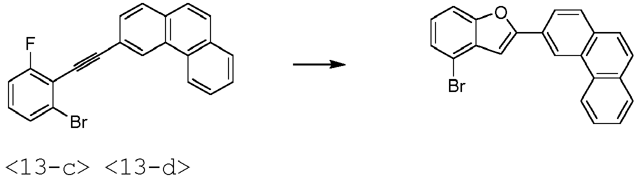

The same procedure as in Synthesis Example 11-4 was carried out, with the exception of using <13-c> instead of <11-c>, to afford <13-d>. (yield 79%)

### Synthesis Example 13-5 : Synthesis of [A-144]

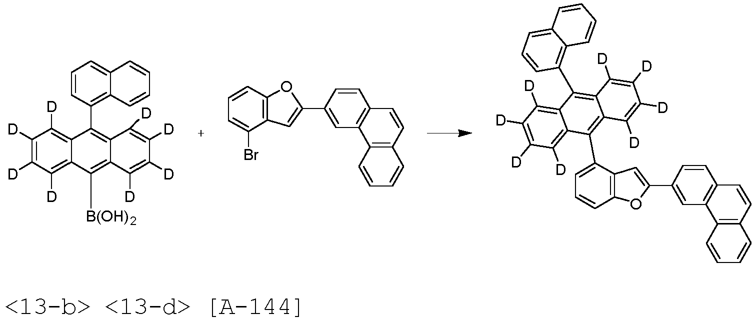

The same procedure as in Synthesis Example 1-3 was carried out, with the exception of using <13-d> and <13-b>instead of <1-b> and 10-phenylanthracene-9-boronic acid, respectively, to afford [A-144] . (yield 60%)
MS (MALDI-TOF) : m/z 604.26 [M⁺]

### EXAMPLES 1 TO 55 : Fabrication of Organic Light-Emitting Diode Having First and Second Light-Emitting Layers

An ITO glass substrate was patterned to have a translucent area of 2 mm x 2 mm and cleansed. The ITO glass was mounted in a vacuum chamber that was then set to have a base pressure of 1×10⁻⁷ torr. On the ITO glass substrate, films were sequentially formed of DNTPD (700 Å) and α-NPD (300 Å). Subsequently, a first and a second light-emitting layer were formed. In this regard, the first light-emitting layer (75 Å) was composed of a combination of the pyrene compound according to the present disclosure (compound represented by Chemical Formula B) and the boron dopant compound (1 wt%) according to the present disclosure while the second light-emitting layer (75 Å) was composed of a combination of the anthracene compound according to the present disclosure (compound represented by Chemical Formula A) and the boron compound (1 wt%) according to the present disclosure. Then, [Chemical Formula E-1] and [Chemical Formula E-2] were deposited at a weight ratio of 1:1 to form an electron transport layer (300 Å) on which an electron injection layer of [Chemical Formula E-2] (10 Å) was formed and then covered with an Al layer (1,000 Å) to fabricate an organic light-emitting diode. The organic light-emitting diodes thus obtained were measured at 10 mA/cm² for luminescence properties.

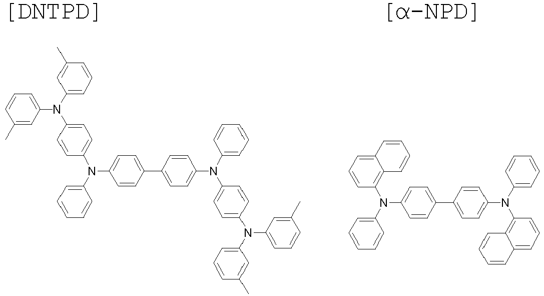

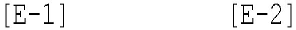

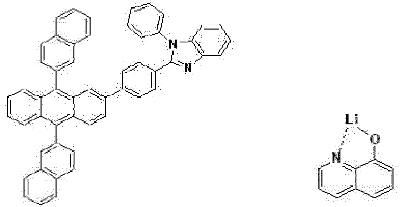

### COMPARATIVE EXAMPLES 1 TO 12

Organic light emitting diodes were fabricated in the same manner as in the Examples, with the exception of using [BH1] and [BH2] as hosts instead of the compounds according to the present disclosure. The luminescence of the organic light-emitting diodes thus obtained was measured at 10 mA/cm². Structures of compounds [BH1] and [BH2] are as follows:

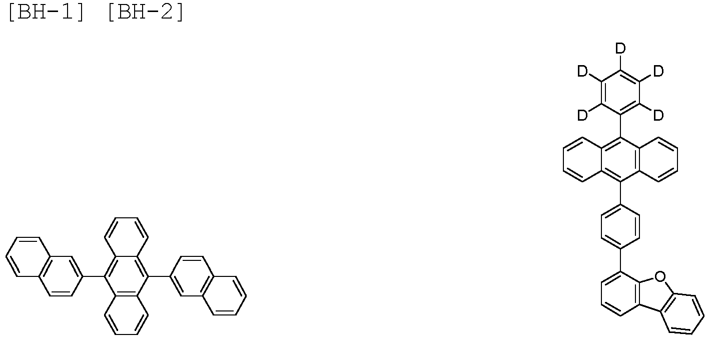

**TABLE 1**

| | 1^{st} Light-emitting layer | | 2^{nd} Light-emitting layer | | V | EQE | LT97 |
|---|---|---|---|---|---|---|---|
| | Host | Dopant | Host | Dopant | | | |
| Ex. 1 | B-4 | D-211 | A-20 | D-211 | 3.7 | 13.8 | 327 |
| Ex. 2 | B-4 | D-211 | A-30 | D-211 | 3.6 | 12.3 | 315 |
| Ex. 3 | B-4 | D-211 | A-57 | D-211 | 3.7 | 13.2 | 321 |
| Ex. 4 | B-4 | D-211 | A-58 | D-211 | 3.6 | 13.5 | 325 |
| Ex. 5 | B-4 | D-211 | A-68 | D-211 | 3.6 | 12.4 | 305 |
| Ex. 6 | B-4 | D-211 | A-79 | D-211 | 3.7 | 12.9 | 317 |
| Ex. 7 | B-4 | D-211 | A-89 | D-211 | 3.6 | 14.0 | 343 |
| Ex. 8 | B-4 | D-211 | A-90 | D-211 | 3.6 | 14.1 | 352 |
| Ex. 9 | B-4 | D-211 | A-91 | D-211 | 3.7 | 13.9 | 339 |
| Ex. 10 | B-4 | D-211 | A-92 | D-211 | 3.6 | 13.7 | 349 |
| Ex. 11 | B-4 | D-211 | A-137 | D-211 | 3.6 | 12.8 | 329 |
| Ex. 12 | B-4 | D-211 | A-144 | D-211 | 3.7 | 12.5 | 324 |
| Ex. 13 | B-4 | D-892 | A-20 | D-892 | 3.7 | 12.6 | 306 |
| Ex. 14 | B-4 | D-892 | A-30 | D-892 | 3.7 | 11.5 | 298 |
| Ex. 15 | B-4 | D-892 | A-57 | D-892 | 3.7 | 12.4 | 303 |
| Ex. 16 | B-4 | D-892 | A-58 | D-892 | 3.6 | 12.2 | 308 |
| Ex. 17 | B-4 | D-892 | A-68 | D-892 | 3.6 | 11.4 | 291 |
| Ex. 18 | B-4 | D-892 | A-79 | D-892 | 3.8 | 12.2 | 299 |
| Ex. 19 | B-4 | D-892 | A-89 | D-892 | 3.6 | 12.7 | 315 |
| Ex. 20 | B-4 | D-892 | A-90 | D-892 | 3.7 | 12.7 | 325 |
| Ex. 21 | B-4 | D-892 | A-91 | D-892 | 3.7 | 12.8 | 321 |
| Ex. 22 | B-4 | D-892 | A-92 | D-892 | 3.6 | 12.6 | 316 |
| Ex. 23 | B-4 | D-892 | A-137 | D-892 | 3.7 | 12.0 | 309 |
| Ex. 24 | B-4 | D-892 | A-144 | D-892 | 3.8 | 11.9 | 312 |
| Ex. 25 | B-26 | D-211 | A-20 | D-211 | 3.7 | 13.7 | 329 |
| Ex. 26 | B-26 | D-211 | A-30 | D-211 | 3.6 | 12.4 | 312 |
| Ex. 27 | B-26 | D-211 | A-57 | D-211 | 3.8 | 13.1 | 319 |
| Ex. 28 | B-26 | D-211 | A-58 | D-211 | 3.7 | 13.7 | 327 |
| Ex. 29 | B-26 | D-211 | A-68 | D-211 | 3.6 | 12.1 | 302 |
| Ex. 30 | B-26 | D-211 | A-79 | D-211 | 3.7 | 13.1 | 321 |
| Ex. 31 | B-26 | D-211 | A-89 | D-211 | 3.6 | 14.0 | 336 |
| Ex. 32 | B-26 | D-211 | A-90 | D-211 | 3.6 | 14.1 | 350 |
| Ex. 33 | B-26 | D-211 | A-91 | D-211 | 3.7 | 14.0 | 342 |
| Ex. 34 | B-26 | D-211 | A-92 | D-211 | 3.6 | 13.9 | 353 |
| Ex. 35 | B-26 | D-211 | A-137 | D-211 | 3.6 | 13.0 | 331 |
| Ex. 36 | B-26 | D-211 | A-144 | D-211 | 3.7 | 12.9 | 330 |
| Ex. 37 | B-26 | D-892 | A-20 | D-892 | 3.7 | 12.8 | 310 |
| Ex. 38 | B-26 | D-892 | A-30 | D-892 | 3.6 | 11.7 | 305 |
| Ex. 39 | B-26 | D-892 | A-57 | D-892 | 3.8 | 12.4 | 302 |
| Ex. 40 | B-26 | D-892 | A-58 | D-892 | 3.7 | 12.5 | 312 |
| Ex. 41 | B-26 | D-892 | A-68 | D-892 | 3.6 | 11.5 | 293 |
| Ex. 42 | B-26 | D-892 | A-79 | D-892 | 3.7 | 12.1 | 303 |
| Ex. 43 | B-26 | D-892 | A-89 | D-892 | 3.7 | 12.8 | 313 |
| Ex. 44 | B-26 | D-892 | A-90 | D-892 | 3.7 | 12.8 | 322 |
| Ex. 45 | B-26 | D-892 | A-91 | D-892 | 3.7 | 12.9 | 316 |
| Ex. 46 | B-26 | D-892 | A-92 | D-892 | 3.7 | 12.8 | 314 |
| Ex. 47 | B-26 | D-892 | A-137 | D-892 | 3.7 | 12.1 | 311 |
| Ex. 48 | B-26 | D-892 | A-144 | D-892 | 3.7 | 12.2 | 308 |
| Ex. 49 | B-26 | D-401 | A-20 | D-401 | 3.7 | 13.0 | 320 |
| Ex. 50 | B-26 | D-401 | A-89 | D-401 | 3.6 | 13.2 | 324 |
| Ex. 51 | B-26 | D-401 | A-90 | D-401 | 3.6 | 13.3 | 327 |
| Ex. 52 | B-26 | D-401 | A-91 | D-401 | 3.6 | 13.3 | 330 |
| Ex. 53 | B-26 | D-401 | A-92 | D-401 | 3.7 | 13.1 | 333 |
| Ex. 54 | B-4 | D-211 | A-90 | D-401 | 3.7 | 13.8 | 324 |
| Ex. 55 | B-4 | D-401 | A-91 | D-211 | 3.7 | 13.7 | 331 |
| C. Ex. 1 | B-4 | D-211 | BH-1 | D-211 | 3.9 | 18.5 | 206 |
| C. Ex. 2 | B-4 | D-211 | BH-2 | D-211 | 3.9 | 19.1 | 214 |
| C. Ex. 3 | B-4 | D-401 | BH-1 | D-401 | 4.0 | 7.6 | 189 |
| C. Ex. 4 | B-4 | D-401 | BH-2 | D-401 | 3.9 | 18.2 | 196 |
| C. Ex. 5 | B-4 | D-892 | BH-1 | D-892 | 4.1 | 7.4 | 172 |
| C. Ex. 6 | B-4 | D-892 | BH-2 | D-892 | 4.0 | 7.9 | 188 |
| C. Ex. 7 | B-26 | D-211 | BH-1 | D-211 | 3.9 | 18.3 | 211 |
| C. Ex. 8 | B-26 | D-211 | BH-2 | D-211 | 3.9 | 19.3 | 218 |
| C. Ex. 9 | B-26 | D-401 | BH-1 | D-401 | 3.9 | 7.7 | 193 |
| C. Ex. 10 | B-26 | D-401 | BH-2 | D-401 | 4.0 | 8.0 | 199 |
| C. Ex. 11 | B-26 | D-892 | BH-1 | D-892 | 4.1 | 7.5 | 175 |
| C. Ex. 12 | B-26 | D-892 | BH-2 | D-892 | 4.0 | 7.9 | 186 |

As is understood from data of Table 1, the organic light-emitting compounds employing as host compounds the compounds represented by Chemical Formula A according to the present disclosure exhibited significantly improved longevity with high emission efficiency and low driving voltage properties, compared to those according to Comparative Examples ([BH-1] and [BH-2]).

### Industrial Applicability

Compared to conventional OLEDs, the OLEDs employing the compounds represented by Chemical Formula A according to the present disclosure can be driven at low voltage with improved emission efficiency and longevity properties and thus can be highly applicable in organic light-emitting diodes and related industries.

## Claims

1. An organic light-emitting diode, comprising:
a first electrode; and
a second electrode facing the first electrode,
wherein a first light-emitting layer containing a first host and a first dopant and a second light-emitting layer containing a second host and a second dopant are sequentially interposed between the first electrode and the second electrode, and
at least one of the first host and the second host comprises at least one of the compounds represented by the following Chemical Formula A: 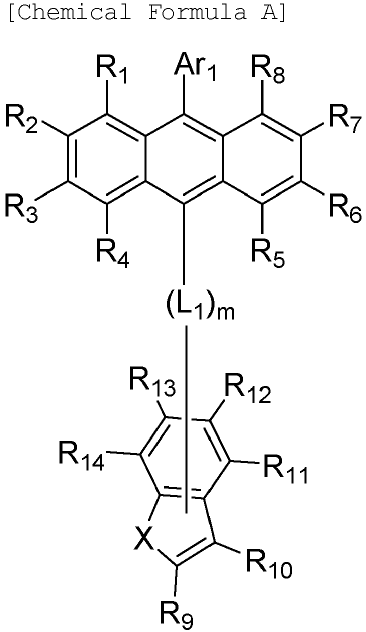
wherein,
Ar₁ is any one substituent selected from a substituted or unsubstituted aryl of 6 to 50 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, and a substituted or unsubstituted aliphatic hydrocarbon ring-fused heteroaryl of 5 to 30 carbon atoms,
R₁ to R₁₄, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted amine of 0 to 30 carbon atoms, a substituted or unsubstituted silyl of 0 to 30 carbon atoms, a germanium of 0 to 30 carbon atoms, a cyano, a nitro, and a halogen, with one of R₉ to R₁₄ being a single bond to L₁,
X is an oxygen atom (O) or a sulfur atom (S),
L₁, which functions as a linker, is a single bond or any one selected from a substituted or unsubstituted arylene of 6 to 20 carbon atoms and a substituted or unsubstituted heteroarylene of 2 to 20 carbon atoms,
m is an integer of 1 to 3, wherein when m is 2 or higher, the corresponding L₁'s are same or different,
wherein the term "substituted" in the expression "substituted or unsubstituted" used for compounds of Chemical Formula A means having at least one substituent selected from the group consisting of a deuterium atom, a cyano, a halogen, a hydroxy, a nitro, an alkyl of 1 to 24 carbon atoms, a halogenated alkyl of 1 to 24 carbon atoms, a cycloalkyl of 3 to 30 carbon atoms, an alkenyl of 2 to 24 carbon atoms, an alkynyl of 2 to 24 carbon atoms, a heteroalkyl of 1 to 24 carbon atoms, an aryl of 6 to 24 carbon atoms, an arylalkyl of 7 to 24 carbon atoms, an alkylaryl of 7 to 24 carbon atoms, a heteroaryl of 2 to 24 carbon atoms, a heteroarylalkyl of 2 to 24 carbon atoms, an alkoxy of 1 to 24 carbon atoms, an amine of 1 to 24 carbon atoms, a silyl of 1 to 24 carbon atoms, a germanium of 1 to 24 carbon atoms, an aryloxy of 6 to 24 carbon atoms, and an arylthionyl of 6 to 24 carbon atoms.

2. The organic light-emitting diode of claim 1, wherein the compound represented by Chemical Formula A is any one anthracene derivative represented by the following Chemical Formulas A-1 to A-6: 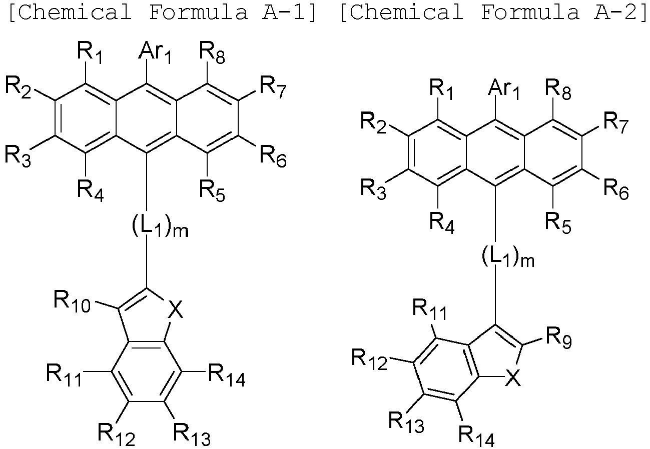 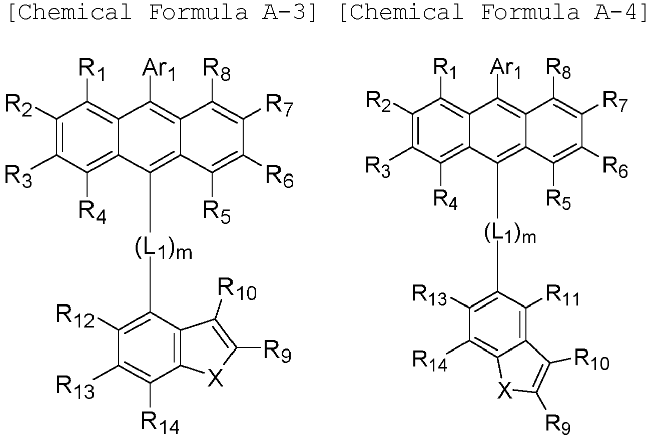 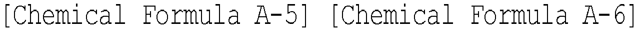 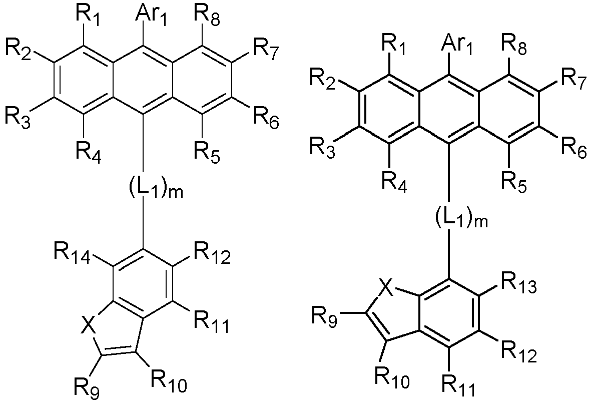 wherein,
Ar₁, R₁ to R₁₄, L₁, X, and m are each as defined in Chemical Formula A above,

3. The organic light-emitting diode of claim 1, wherein the compound represented by Chemical Formula A contains at least one deuterium atom.

4. The organic light-emitting diode of claim 2, wherein at least one of R₁₁ to R₁₄ in the anthracene derivatives represented by Chemical Formulas A-1 and A-2 is any one selected from a substituted or unsubstituted aryl of 6 to 20 carbon atoms, a substituted or unsubstituted cycloalkyl of 3 to 20 carbon atoms, a substituted or unsubstituted heteroaryl of 3 to 20 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aliphatic hydrocarbon ring-fused aryl of 8 to 30 carbon atoms, andlQ a substituted or unsubstituted aliphatic hydrocarbon ring-fused heteroaryl of 5 to 30 carbon atoms.

5. The organic light-emitting diode of claim 4, wherein at least one of R₁₁ to R₁₄ in the anthracene derivatives represented by Chemical Formulas A-1 and A-2 is a deuterated or undeuterated aryl of 6 to 20 carbon atoms deuterium atom.

6. The organic light-emitting diode of claim 1, wherein L₁ in Chemical Formula A functions as a linker and is a single bond or a substituted or unsubstituted arylene of 6 to 18 carbon atoms.

7. The organic light-emitting diode of claim 6, wherein the linker L₁ in Chemical Formula A is a single bond or any one selected from the following Structural Formulas 1 to 5: 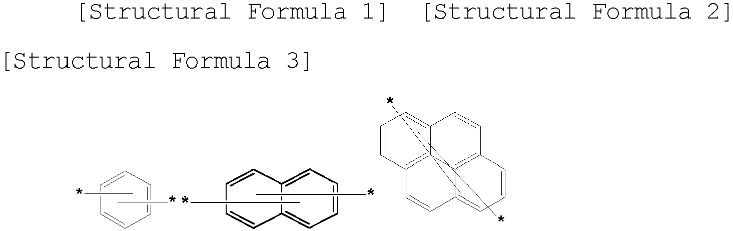 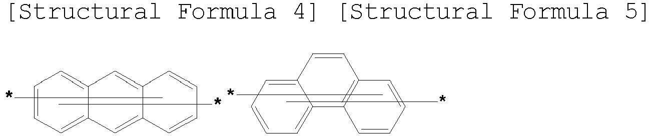 wherein each of the unsubstituted carbon atoms of the aromatic ring moiety is bound with a hydrogen atom or a deuterium atom.

8. The organic light-emitting diode of claim 1, wherein Ar₁ in Chemical Formula A is a substituted or unsubstituted aryl of 6 to 18 carbon atoms.

9. The organic light-emitting diode of claim 8, wherein Ar₁ in Chemical Formula A is an aryl of 6 to 18 carbon atoms with or without a substituent selected from a deuterium atom, a phenyl, and a naphthyl.

10. The organic light-emitting diode of claim 1, wherein R₁ to R₈ in Chemical Formula A are same or different and are each independently a hydrogen atom or a deuterium atom.

11. The organic light-emitting diode of claim 3, wherein the anthracene compound represented by Chemical Formula A has a degree of deuteration of 10% or higher.

12. The organic light-emitting diode of claim 3, wherein the anthracene compound represented by Chemical Formula A has a degree of deuteration of 30% or higher.

13. The organic light-emitting diode of claim 1, wherein R₉ or R₁₀ in the anthracene derivative represented by Chemical Formula A is a single bond to the linker L₁.

14. The organic light-emitting diode of claim 1, wherein the compound represented by Chemical Formula A is any one selected from the following Compounds A-1 to A-218:

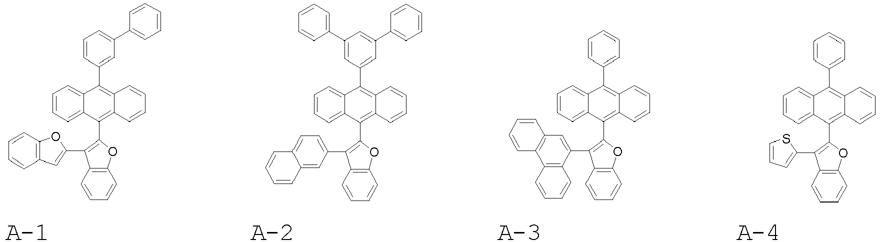

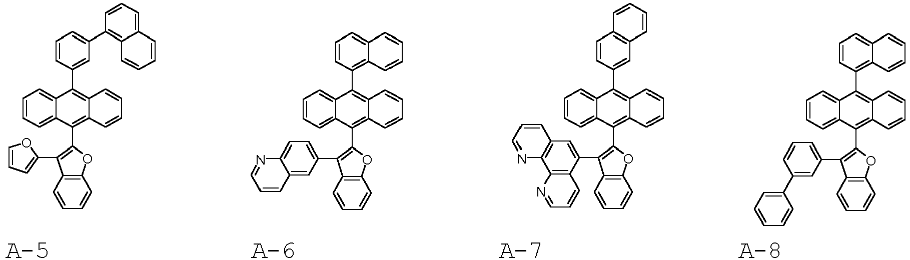

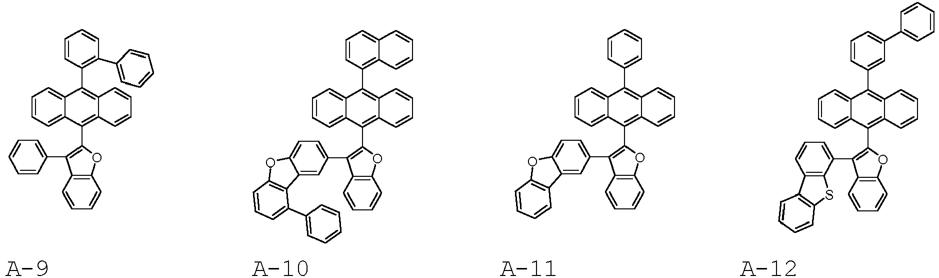

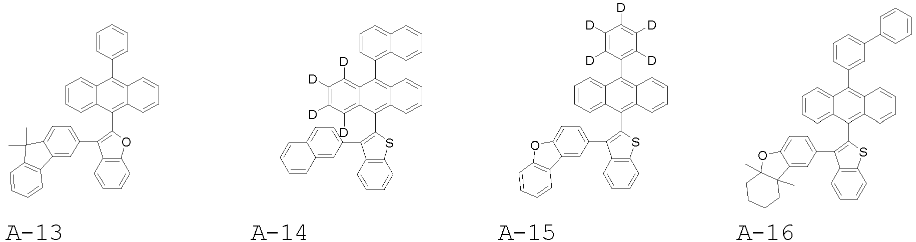

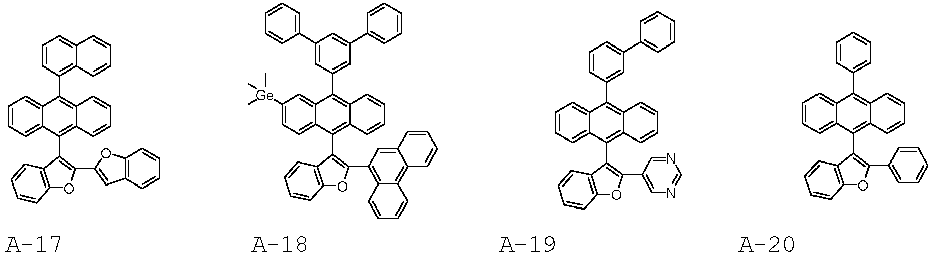

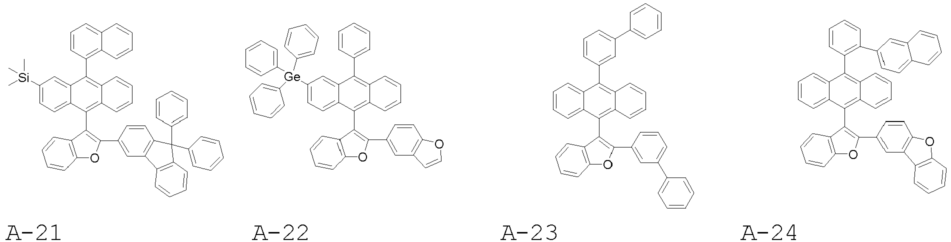

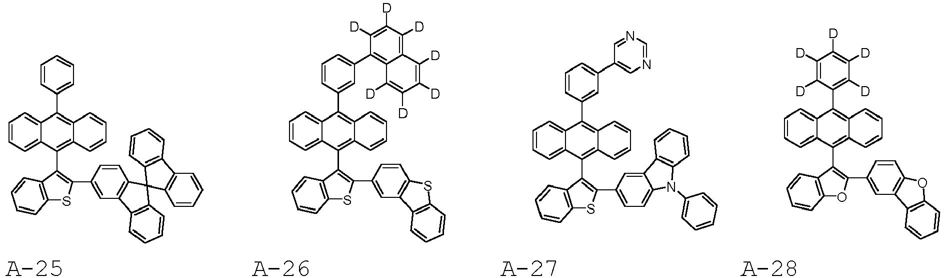

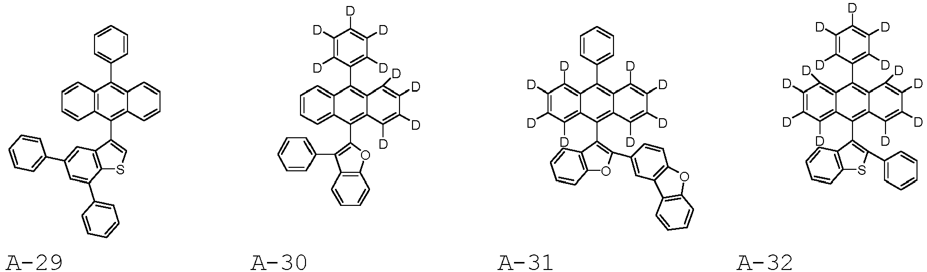

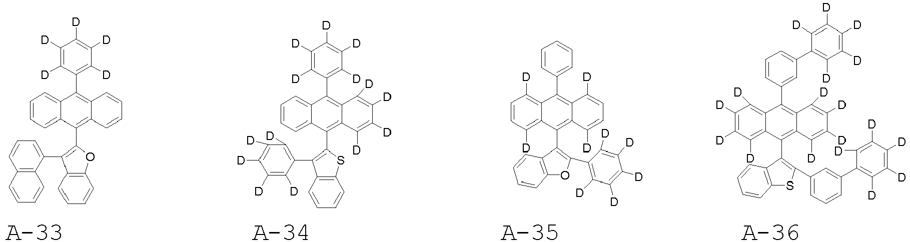

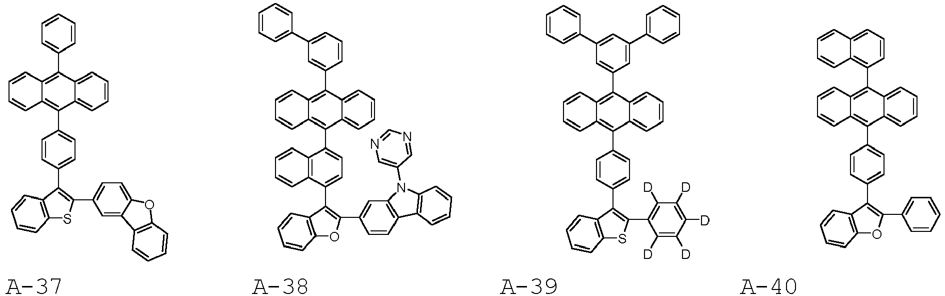

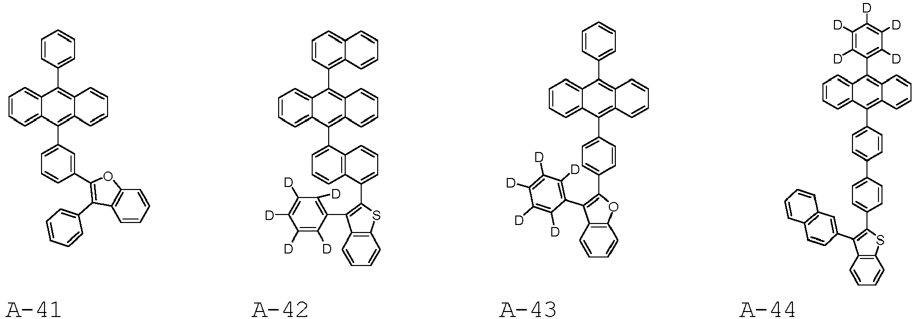

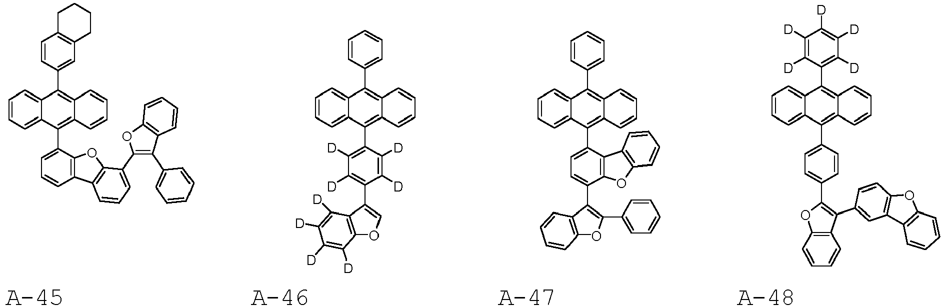

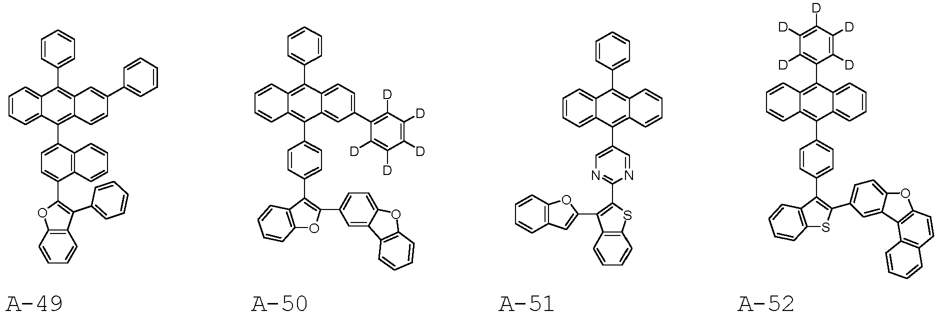

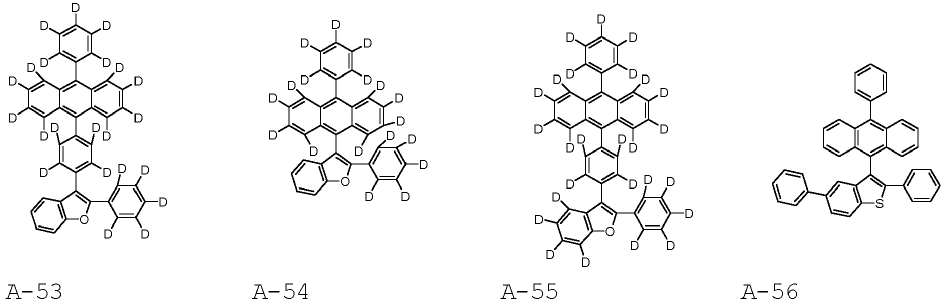

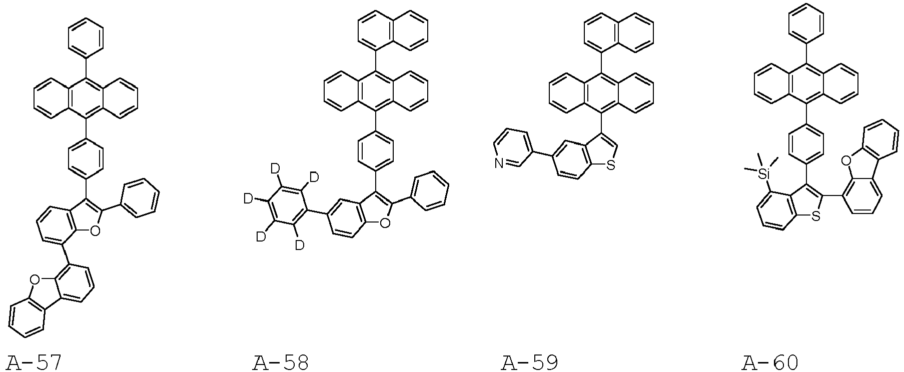

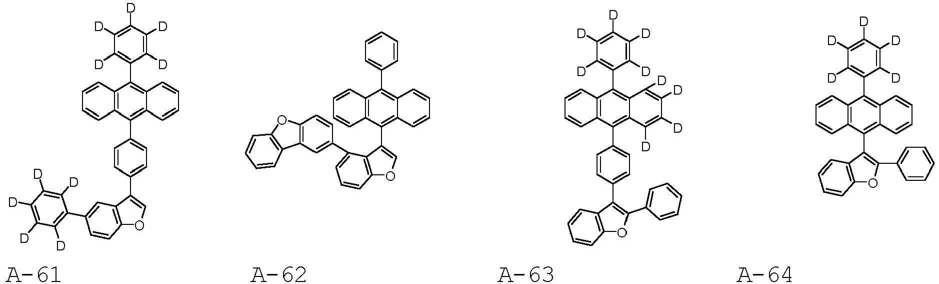

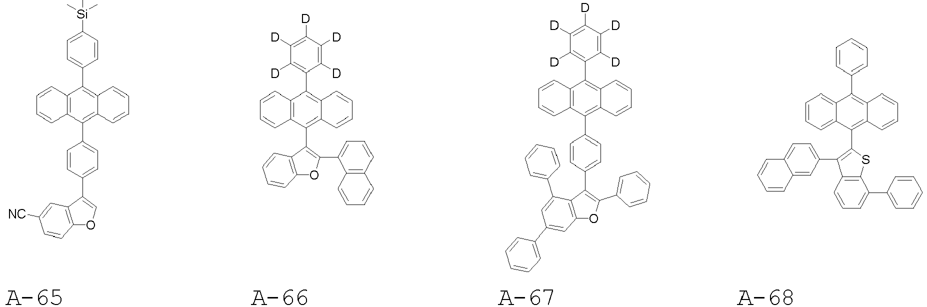

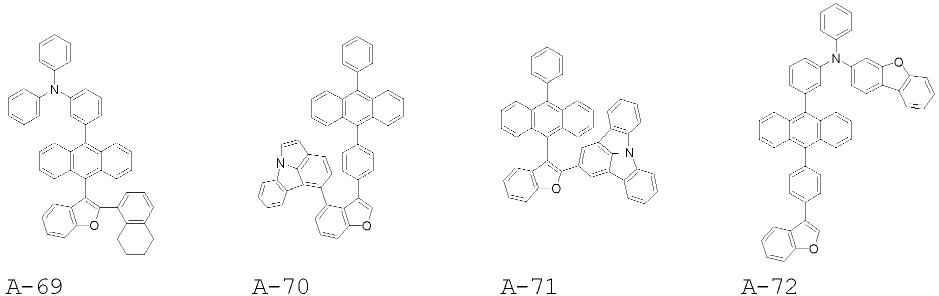

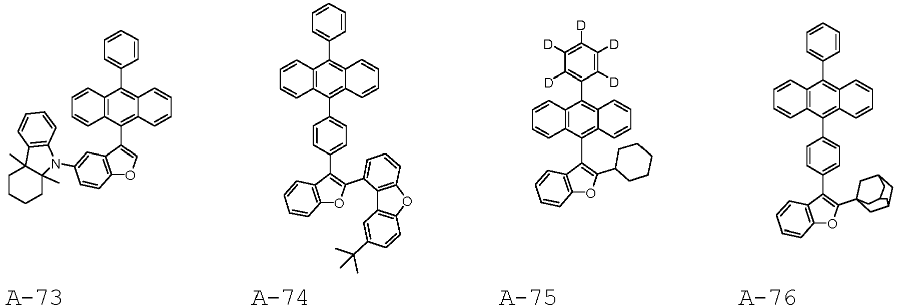

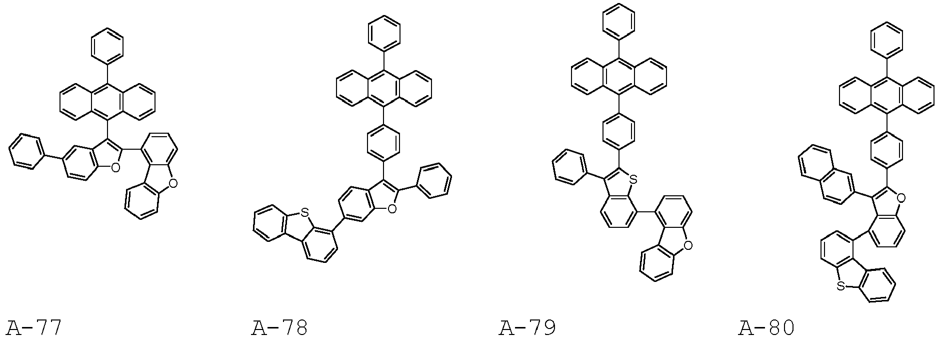

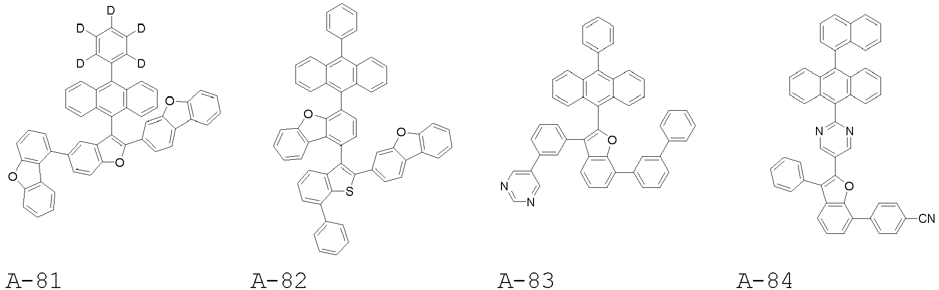

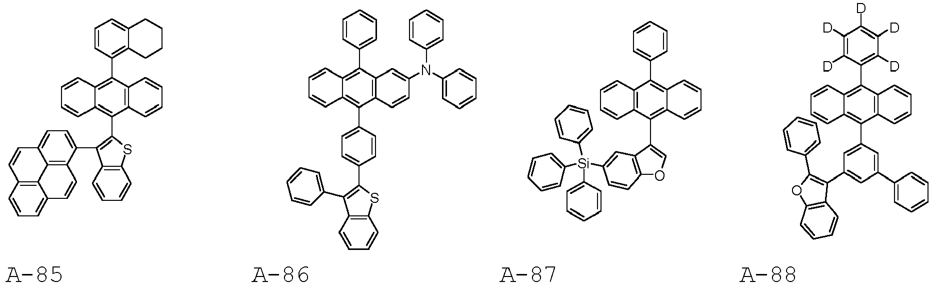

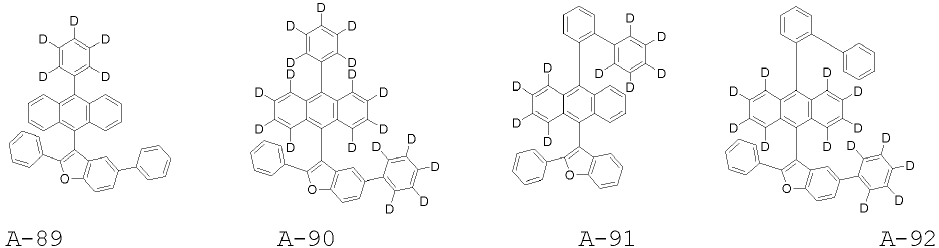

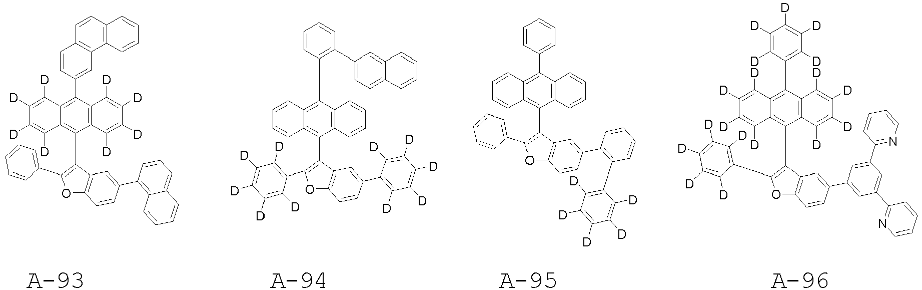

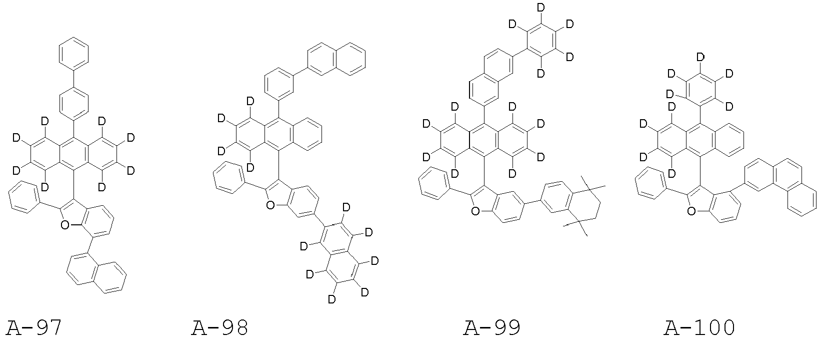

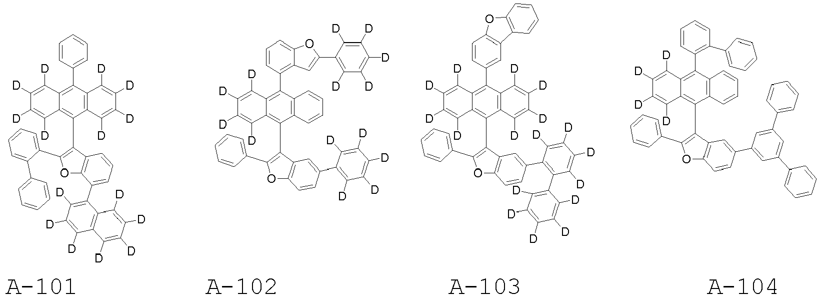

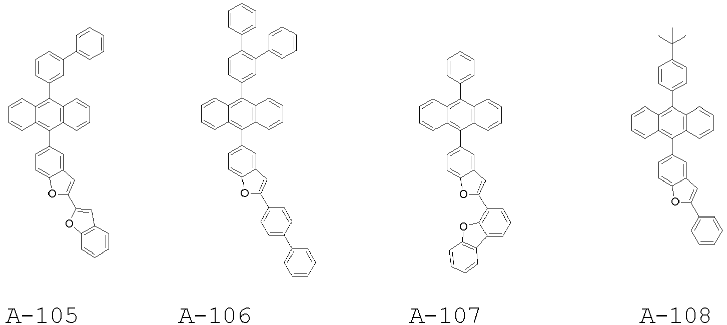

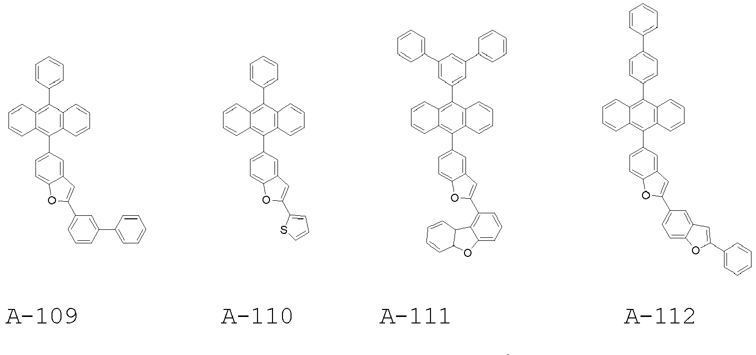

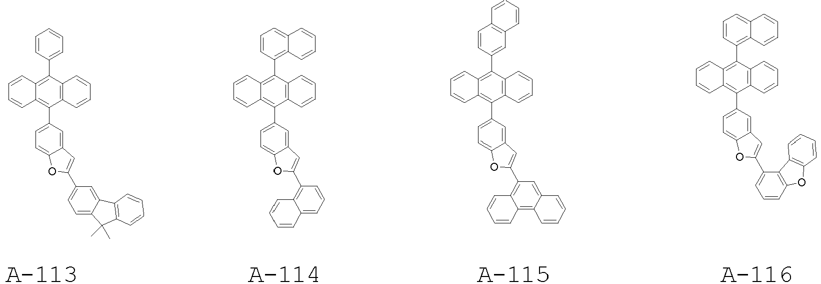

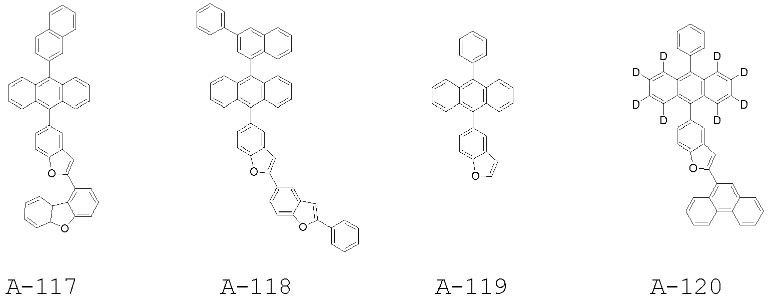

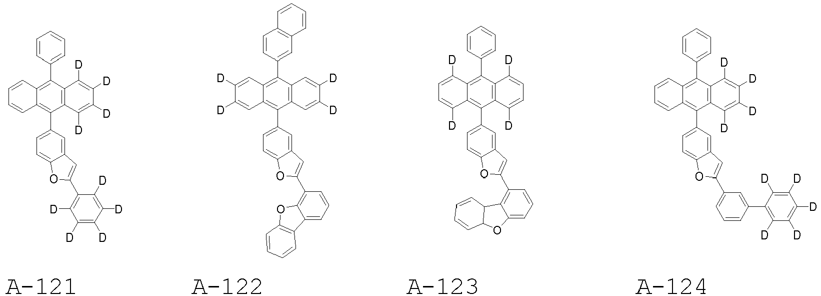

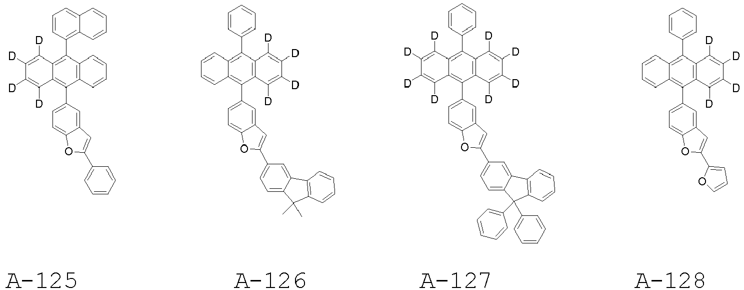

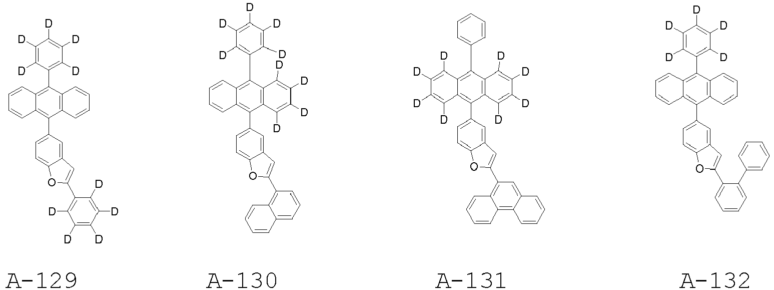

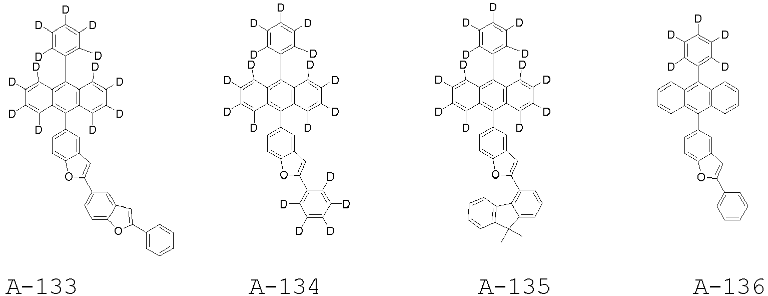

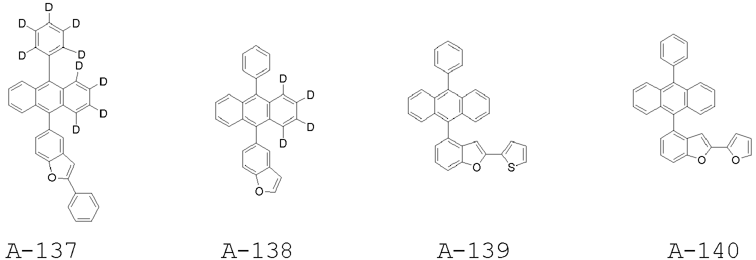

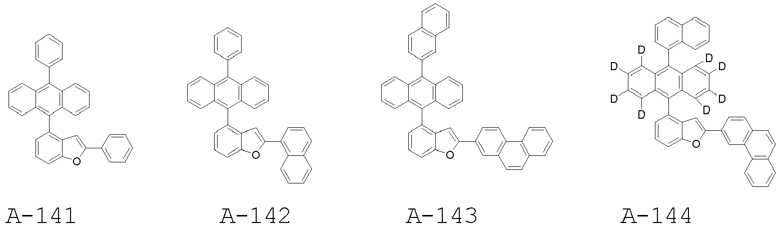

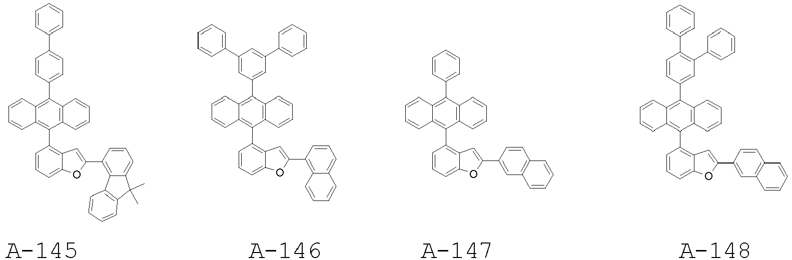

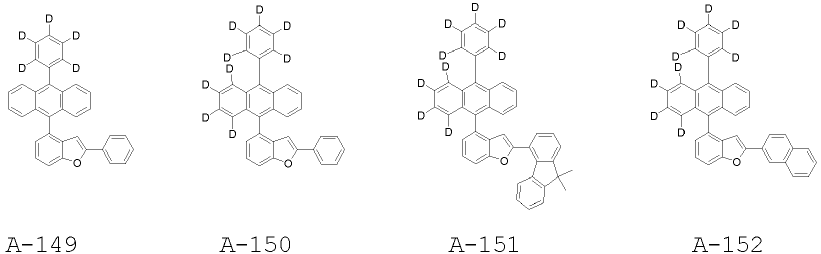

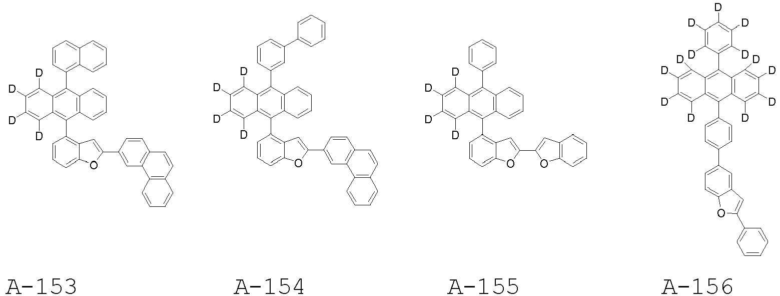

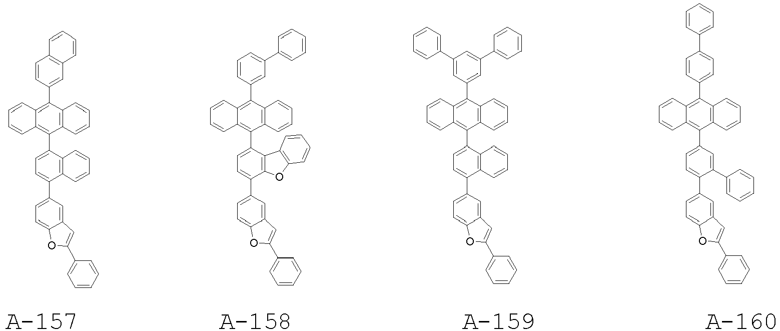

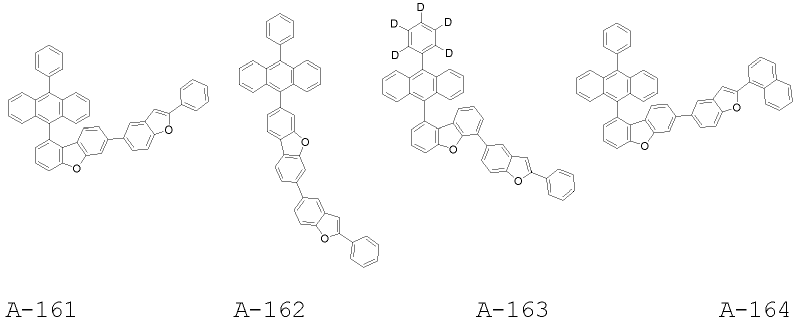

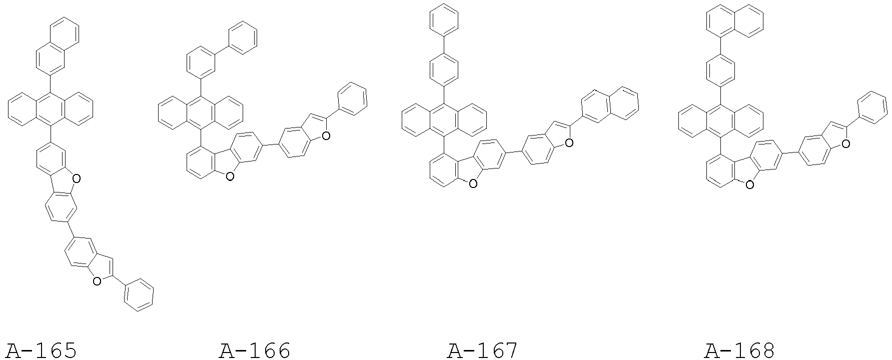

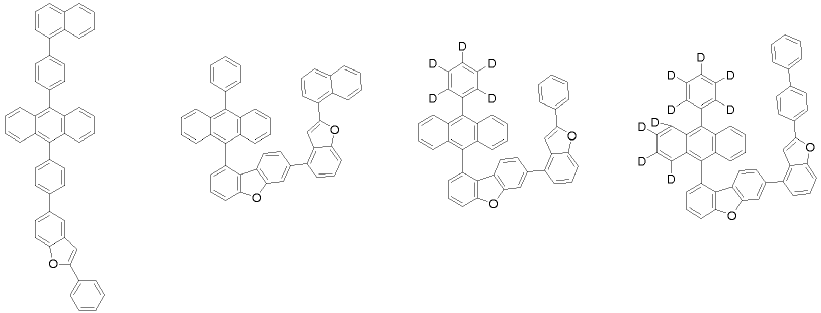

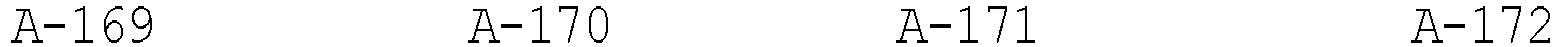

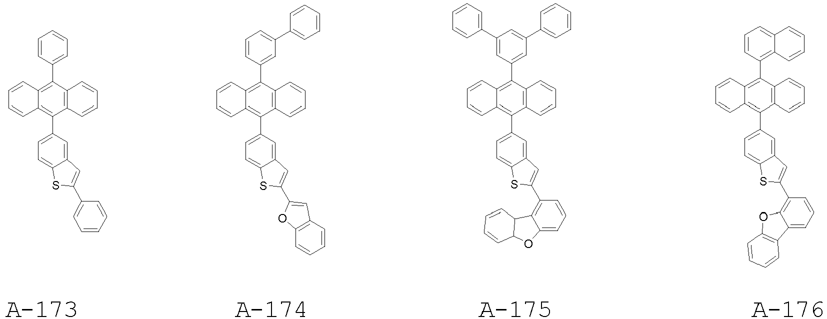

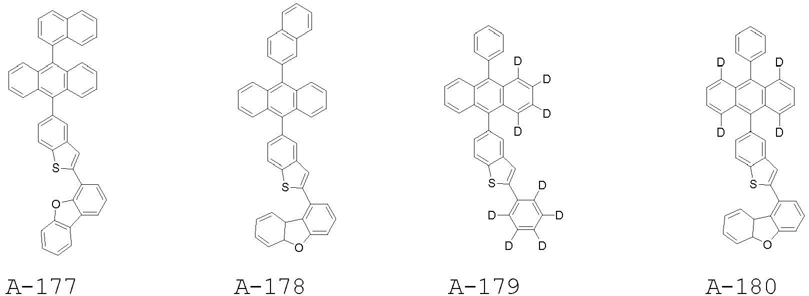

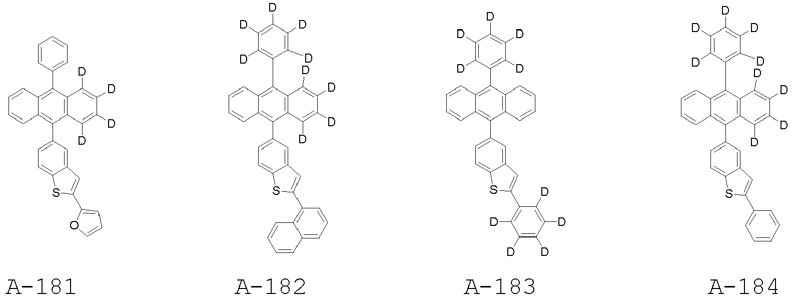

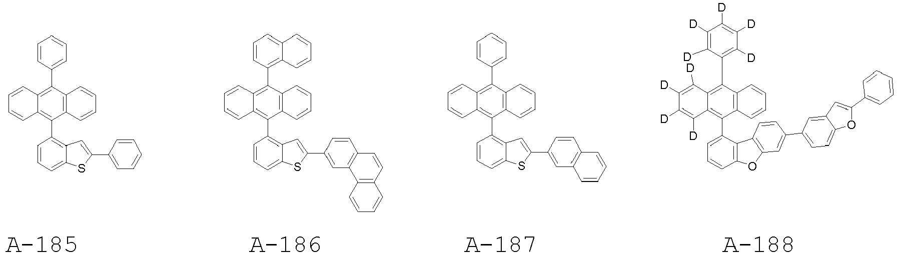

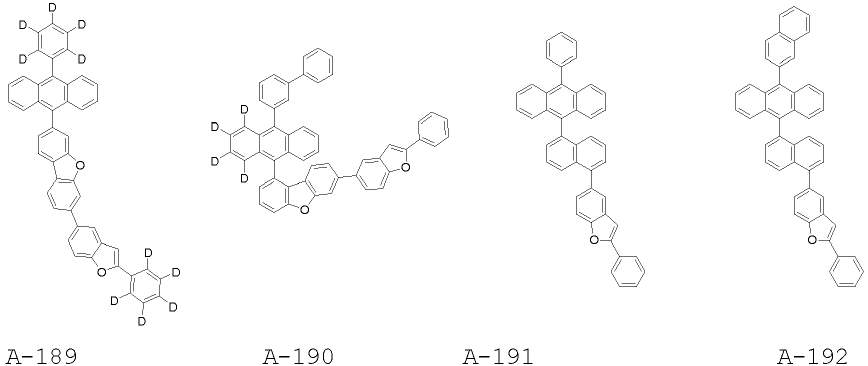

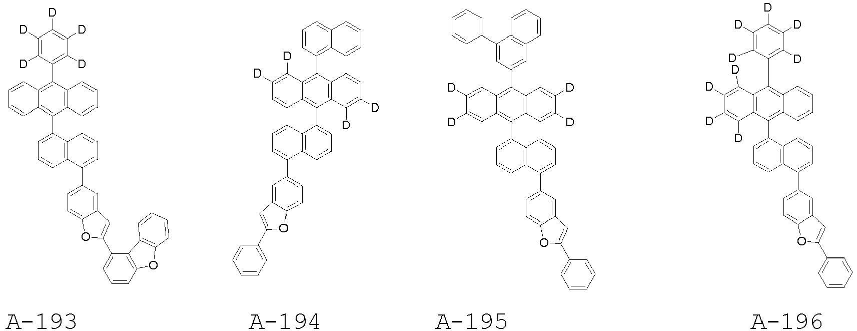

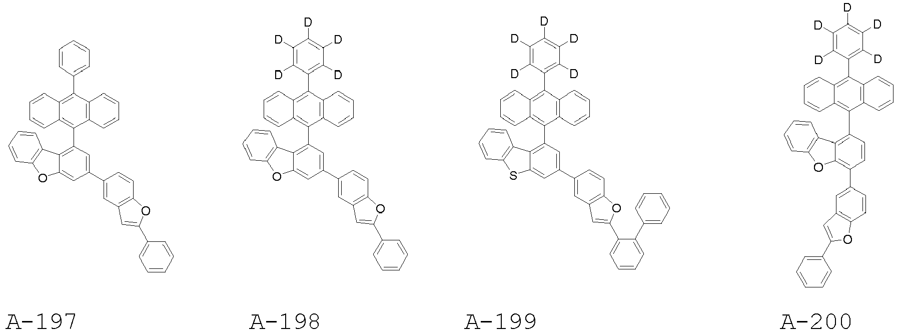

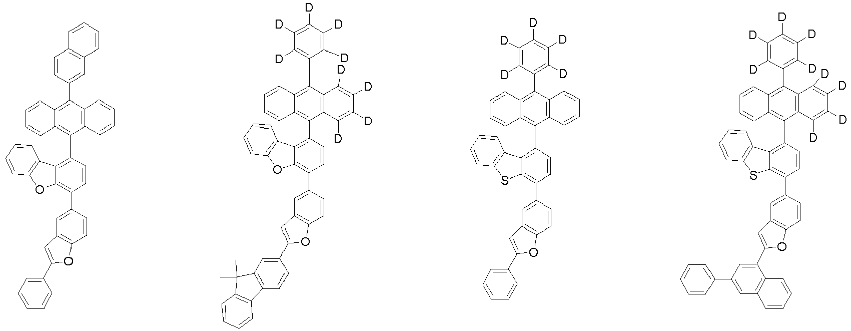

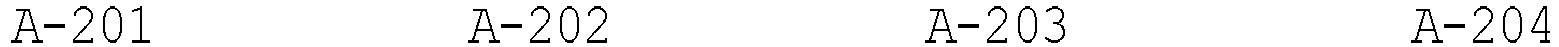

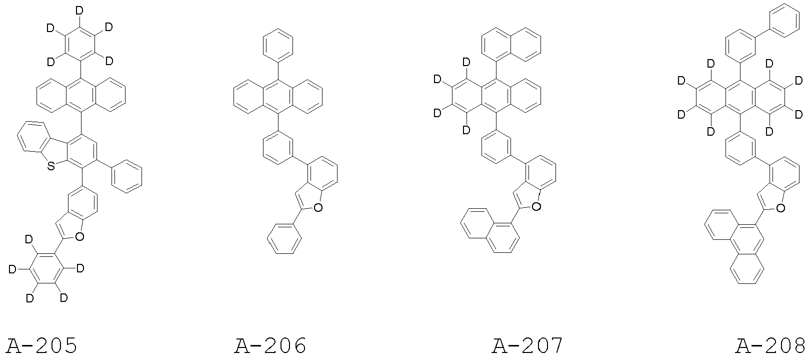

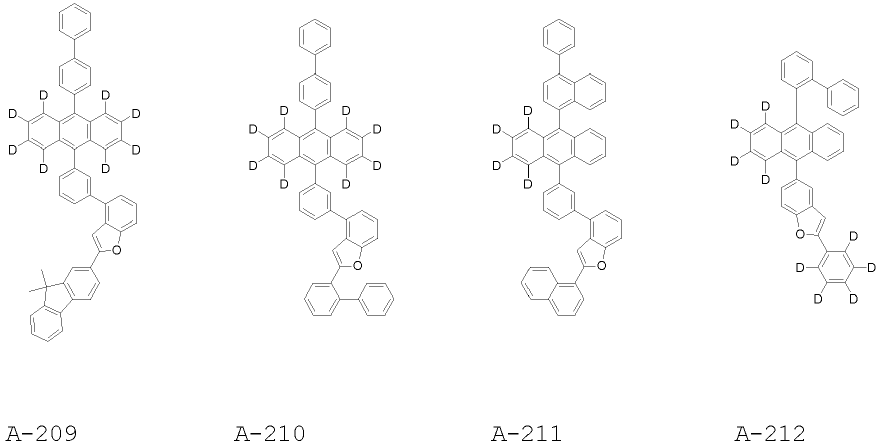

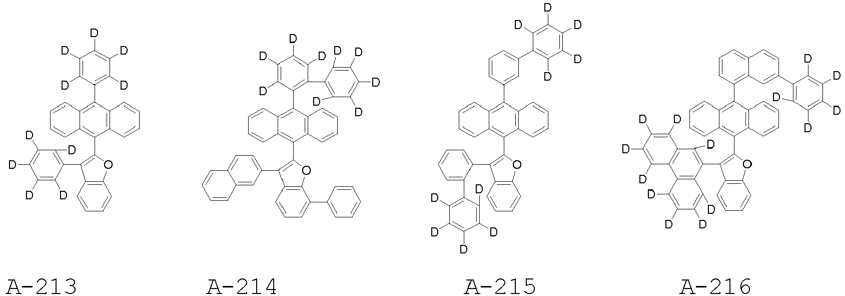

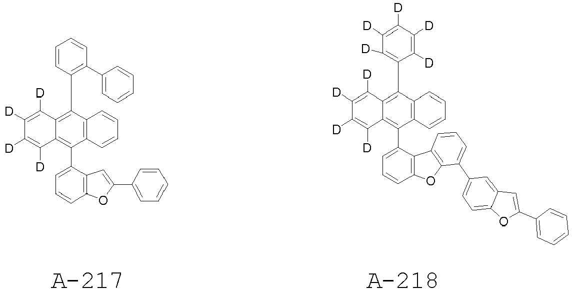

15. The organic light-emitting diode of claim 1, further comprising at least one of a hole transport layer and a hole injection layer between the first electrode and the first light-emitting layer and at least one of an electron transport and an electron injection layer between the second light-emitting layer and the second electrode.

16. The organic light-emitting diode of claim 1, wherein at least one of the first dopant in the first light-emitting layer and the second dopant in the second light-emitting layer comprises a compound represented by any one of the following Chemical Formulas D-1 to D-3: 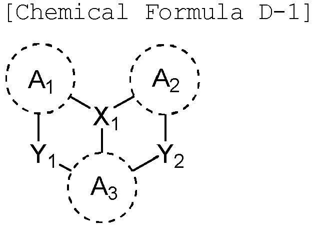 wherein,
X₁ is any one selected from B, P=O, and P=S,
Y₂ and Y₂, which are same or different, are each independently any one selected from NR₂₁, CR₂₂R₂₂, O, S, Se, and SiR₂₄R₂₅,
A₁ to A₃, which are same or different, are each independently any one selected from a substituted or unsubstituted aromatic hydrocarbon ring of 6 to 50 carbon atoms, a substituted or unsubstituted aliphatic hydrocarbon ring of 5 to 50 carbon atoms, a substituted or unsubstituted fused ring of 7 to 50 carbon atoms in which an aromatic hydrocarbon ring is fused with an aliphatic hydrocarbon ring, a substituted or unsubstituted heteroaromatic ring of 2 to 50 carbon atoms, a substituted or unsubstituted fused ring of 6 to 40 carbon atoms in which a heteroaromatic ring is fused with an aliphatic hydrocarbon ring,
R₂₁ to R₂₅, which are same or different, are each independently any one selected from a hydrogen atom, a deuterium atom, a substituted or unsubstituted alkyl of 1 to 30 carbon atoms, a substituted or unsubstituted alkenyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted heterocyclic alkyl of 3 to 30 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a nitro, a cyano, and a halogen,
at least one of R₂₂ to R₂₅ can be connected to at least one of A₁ to A₃ ring moieties to additionally form a mono- or polycyclic aliphatic or aromatic ring or an aliphatic and aromatic fused ring,
adjacent substituents in A₁ to A₃ ring moieties can be connected to each other to form a mono- or polycyclic aliphatic or aromatic ring or an aliphatic and aromatic fused ring, and
a linkage can be made between R₂₂ and R₂₃ or between R₂₄ and R₂₅ to form a mono- or polycyclic aliphatic or aromatic ring or an aliphatic and aromatic fused ring; 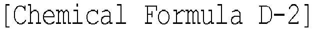 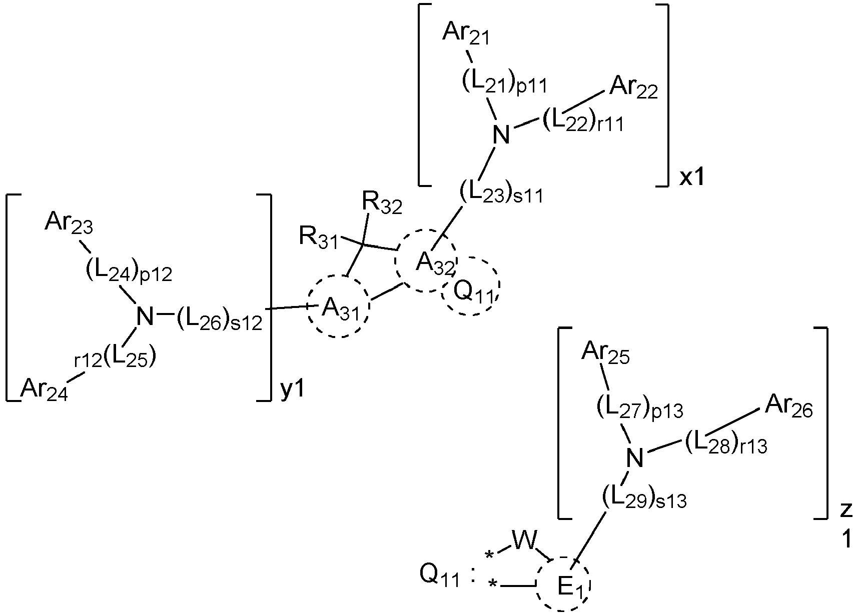 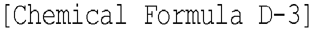 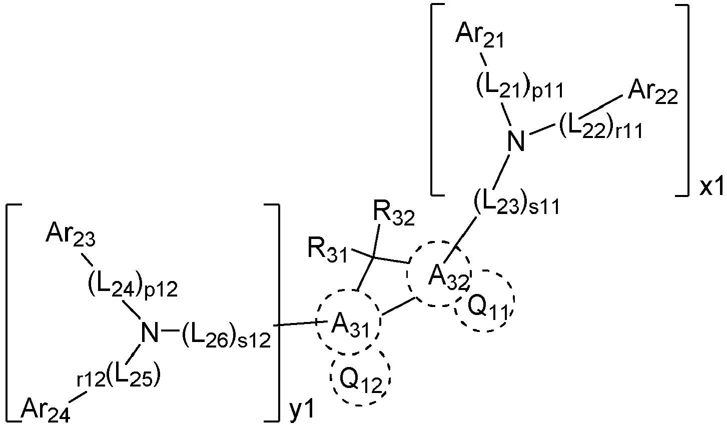 Q₁₁ : 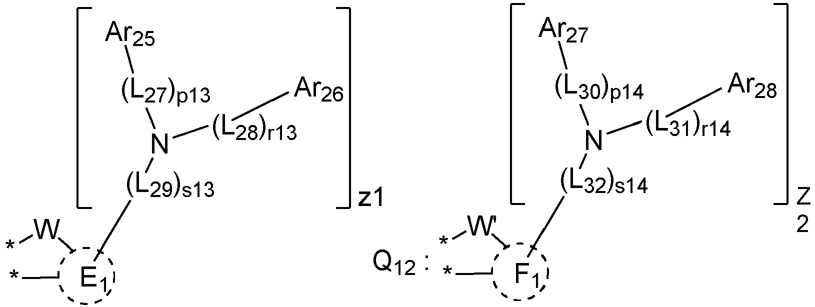
wherein,
A₃₁, A₃₂, E₁, and F₁, which are same or different, are each independently any one selected from a substituted or unsubstituted aromatic hydrocarbon ring of 6 to 50 carbon atoms, a substituted or unsubstituted aliphatic hydrocarbon ring of 5 to 50 carbon atoms, a substituted or unsubstituted fused ring of 7 to 50 carbon atoms in which an aromatic hydrocarbon ring is fused with an aliphatic hydrocarbon ring, a substituted or unsubstituted heteroaromatic ring of 2 to 50 carbon atoms, a substituted or unsubstituted fused ring of 6 to 40 carbon atoms in which a heteroaromatic ring is fused with an aliphatic hydrocarbon ring;
two adjacent carbon atoms of the aromatic ring A₃₁ and two adjacent carbon atoms of the aromatic ring A₃₂ form a 5-membered fused ring together with a carbon atom to which substituents R₃₁ and R₃₂ are bonded;
linkers L₂₁ to L₃₂, which are same or different, are each independently selected from among a single bond, a substituted or unsubstituted alkylene of 1 to 60 carbon atoms, a substituted or unsubstituted alkenylene of 2 to 60 carbon atoms, a substituted or unsubstituted alkynylene of 2 to 60 carbon atoms, a substituted or unsubstituted cycloalkylene of 3 to 60 carbon atoms, a substituted or unsubstituted heterocycloalkylene of 2 to 60 carbon atoms, a substituted or unsubstituted arylene of 6 to 60 carbon atoms, and a substituted or unsubstituted heteroarylene of 2 to 60 carbon atoms
W and W', which are same or different, are each independently any one selected from N-R₃₃, CR₃₄R₃₅, SiR₃₆R₃₇, GeR₃₈R₃₉, O, S, and Se;
R₃₁ to R₃₉ and Ar₂₁ to Ar₂₈, which are same or different, are each independently any one selected from a hydrogen atom, a deuterium atom, a substituted or unsubstituted alkyl of 1 to 30 carbon atoms, a substituted or unsubstituted aryl of 6 to 50 carbon atoms, a substituted or unsubstituted alkenyl of 2 to 30 carbon atoms, a substituted or unsubstituted alkynyl of 2 to 20 carbon atoms, a substituted or unsubstituted cycloalkyl of 3 to 30 carbon atoms, a substituted or unsubstituted cycloalkenyl of 5 to 30 carbon atoms, a substituted or unsubstituted heteroaryl of 2 to 50 carbon atoms, a substituted or unsubstituted heterocycloalkyl of 2 to 30 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 5 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a cyano, a nitro, and a halogen,
wherein R₃₁ and R₃₂ together can form a mono- or polycyclic aliphatic or aromatic ring that can be a heterocyclic ring bearing a heteroatom selected from among N, O, P, Si, S, Ge, Se, and Te as a ring member;
p₁₁ to p₁₄, r₁₁ to r₁₄, and s₁₁ to s₁₄ are each independently an integer of 1 to 3, wherein when any of them is 2 or greater, the corresponding linkers L₂₁ to L₃₂ are same or different,
x₁ is 1, and y₁, z₁, and z₂, which are same or different, are each independently an integer of 0 to 1; and
Ar₂₁ can form a ring with Ar₂₂, Ar₂₃ can form a ring with Ar₂₄, Ar₂₅ can form a ring with Ar₂₆, and Ar₂₇ can form a ring with Ar₂₈;
two adjacent carbon atoms of the A₃₂ ring moiety of Chemical Formula D-1 can occupy respective positions * of Structural Formula Q₁₁ to form a fused ring, and
two adjacent carbon atoms of the A₃₁ ring moiety of Chemical Formula D-2 can occupy respective positions * of Structural Formula Q₁₂ to form a fused ring, and two adjacent carbon atoms of the A₃₂ ring moiety of Chemical Formula D-2 can occupy respective positions * of Structural Formula Q₁₁ to form a fused ring,
wherein the term "substituted" in the expression "substituted or unsubstituted" used for Chemical Formulas D-1 to D-3 is as defined in Chemical Formula A.

17. The organic light-emitting diode of claim 16, wherein the polycyclic compound represented by Chemical Formula D-1 is a compound represented by any one of the following Chemical Formulas D-4 to D-11: 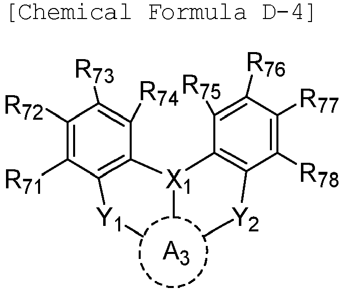 wherein,
R₇₁ to R₃₈, which are same or different, are each independently at least one selected from a hydrogen atom, a deuterium atom, a substituted or unsubstituted alkyl of 1 to 30 carbon atoms, a substituted or unsubstituted alkenyl of 2 to 30 carbon atoms, a substituted or unsubstituted aryl of 5 to 50 carbon atoms, a substituted or unsubstituted cycloalkyl of 3 to 30 carbon atoms, a substituted or unsubstituted heterocyclic alkyl of 3 to 30 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a nitro, a cyano, and a halogen, and can further form a mono- or polycyclic aliphatic or aromatic ring with an adjacent radical thereto,
X₁, Y₁, Y₂, and A₃ are each as defined in Chemical Formula D-1, above; 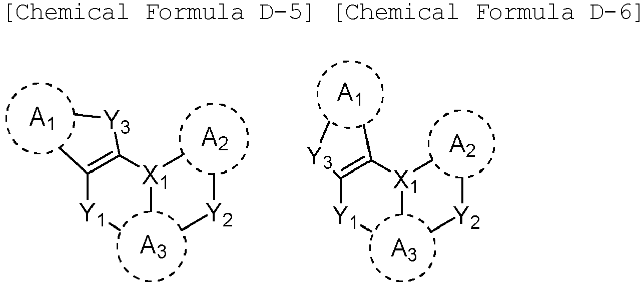
wherein,
Y₁ to Y₃, which are same or different, are each independently any one selected from NR₂₁, CR₂₂R₂₃, O, S, Se, and SiR₂₄R_{25f},
X₁, A₁ to A₃, and R₂₁ to R₂₅ are each as defined in Chemical Formula D-1; 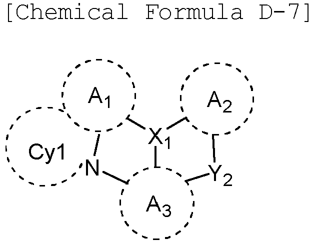
wherein,
X₁, Y₂, and A₁ to A₃ are each as defined in Chemical Formula D-1,
Cy1 accounts for a fused ring bearing, as ring members, the nitrogen atom (N) and two adjacent aromatic carbon atoms contributed by A₁ ring, one of which is bonded to the nitrogen atom (N),
the ring accounted for by Cy1 being composed of a substituted or unsubstituted alkylene of 2 to 5 carbon atoms, the nitrogen (N) atom, the aromatic carbon atom of A₁ to which the nitrogen (N) atom is bonded, and the aromatic carbon atom of A₁ to which Cy1 is to bond; 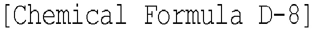 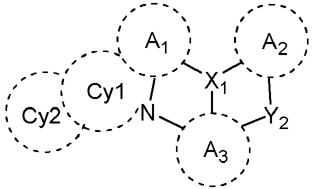
wherein,
X₁, Y₂, A₂ to A₃ are each as defined in Chemical Formula D-1 above,
Cy1 accounts for a fused ring bearing, as ring members, the nitrogen atom (N) and two adjacent aromatic carbon atoms of A₁ ring one of which is bonded to the nitrogen atom (N),
the ring accounted for by Cy1 being composed of a substituted or unsubstituted alkylene of 2 to 5 carbon atoms, the nitrogen (N) atom, the aromatic carbon atom of A₁ to which the nitrogen (N) atom is bonded, and the aromatic carbon atom of A₁ to which Cy1 is to bond;
Cy2 accounts for a saturated hydrocarbon ring added to Cy1 and is composed of a substituted or unsubstituted alkylene of 2 to 5 carbon atoms except for the carbon atoms contributed by Cy1; 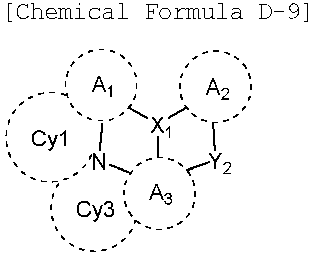
wherein,
X₁, Y₂, and A₂ to A₃ are each as defined in Chemical Formula D-1 above,
Cy1 accounts for a fused ring bearing, as ring members, the nitrogen atom (N) and two aromatic carbon atoms contributed by A₁ ring, one of which is bonded to the nitrogen atom (N),
the ring accounted for by Cy1 being composed of a substituted or unsubstituted alkylene of 2 to 5 carbon atoms, the nitrogen (N) atom, the aromatic carbon atom of A₁ to which the nitrogen (N) atom is bonded, and the aromatic carbon atom of A₁ to which Cy1 is to bond,
Cy3 accounts for a fused ring bearing, as ring members, the nitrogen atom, the carbon atom of Cy1 bonded to the nitrogen atom, and two adjacent aromatic carbon atoms of A₃ ring one of which is bonded to the nitrogen atom,
the ring accounted for by Cy3 being composed of a substituted or unsubstituted alkylene of 1 to 4 carbon atoms, the nitrogen atom (N), the aromatic carbon atom of A₃ bonded to the nitrogen atom, the carbon atom of Cy1 bonded to the nitrogen atom (N), and the aromatic carbon atom of A₃ to which Cy3 is to bond; 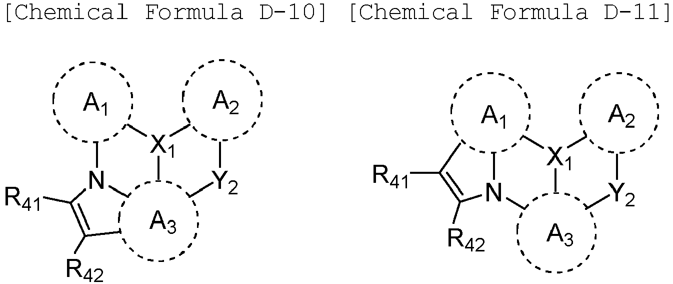
wherein,
R₄₁ and R₄₂, which are same or different, are each independently any one selected from a hydrogen atom, a deuterium atom, a substituted or unsubstituted alkyl of 1 to 30 carbon atoms, a substituted or unsubstituted alkenyl of 2 to 30 carbon atoms, a substituted or unsubstituted aryl of 5 to 50 carbon atoms, a substituted or unsubstituted cycloalkyl of 3 to 30 carbon atoms, a substituted or unsubstituted heterocyclic alkyl of 3 to 30 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted alkoxy of 1 to 30 carbon atoms, a substituted or unsubstituted aryloxy of 6 to 30 carbon atoms, a substituted or unsubstituted alkylthioxy of 1 to 30 carbon atoms, a substituted or unsubstituted arylthioxy of 6 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a nitro, a cyano, and a halogen,
R₄ and R₄₂ can be connected to each other to additionally form a mono- or polycyclic aliphatic or aromatic ring or an aliphatic and aromatic fused ring,
X₁, Y₂, and A₁ to A₃ are each as defined in Chemical Formula D-1 above,
wherein the term "substituted" in the expression "substituted or unsubstituted" used for compounds of Chemical Formulas D-4 to D-11 is as defined in the compounds of Chemical Formula A above.

18. The organic light-emitting diode of claim 1, wherein at least one of the first host and the second host comprises at least one of the compounds represented by the following Chemical Formula B: 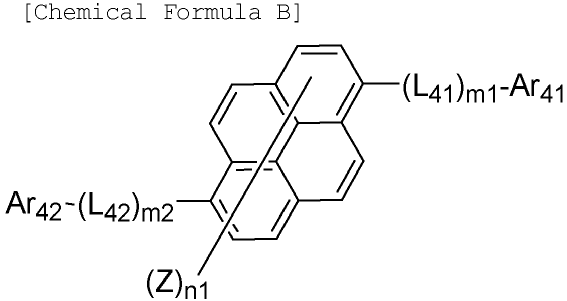 wherein,
L₄₁ and L₄₂, which are same or different, function as linkers and are each independently selected from a single bond, a substituted or unsubstituted arylene of 6 to 30 carbon atoms, and a substituted or unsubstituted heteroarylene of 6 to 30 carbon atoms,
m₁ and m₂, which are same or different, are each independently an integer of 1 or 2 wherein when m₁ and m₂ are each 2, the corresponding L₄₁'s and L₄₂'s are same or different;
Ar₄₁ and Ar₄₂, which are same or different, are each independently any one selected from a substituted or unsubstituted aryl of 6 to 50 carbon atoms, a substituted or unsubstituted heteroaryl of 2 to 50 carbon atoms, a substituted or unsubstituted alkyl of 1 to 30 carbon atoms, a substituted or unsubstituted cycloalkyl of 3 to 30 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted amine of 0 to 30 carbon atoms, a substituted or unsubstituted silyl of 0 to 30 carbon atoms, and a substituted or unsubstituted germanium of 0 to 30 carbon atoms;
Z is any one selected from a hydrogen atom, a deuterium atom, a substituted or unsubstituted alkyl of 1 to 30 carbon atoms, a substituted or unsubstituted alkenyl of 2 to 30 carbon atoms, a substituted or unsubstituted aryl of 6 to 50 carbon atoms, a substituted or unsubstituted cycloalkyl of 3 to 30 carbon atoms, a substituted or unsubstituted heterocycloalkyl of 2 to 30 carbon atoms, a substituted or unsubstituted heteroaryl of 2 to 50 carbon atoms, a substituted or unsubstituted aromatic hydrocarbon ring-fused cycloalkyl of 7 to 30 carbon atoms, a substituted or unsubstituted heteroaromatic ring-fused cycloalkyl of 5 to 30 carbon atoms, a substituted or unsubstituted aromatic hydrocarbon ring-fused heterocycloalkyl of 6 to 30 carbon atoms, a substituted or unsubstituted aliphatic hydrocarbon ring-fused aryl of 8 to 30 carbon atoms, a substituted or unsubstituted aliphatic hydrocarbon ring-fused heteroaryl of 5 to 30 carbon atoms, a substituted or unsubstituted amine of 0 to 30 carbon atoms, a substituted or unsubstituted silyl of 0 to 30 carbon atoms, a substituted or unsubstituted germanium of 0 to 30 carbon atoms, a cyano, a nitro, and a halogen;
n₁ is an integer of 0 to 8, wherein when n₁ is 2 or higher, the corresponding Z's are same or different,
the aromatic carbon atom of the pyrene ring being bound with a hydrogen atom or deuterium atom when any of Z, Ar₄₁-(L₄₁)m₁-, and Ar₄₂-(L₄₂)m₂- is not bonded thereto.

19. The organic light-emitting diode of claim 18, wherein the linkers L₄₁ and L₄₂ in Chemical Formula B are same or different and are each independently a single bond or a substituted or unsubstituted arylene of 6 to 18 carbon atoms.

20. The organic light-emitting diode of claim 18, wherein at least one of Ar₄₁ and Ar₄₂ in Chemical Formula B is a substituted or unsubstituted aryl of 6 to 18 carbon atoms or a substituted or unsubstituted heteroaryl of 3 to 18 carbon atoms.

21. The organic light-emitting diode of claim 15, wherein at least one selected from among the layers is formed using a deposition process or a solution process.

22. The organic light-emitting diode of claim 1, wherein the organic light-emitting diode is used for a device selected from among a flat panel display device, a flexible display device, a monochrome or grayscale flat illumination device, a monochrome or grayscale flexible illumination device, a vehicle display device, and a display device for virtual or augmented reality.
